# EUROPEAN PATENT APPLICATION

(11) **EP 4 586 013 A2**
(43) Date of publication of application: **16.07.2025**
(21) Application number: 25150832.1
(22) Date of filing: 09.01.2025
(51) Int. Cl.: G03F 7/09

(54) **COMPOSITION FOR FORMING ORGANIC FILM, METHOD FOR FORMING ORGANIC FILM, AND PATTERNING PROCESS**

(30) Priority: 15.01.2024 JP 2024004189
(71) Applicant: SHIN-ETSU CHEMICAL CO., LTD., Tokyo 1000005 (JP)
(72) Inventor: Niida, Keisuke, Niigata (JP); Yamamoto, Yasuyuki, Niigata (JP)
(74) Representative: Sonnenhauser, Thomas Martin

(57) **Abstract**

The present invention is a composition for forming an organic film, containing: (A) a material for forming an organic film; (B) an aryl benzyl ether compound containing a partial structure represented by the following general formula (Bl); and (C) a solvent, where R₁ represents a fluorine-containing group of formulae (B2), R₂ represents a saturated or unsaturated monovalent organic group having 1 to 30 carbon atoms, "a" represents 0 or 1, when "a" is 0, "b" representing 1 to 5 and "c" representing 0 to 4, and when "a" is 1, "b" representing 1 to 7 and "c" representing 0 to 6, "*" represents an attachment point to another atom, a broken line represents an attachment point to the oxygen atom in formula (B1), and one or two of the structures of formulae (B2) is contained. This can provide a composition that can form an organic film excellent in film-formability on a substrate, filling property, hump suppression property, and process margin when used as an organic film for a multilayer resist.

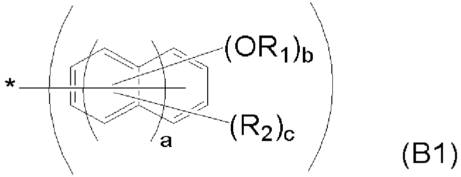

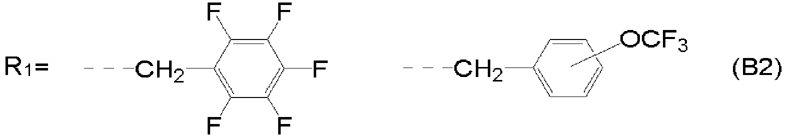

## Description

### TECHNICAL FIELD

The present invention relates to: a composition for forming an organic film; a method for forming an organic film by using the composition; and a patterning process using the composition.

### BACKGROUND ART

Recently, along with advancements toward higher integration and higher processing speed of semiconductor devices, a finer pattern rule has been required. In this situation, various techniques have been developed in regard to how patterning process can be performed more finely and precisely depending on light sources used in lithography with light exposure, which is a commonly-employed technique at present.

As the light source for lithography employed in resist pattern formation, light exposure using a g-line (436 nm) or an i-line (365 nm) of a mercury lamp as a light source is widely adopted for portions where the degree of integration is low. Meanwhile, for portions where the degree of integration is high and finer patterning is required, lithography using a KrF excimer laser (248 nm) or an ArF excimer laser (193 nm) with shorter wavelengths has also been practically used. Moreover, for the most-advanced generation requiring further finer patterning, lithography with extreme ultraviolet ray (EUV, 13.5 nm) is about to be put to practical use.

It is well known that in a monolayer resist method, which is employed as a typical resist patterning process, as the thinning of resist patterns progresses as described above, the ratio of a pattern height to a pattern line width (aspect ratio) is increased, and pattern collapse occurs due to the surface tension of a developer during development. It is known that, in this situation, a multilayer resist method, in which a pattern is formed by laminating films having different dry etching properties, is excellent in forming a pattern with a high aspect ratio on an uneven substrate. There have been developed: a two-layer resist method in which a photoresist layer (resist upper layer film) made of a silicon-containing photosensitive polymer is combined with a resist underlayer film made of an organic polymer containing carbon, hydrogen, and oxygen as main constituent elements, for example, a novolak polymer (Patent Document 1); and a three-layer resist method in which a photoresist layer made of an organic photosensitive polymer used in a monolayer resist method is combined with a resist middle layer film made of a silicon-based polymer or a silicon-based CVD film, and a resist underlayer film made of an organic polymer (Patent Document 2).

In the three-layer resist method, for example, an organic film made of a novolak or the like is formed uniformly as a resist underlayer film on a substrate to be processed; a silicon-containing resist middle layer film is formed thereon as a resist middle layer film; and an ordinary organic photoresist film is formed thereon as a resist upper layer film. In dry etching using a fluorine-based gas plasma, an organic resist upper layer film has favorable etching selectivity to a silicon-containing resist middle layer film, and therefore, a resist pattern is transferred to the silicon-containing resist middle layer film by dry etching using a fluorine-based gas plasma. According to this method, the pattern can be transferred to the silicon-containing resist middle layer film even when using a resist composition that causes difficulties in forming a pattern having a sufficient film thickness for directly processing the substrate to be processed or when using a resist composition that does not have sufficient dry etching resistance for processing the substrate. In addition, by subsequently transferring the pattern by dry etching with an oxygen-based gas plasma, it is possible to obtain a pattern in an organic film (e.g. a resist underlayer film of the novolak film or the like) having sufficient dry etching resistance for processing.

Many techniques are already known (e.g. Patent Document 3) regarding organic films (organic underlayer films) like the organic film described above. However, in association with recent progress in miniaturization, the need for excellent filling property in addition to dry etching property is rising. There is a demand for an organic film material that enables uniform film formation even on an underlying substrate to be processed having a complex form or any material, and that has a filling property that allows a required pattern to be filled without gaps.

When a semiconductor substrate or the like is manufactured, the above-described organic film is formed using a coater/developer that can perform treatments such as spin-coating process, EBR process, and baking process. The EBR (Edge Bead Removal) process is a process of removing, after forming a film on a substrate (wafer) by spin-coating, the film on the edge of the substrate with a remover, for the purpose of preventing the contamination of a substrate-conveying arm of the coater/developer. For example, a mixed solution of propylene glycol monomethyl ether acetate and propylene glycol monomethyl ether (30 mass% :70 mass%) is a remover used in EBR processes, and such removers are widely used in EBR processes of resist upper layer films and resist underlayer films (silicon-containing resist middle layer films and organic films).

Due to the effect of a remover in an EBR process, a state where a peripheral portion of an organic film has a thick film thickness (a hump) occurs in some cases. In the above-described dry etching step at the time of substrate processing, a hump causes defects, and therefore, an organic film in which a hump is suppressed is desired.

Furthermore, after forming the spin-coating film, the organic film is baked to form a cured film in order to use in a multilayer resist process. This is because it is necessary to achieve an insoluble and infusible organic film for applying a silicon-containing resist middle layer film thereon. On the surface of an organic film formed by baking, a hydrophobic surface caused by a surfactant contained in the composition for forming an organic film is formed, and induces coating abnormality of the silicon-containing resist middle layer film in some cases. To improve the coating property of the silicon-containing resist middle layer film and widen the process margin, the contact angle of the surface of the organic film is required to be controlled.

### CITATION LIST

### PATENT LITERATURE

Patent Document 1: JP H6-118651 A
Patent Document 2: JP 2005-128509 A
Patent Document 3: JP 2004-205685 A

### SUMMARY OF INVENTION

### TECHNICAL PROBLEM

The present invention has been made in view of the above-described circumstances. An object of the present invention is to provide: a composition for forming an organic film which is excellent in film-formability (in-plane uniformity) on a substrate (wafer) and filling property, is excellent in suppressing humps in an EBR process, and furthermore, makes it possible to form an organic film having an excellent process margin when used as an organic film for a multilayer resist; a method for forming an organic film, using the composition; and a patterning process using the composition.

### SOLUTION TO PROBLEM

To achieve the object, the present invention provides a composition for forming an organic film, comprising:
(A) a material for forming an organic film;
(B) an aryl benzyl ether compound containing a partial structure represented by the following general formula (B1) and not containing a partial structure represented by the following general formula (B0); and
(C) a solvent, 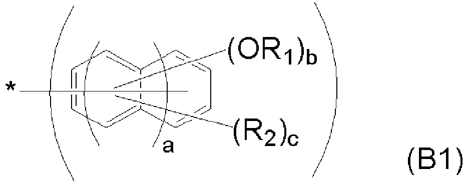 wherein R₁ represents either of groups containing fluorine represented by the following formulae (B2), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 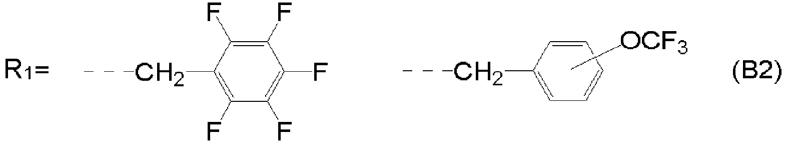 wherein a broken line represents an attachment point to the oxygen atom in the formula (B1), and one of the structures represented by the formulae (B2) is contained or two of the structures is contained, 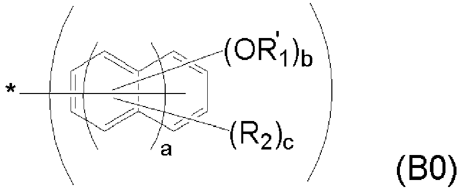 wherein R'₁ represents a hydrogen atom or a group represented by the following formula (B0-1), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 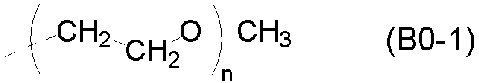 wherein a broken line represents an attachment point to the oxygen atom in the formula (B0), and "n" represents 1 to 6.

Such a composition for forming an organic film is excellent in in-plane uniformity and filling property and makes it possible to form an organic film in which the formation of a hump due to the effect of a remover in an EBR process is suppressed. Furthermore, since a phenolic hydroxy group is modified with a structure represented by either of the formulae (B2), hydrophobic components unevenly distributed on the surface of the organic film are thermally decomposed at the benzyl position by baking when a cured film is formed, and phenolic hydroxy groups are generated. As a result, the contact angle of the organic film surface can be decreased, and therefore, the composition for forming an organic film makes it possible to form an organic film on which a middle layer film, for example, a silicon-containing middle layer film, can be formed with excellent coating property. That is, the inventive composition for forming an organic film is excellent in film-formability on a substrate and filling property, excellent in hump suppression in an EBR process, and furthermore, makes it possible to form an organic film that is excellent in process margin when used as an organic film for a multilayer resist.

In the present invention, the aryl benzyl ether compound (B) is preferably a compound represented by the following general formula (B3), (B4), (B6), (B8), (B10), or (B11), 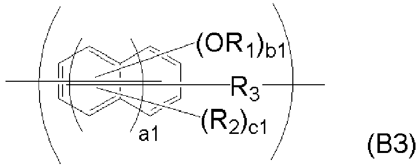 wherein R₁ represents one or two of the groups containing fluorine represented by the formulae (B2); R₂ represents a saturated or unsaturated monovalent organic group having 1 to 30 carbon atoms; R₃ represents a saturated or unsaturated divalent organic group having 1 to 30 carbon atoms; "a1" represents 0 or 1, provided that when "a1" is 0, "b1" represents 1 to 5 and "c1" represents 0 to 4, and when "a1" is 1, "b1" represents 1 to 7 and "c1" represents 0 to 6, 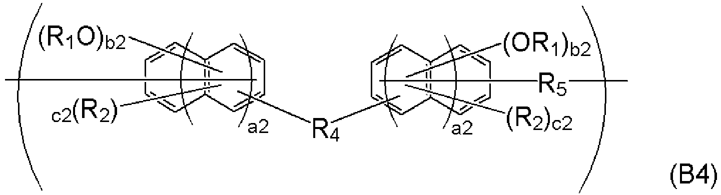 wherein R₁ represents one or two of the groups containing fluorine represented by the formulae (B2); R₂ represents a saturated or unsaturated monovalent organic group having 1 to 30 carbon atoms; R₄ represents a single bond or any of groups represented by the following formulae (B5); R₅ represents a saturated or unsaturated divalent organic group having 1 to 30 carbon atoms; and "a2" represents 0 or 1, provided that when "a2" is 0, "b2" represents 1 to 5 and "c2" represents 0 to 4, and when "a2" is 1, "b2" represents 1 to 7 and "c2" represents 0 to 6, 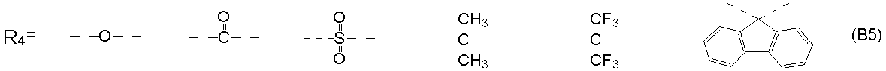 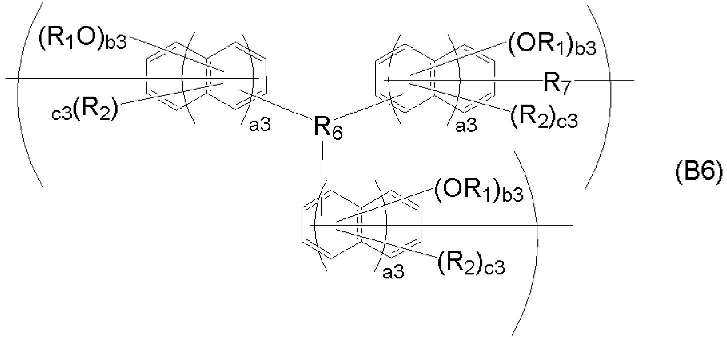 wherein R₁ represents one or two of the groups containing fluorine represented by the formulae (B2); R₂ represents a saturated or unsaturated monovalent organic group having 1 to 30 carbon atoms; R₆ represents a group represented by any of the following formulae (B7); R₇ represents a saturated or unsaturated divalent organic group having 1 to 30 carbon atoms; and "a3" represents 0 or 1, provided that when "a3" is 0, "b3" represents 1 to 5 and "c3" represents 0 to 4, and when "a3" is 1, "b3" represents 1 to 7 and "c3" represents 0 to 6, 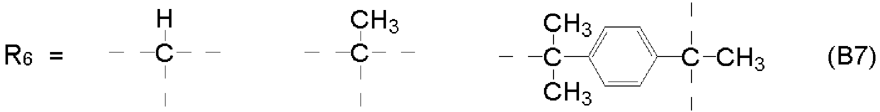 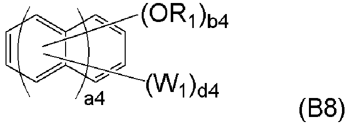 wherein R₁ represents one or two of the groups containing fluorine represented by the formulae (B2); W₁ represents a group represented by the following formula (B9); "a4" represents 0 or 1; "b4" represents 1 or 2; and "d4" represents 1 to 4, 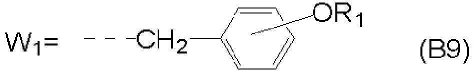 wherein R₁ represents either of the groups containing fluorine represented by the formulae (B2), 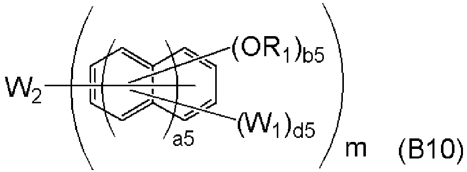 wherein R₁ represents one or two of the groups containing fluorine represented by the formulae (B2); W₁ represents a group represented by the formula (B9); W₂ represents a single bond or an organic group having 1 to 50 carbon atoms; "m" represents an integer satisfying 1 ≤ m ≤ 5; "a5" represents 0 or 1; "b5" represents 1 or 2; and "d5" represents 1 to 4, 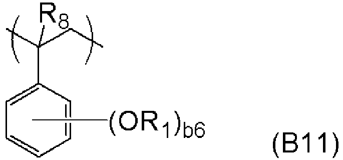 wherein R₁ represents one or two of the groups containing fluorine represented by the formulae (B2); R₈ represents a hydrogen atom or a methyl group; and "b6" represents 1 to 5.

The composition for forming an organic film containing such an aryl benzyl ether compound (B) has a suitable fluorine content, and therefore, can improve film-formability at the time of application. Moreover, there is no risk of the in-plane uniformity of the film being degraded by decomposed products generated during baking, and there is no risk of insoluble components being formed by a reaction between decomposed products or the like. Therefore, the process margin does not become narrowed when the composition is used for forming an organic film, and equipment contamination, inconvenience, etc. do not arise either.

The aryl benzyl ether compound (B) preferably has a weight-average molecular weight of 1000 to 30000.

When the weight-average molecular weight is in such a range, it is possible to form an organic film having better film-formability and better filling property.

The aryl benzyl ether compound (B) is preferably contained in an amount of 0.01 parts by mass to 5 parts by mass based on 100 parts by mass of the material (A) for forming an organic film.

The composition for forming an organic film containing the aryl benzyl ether compound (B) in such an amount is preferable, since a formed organic film has better in-plane uniformity.

The present invention also provides a method for forming an organic film to be used in a manufacturing process of a semiconductor device, the method comprising:
spin-coating a substrate to be processed with the inventive composition for forming an organic film to obtain a coating film; and
forming an organic film by heating the coating film at a temperature of 100°C or higher and 600°C or lower for 10 to 600 seconds to cure the coating film.

The inventive composition for forming an organic film can fill, by spin-coating, a pattern having a complicated shape on a substrate to be processed, makes it possible to form an organic film excellent in in-plane uniformity, and is particularly useful when an edge portion of an organic film is to be removed while suppressing humps in an EBR process. Therefore, according to the inventive method for forming an organic film, it is possible to form an organic film that exhibits excellent film-formability, excellent filling property, and excellent hump suppression at the time of an EBR process, and furthermore, has an excellent process margin when used as an organic film for a multilayer resist.

The present invention also provides a patterning process comprising:
forming an organic film on a body to be processed by using the inventive composition for forming an organic film;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The present invention also provides a patterning process comprising:
forming an organic film on a body to be processed by using the inventive composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The present invention also provides a patterning process comprising:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further forming the pattern in the body to be processed by etching while using the organic film having the transferred pattern as a mask.

The present invention also provides a patterning process comprising:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic film by etching while using the inorganic hard mask having the transferred pattern as a mask; and
further forming the pattern in the body to be processed by etching while using the organic film having the transferred pattern as a mask.

As described, the inventive composition for forming an organic film can be used suitably in various patterning processes such as a three-layer resist process using a silicon-containing resist middle layer film or an inorganic hard mask and a four-layer resist process additionally using an organic antireflective film or an adhesive film. According to such patterning processes of the present invention, it is possible to transfer and form a circuit pattern of a resist upper layer film in a body to be processed with high accuracy.

The inorganic hard mask is preferably formed by a CVD method or an ALD method.

In the inventive patterning process, the inorganic hard mask can be formed by such methods, for example.

The circuit pattern is preferably formed by a lithography using light having a wavelength of 10 nm or more and 300 nm or less, a direct writing with electron beam, nanoimprinting, or a combination thereof.

Furthermore, the circuit pattern is preferably developed with an alkaline development or an organic solvent.

In the inventive patterning process, such means of forming and developing the circuit pattern can be used suitably.

The body to be processed is preferably a semiconductor device substrate or the semiconductor device substrate coated with any of a metal film, a metal carbide film, a metal oxide film, a metal nitride film, a metal oxycarbide film, and a metal oxynitride film.

In this case, the metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

According to the inventive patterning process, such a body to be processed can be processed to form a pattern.

### ADVANTAGEOUS EFFECTS OF INVENTION

As described above, according to the present invention, it is possible to provide a composition for forming an organic film having excellent film-formability (in-plane uniformity) on a substrate (wafer) and excellent filling property, and being excellent in the film-formability of a middle layer film on the organic film when used for an organic film and in hump suppression at the time of an EBR process. Furthermore, the inventive composition for forming an organic film has excellent film-formability, an excellent filling property, and an excellent property of suppressing humps that are generated during an EBR process, and therefore, is extremely useful as: for example, an organic film material used in multilayer resist processes, such as a two-layer resist process, a three-layer resist process using a silicon-containing resist middle layer film or an inorganic hard mask, or a four-layer resist process using a silicon-containing resist middle layer film or inorganic hard mask and an organic antireflective film or adhesive film; or a material for forming an organic film for manufacturing a semiconductor device. In addition, according to the inventive method for forming an organic film, it is possible to form an organic film in which humps have been suppressed, and therefore, semiconductor devices and so forth can be manufactured efficiently. Furthermore, the aryl benzyl ether compound contained in the inventive composition for forming an organic film can exhibit the above-described properties by having a thermally decomposable aryl benzyl ether structure and also having a particular fluorine-substituted group, and therefore, is useful for a composition for forming an organic film.

### BRIEF DESCRIPTION OF DRAWINGS

FIG. 1 is an explanatory diagram of an example of the inventive patterning process according to a three-layer resist process.
FIG. 2 is an example of a graph on measuring the height of a hump by using a stylus profiler in Example 2.
FIG. 3 is an example of a graph on measuring the height of a hump by using a stylus profiler in Comparative Example 2.
FIG. 4 is an explanatory diagram of a filling property evaluation method in the Examples.

### DESCRIPTION OF EMBODIMENTS

As described above, there has been required the development of a composition for forming an organic film that has excellent film-formability (in-plane uniformity) on a substrate (wafer) and excellent filling property, and that can form an organic film in which humps generated in an EBR process have been suppressed .

Usually, when an organic film is to be formed, a resin for forming an organic film and additives are dissolved in an organic solvent to form a composition, the composition is applied with a coater and a developer onto a substrate on which a structure, a circuit, etc. is formed, the composition is spread by the substrate rotating, the composition on the edge is removed in an EBR process, and then the composition is baked to form an organic film.

It is thought that if the flowability of the composition is insufficient, gaps are generated when a hole or trench having a very high aspect ratio is filled, and in addition, a hump is generated in the periphery of the organic film if the resin for forming an organic film or the additives have poor solubility in the remover used in the EBR process.

The present inventors have further studied earnestly the above-described problems and found out that when a thermally decomposable compound having a particular repeating unit is contained in a composition for forming an organic film, the composition has both excellent film-formability and high filling property and allows excellent hump suppression property during an EBR process. Thus, the present invention has been completed.

That is, the present invention is a composition for forming an organic film, comprising:
(A) a material for forming an organic film;
(B) an aryl benzyl ether compound containing a partial structure represented by the following general formula (B1) and not containing a partial structure represented by the following general formula (B0); and
(C) a solvent, 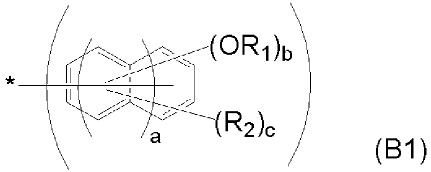 wherein R₁ represents either of groups containing fluorine represented by the following formulae (B2), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 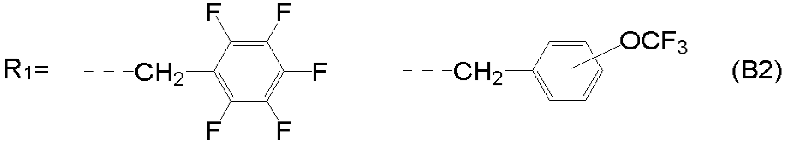 wherein a broken line represents an attachment point to the oxygen atom in the formula (B1), and one of the structures represented by the formulae (B2) is contained or two of the structures is contained, 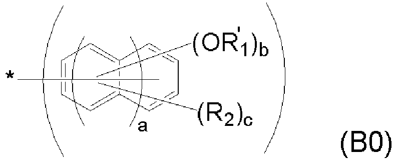 wherein R'₁ represents a hydrogen atom or a group represented by the following formula (B0-1), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 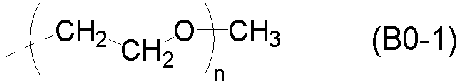 wherein a broken line represents an attachment point to the oxygen atom in the formula (B0), and "n" represents 1 to 6.

Hereinafter, the present invention will be described in detail, but the present invention is not limited thereto.

### [Composition for Forming Organic Film]

The inventive composition for forming an organic film contains:
(A) a material for forming an organic film;
(B) an aryl benzyl ether compound containing a partial structure represented by the following general formula (B1) and not containing a partial structure represented by the following general formula (B0); and
(C) a solvent.

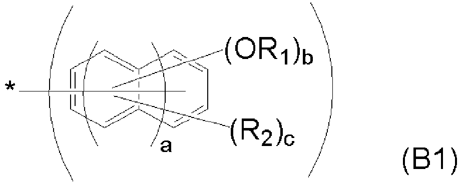

In the formula, R₁ represents either of groups containing fluorine represented by the following formulae (B2), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom.

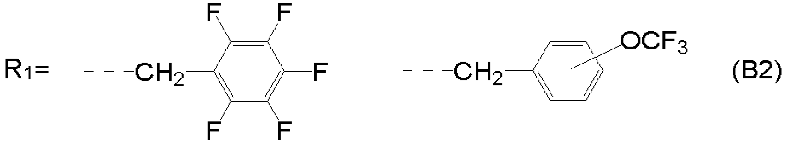

In the formulae, a broken line represents an attachment point to the oxygen atom in the formula (B1), and one of the structures represented by the formulae (B2) is contained or two of the structures is contained.

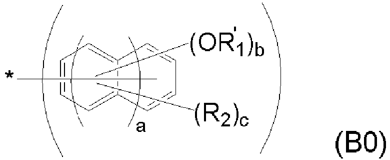

In the formula, R'₁ represents a hydrogen atom or a group represented by the following formula (B0-1), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom.

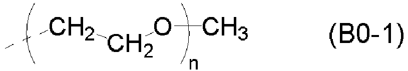

In the formula, a broken line represents an attachment point to the oxygen atom in the formula (B0), and "n" represents 1 to 6.

Note that in the inventive composition for forming an organic film, as each of the aryl benzyl ether compound (B), the material (A) for forming an organic film, and the solvent (C), one kind may be contained or a combination of two or more kinds may be contained.

In the following, the aryl benzyl ether compound (B), which is a feature of the present invention, out of the components of the above-described composition for forming an organic film will be described first, and then the material for forming an organic film, solvent, and other components will be described.

### [Aryl Benzyl Ether Compound (B)]

The component (B) in the inventive composition for forming an organic film is a compound that contains a partial structure represented by the general formula (B1) but does not contain a partial structure represented by the general formula (B0). When this compound is contained in a composition for forming an organic film, the composition is useful for forming an organic film.

The aryl benzyl ether compound (B) of the present invention includes an aryl benzyl ether structure containing a fluorine atom. Humps are hardly generated during an EBR process in a coating film formed from a composition for forming an organic film containing a material (A) for forming an organic film described later and such an aryl benzyl ether compound (B). Furthermore, by introducing a suitable substituent containing fluorine atoms, such as those in the formulae (B2), it is possible to impart a function as a surfactant that has the ability to reduce surface tension and brings about excellent uniform coatability (leveling property) of an organic film. Accordingly, when the aryl benzyl ether compound (B) of the present invention is used as a surfactant, the composition can be used not only for organic films, but also for coating materials for photolithography in general. Specific examples include photosensitive resist materials, materials for forming a top coat formed on a resist film, etc. In addition, the aryl benzyl ether structure incorporated in the aryl benzyl ether compound (B) is decomposed in the benzyl position by heat or the like. The phenolic hydroxy groups generated in this event can decrease the contact angle on the surface of an organic film, and therefore, the composition for forming an organic film can form an organic film that can improve the coating property when a middle layer film, for example, a silicon-containing middle layer film is applied thereon. That is, the aryl benzyl ether compound (B) of the present invention has characteristics that it is thermally decomposable and may function as a surfactant as described.

That is, the inventive composition for forming an organic film, containing the material (A) for forming an organic film and the aryl benzyl ether compound (B), is excellent in film-formability on a substrate and filling property, excellent in hump suppression in an EBR process, and furthermore, makes it possible to form an organic film that is excellent in process margin when used as an organic film for a multilayer resist. For example, by virtue of using the inventive composition for forming an organic film, it is possible to form: an organic film excellent for a multilayer resist for fine processing in manufacturing semiconductor devices or the like; and organic films excellent for planarization in manufacturing semiconductor devices or the like.

The aryl benzyl ether compound (B) is preferably a compound represented by the following general formula (B3), (B4), (B6), (B8), (B10), or (B11).

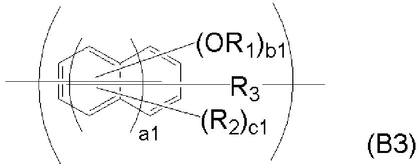

In the formula, R₁ represents one or two of the groups containing fluorine represented by the formulae (B2); R₂ represents a saturated or unsaturated monovalent organic group having 1 to 30 carbon atoms; R₃ represents a saturated or unsaturated divalent organic group having 1 to 30 carbon atoms; "a1" represents 0 or 1, provided that when "a1" is 0, "b1" represents 1 to 5 and "c1" represents 0 to 4, and when "a1" is 1, "b1" represents 1 to 7 and "c1" represents 0 to 6.

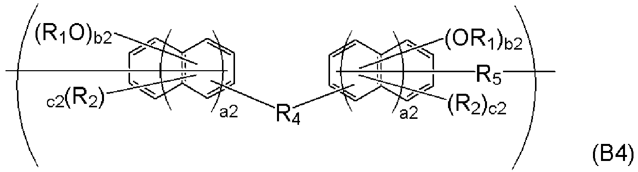

In the formula, R₁ represents one or two of the groups containing fluorine represented by the formulae (B2); R₂ represents a saturated or unsaturated monovalent organic group having 1 to 30 carbon atoms; R₄ represents a single bond or any of groups represented by the following formulae (B5); R₅ represents a saturated or unsaturated divalent organic group having 1 to 30 carbon atoms; and "a2" represents 0 or 1, provided that when "a2" is 0, "b2" represents 1 to 5 and "c2" represents 0 to 4, and when "a2" is 1, "b2" represents 1 to 7 and "c2" represents 0 to 6.

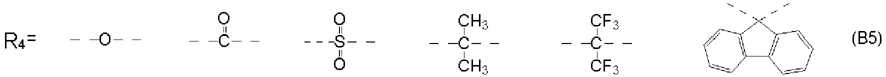

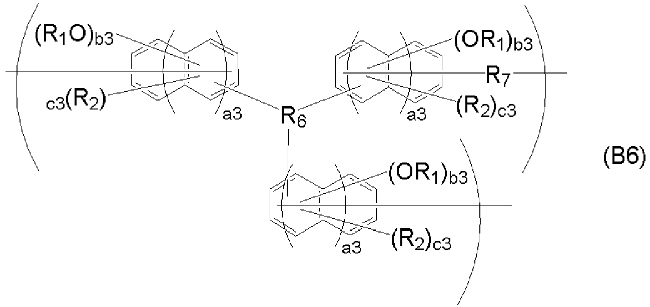

In the formula, R₁ represents one or two of the groups containing fluorine represented by the formulae (B2); R₂ represents a saturated or unsaturated monovalent organic group having 1 to 30 carbon atoms; R₆ represents a group represented by any of the following formulae (B7); R₇ represents a saturated or unsaturated divalent organic group having 1 to 30 carbon atoms; and "a3" represents 0 or 1, provided that when "a3" is 0, "b3" represents 1 to 5 and "c3" represents 0 to 4, and when "a3" is 1, "b3" represents 1 to 7 and "c3" represents 0 to 6.

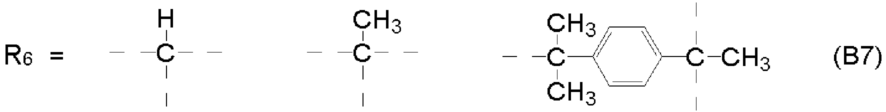

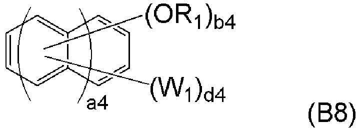

In the formula, R₁ represents one or two of the groups containing fluorine represented by the formulae (B2); W₁ represents a group represented by the following formula (B9); "a4" represents 0 or 1; "b4" represents 1 or 2; and "d4" represents 1 to 4.

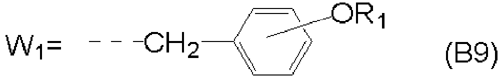

In the formula, R₁ represents either of the groups containing fluorine represented by the formulae (B2).

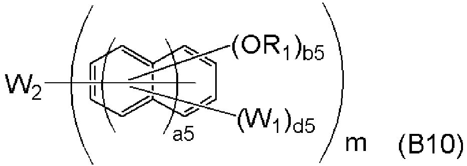

In the formula, R₁ represents one or two of the groups containing fluorine represented by the formulae (B2); W₁ represents a group represented by the formula (B9); W₂ represents a single bond or an organic group having 1 to 50 carbon atoms; "m" represents an integer satisfying 1 ≤ m ≤ 5; "a5" represents 0 or 1; "b5" represents 1 or 2; and "d5" represents 1 to 4.

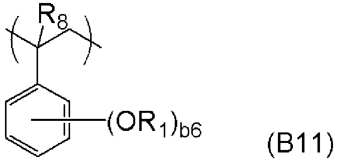

In the formula, R₁ represents one or two of the groups containing fluorine represented by the formulae (B2); R₈ represents a hydrogen atom or a methyl group; and "b6" represents 1 to 5.

The composition for forming an organic film containing such a compound has a suitable fluorine content, and therefore, can improve film-formability at the time of application. Moreover, there is no risk of the in-plane uniformity of the film being degraded by decomposed products generated during baking, and there is no risk of insoluble components being formed by a reaction between decomposed products or the like. Therefore, the process margin does not become narrowed when the composition is used for an organic film, and equipment contamination, inconvenience, etc. do not arise either.

Examples of the saturated or unsaturated monovalent organic group having 1 to 30 carbon atoms, represented by R₂ in the general formulae (B1), (B3), (B4), and (B6), include: monovalent saturated hydrocarbon groups, such as a methyl group, an ethyl group, an n-propyl group, an i-propyl group, an n-butyl group, an i-butyl group, a sec-butyl group, a tert-butyl group, an n-pentyl group, an iso-pentyl group, a sec-pentyl group, and a tert-pentyl group; monovalent unsaturated linear hydrocarbon groups, such as an ethenyl group, a propenyl group, a butenyl group, a pentenyl group, an ethynyl group, and a propynyl group; monocyclic saturated cyclic hydrocarbon groups, such as a cyclobutyl group, a cyclopentyl group, a cyclohexyl group, a cycloheptyl group, and a cyclooctyl group; monovalent monocyclic unsaturated cyclic hydrocarbon groups, such as a cyclobutenyl group, a cyclopentenyl group, and a cyclohexenyl group; monovalent polycyclic cyclic hydrocarbon groups, such as a norbornyl group and an adamantyl group; and monovalent aromatic hydrocarbon groups, such as a phenyl group, a methylphenyl group, a naphthyl group, a methylnaphthyl group, an anthryl group, and a methylanthryl group.

Other examples of the organic group represented by the R₂ include: alkoxy groups, such as a methoxy group, an ethoxy group, an n-propoxy group, an i-propoxy group, an n-butoxy group, an i-butoxy group, a sec-butoxy group, a t-butoxy group, an n-pentyloxy group, and an n-hexyloxy group; and alkoxycarbonyl groups, such as a methoxycarbonyl group, an ethoxycarbonyl group, an n-propoxycarbonyl group, an i-propoxycarbonyl group, an n-butoxycarbonyl group, an i-butoxycarbonyl group, a sec-butoxycarbonyl group, a t-butoxycarbonyl group, an n-pentyloxycarbonyl group, and an n-hexyloxycarbonyl group.

Part or all of the hydrogen atoms contained in the organic groups, such as the above-mentioned saturated hydrocarbon groups, unsaturated linear hydrocarbon groups, monocyclic saturated cyclic hydrocarbon groups, monocyclic unsaturated cyclic hydrocarbon groups, polycyclic cyclic hydrocarbon groups, aromatic hydrocarbon groups, alkoxy groups, and alkoxycarbonyl groups, may be substituted. Examples of substituents include halogen atoms, such as a fluorine atom, a chlorine atom, a bromine atom, and an iodine atom, a hydroxy group, a cyano group, a carboxy group, a nitro group, an amino group, alkoxy groups, alkoxycarbonyl groups, acyl groups, alkoxycarbonyloxy groups, aryl groups, aliphatic heterocyclic groups, such as lactone groups, and aromatic heterocyclic groups, such as a furyl group and a pyridyl group.

Preferable examples of the organic group represented by the R₂ include a methyl group from the viewpoint of the availability of raw materials.

Examples of the saturated or unsaturated divalent organic group having 1 to 30 carbon atoms represented by R₃, R₅, or R₇ in the general formulae (B3), (B4), and (B6) include: alkanediyl groups, such as a methylene group, an ethanediyl group, a propanediyl group, a butanediyl group, a pentanediyl group, a hexanediyl group, an octanediyl group, and a decanediyl group; monocyclic cycloalkanediyl groups, such as a cyclopropanediyl group, a cyclobutanediyl group, a cyclopentanediyl group, a cyclohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups, such as a bicyclo[2.2.1]heptanediyl group, a bicyclo[2.2.2]octanediyl group, a tricyclo[5.2.1.0^{2,6}]decanediyl group (a dicyclopentylene group), a tricyclo [3.3.1.1^{3,7}] decanediyl group, a tetracyclo[6.2.1.1^{3,6}.0^{2,7}]dodecanediyl group, and an adamantanediyl group; and arenediyl groups, such as a phenylene group and a naphthylene group.

Examples of alkanediyloxy groups represented by the R₃, R₅, or R₇ include groups which are combinations of an alkanediyl group mentioned above and an oxygen atom. Meanwhile, examples of cycloalkanediyloxy groups represented by the R₃, R₅, or R₇ include groups which are combinations of a cycloalkanediyl group mentioned above and an oxygen atom.

Part or all of the hydrogen atoms contained in the alkanediyl groups, cycloalkanediyl groups, alkanediyloxy groups, cycloalkanediyloxy groups, arenediyl groups, etc. may be substituted. Examples of substituents include the groups which are examples of substituents that may be contained in the organic group represented by the R₂.

Examples of the organic group represented by the R₃, R₅, or R₇ include groups represented by the following formulae.

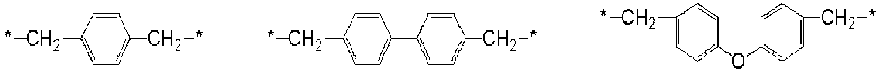

In the formulae, "*" represents an attachment point.

Preferable examples of the R₃, R₅, and R₇ include a methylene group from the viewpoint of the availability of raw materials.

The W₂ represents a single bond or an organic group having 1 to 50 carbon atoms, and examples include the groups represented by the following formulae.

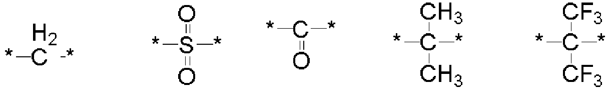

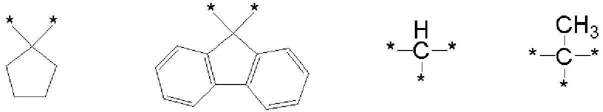

In the formulae, "*" represents an attachment point.

Specific examples of the compound represented by the general formula (B3) include the following, but are not limited thereto. In the following examples, R₁ is one or two kinds of the fluorine-containing groups represented by the formulae (B2).

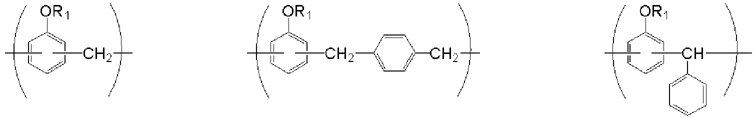

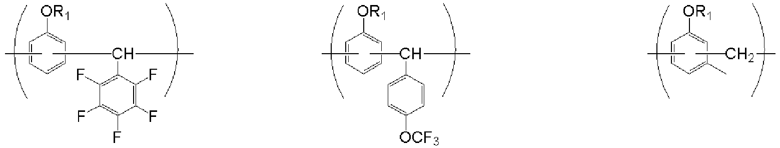

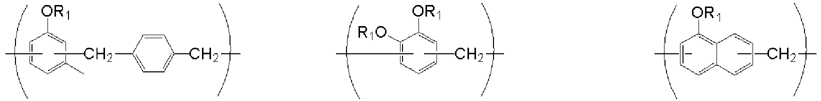

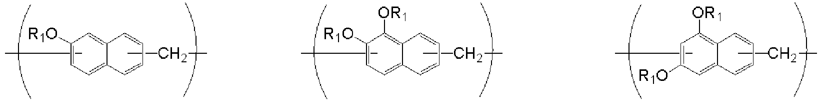

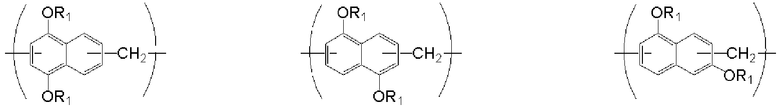

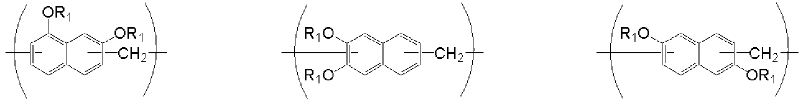

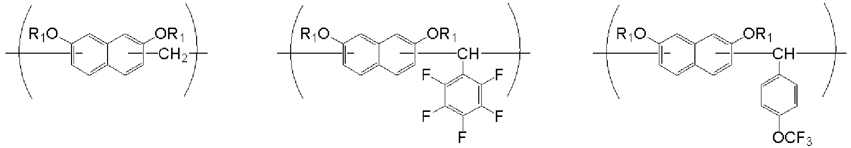

Specific examples of the compound represented by the general formula (B4) include the following, but are not limited thereto. In the following examples, R₁ is one or two kinds of the fluorine-containing groups represented by the formulae (B2).

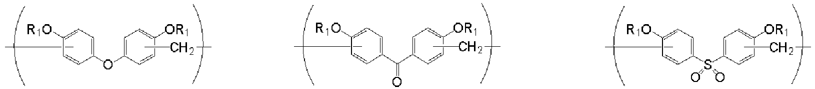

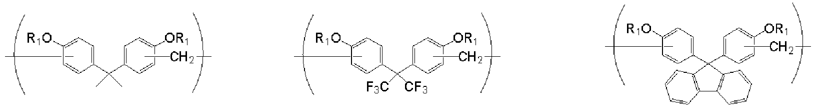

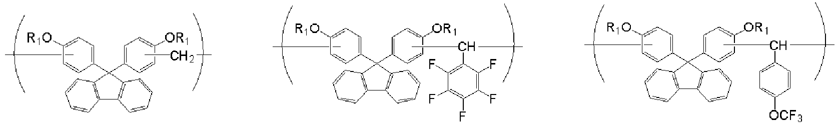

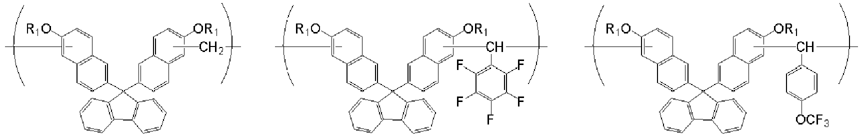

Specific examples of the compound represented by the general formula (B6) include the following, but are not limited thereto. In the following examples, R₁ is one or two kinds of the fluorine-containing groups represented by the formulae (B2).

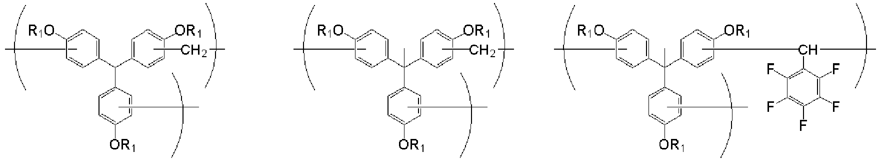

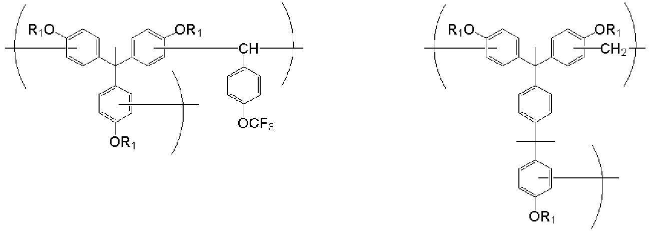

Specific examples of the compound represented by the general formula (B8) include the following, but are not limited thereto. In the following examples, R₁ is one or two kinds of the fluorine-containing groups represented by the formulae (B2).

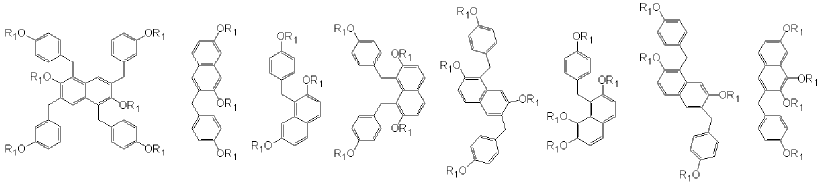

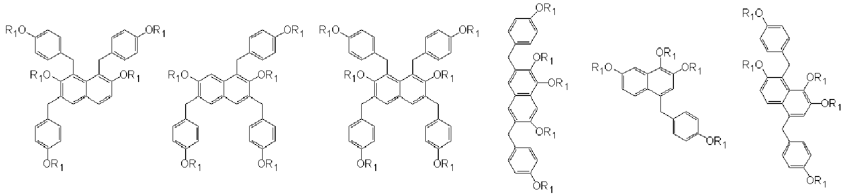

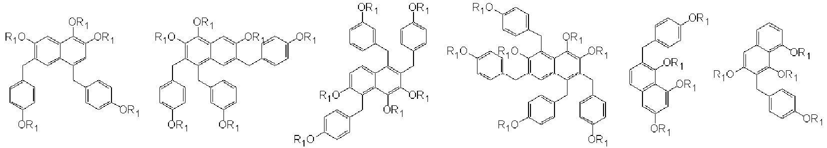

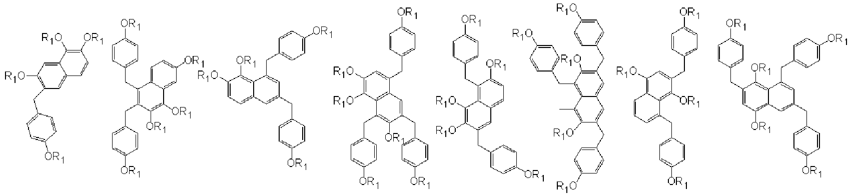

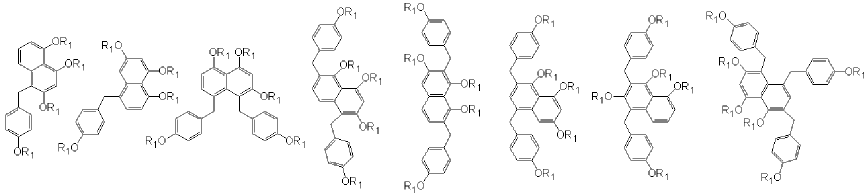

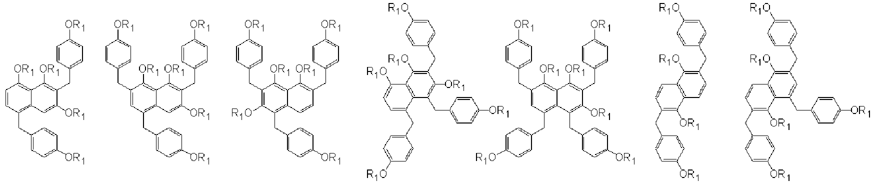

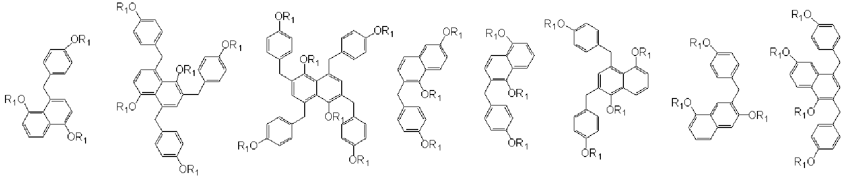

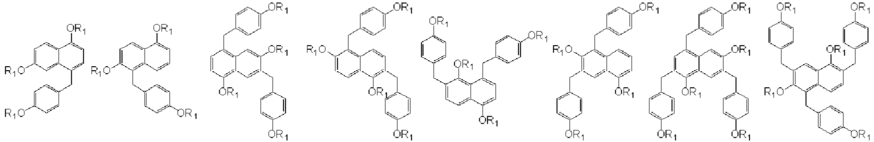

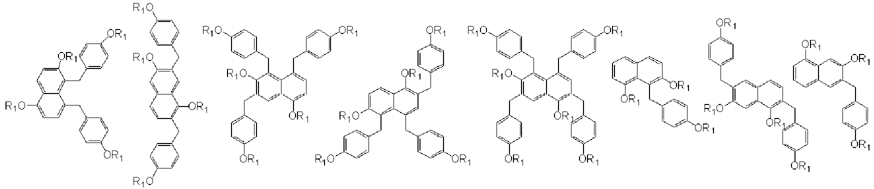

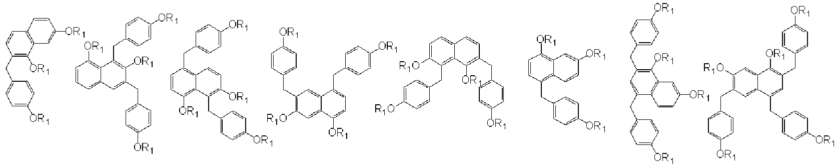

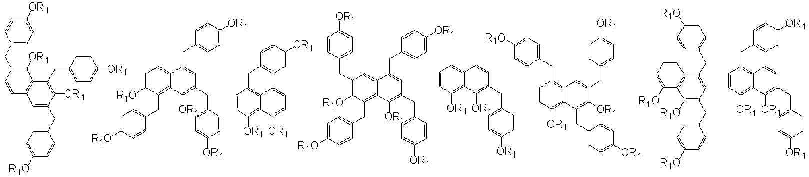

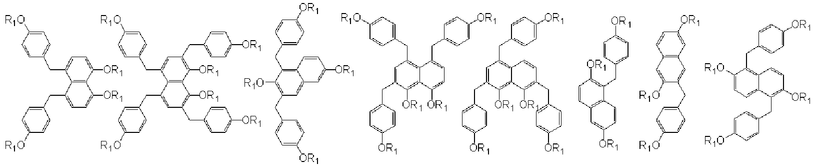

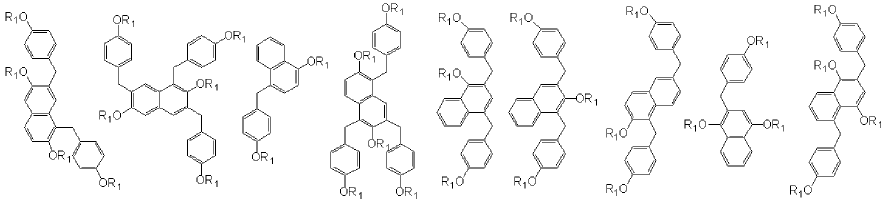

Specific examples of the compound represented by the general formula (B10) include the following, but are not limited thereto. In the following examples, R₁ is one or two kinds of the fluorine-containing groups represented by the formulae (B2).

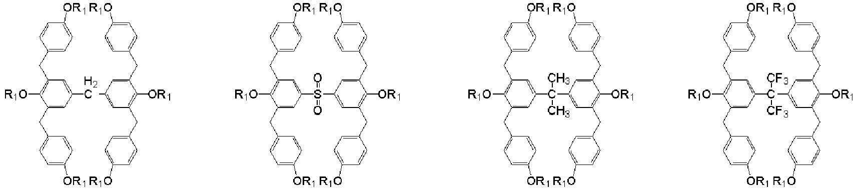

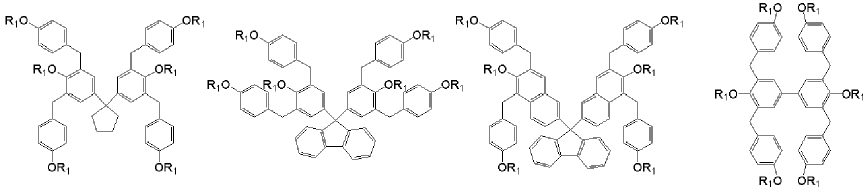

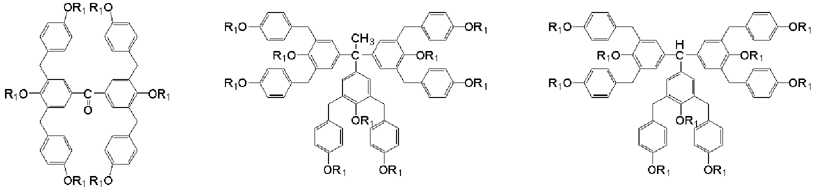

Specific examples of the compound represented by the general formula (B11) include the following, but are not limited thereto. In the following examples, R₁ is one or two kinds of the fluorine-containing groups represented by the formulae (B2).

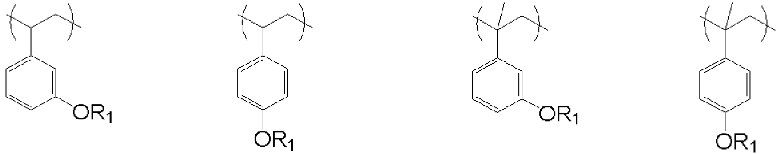

When the compounds have a structure shown above, it is possible to adjust thermal decomposability, surface active effect, and the flowability of a polymer, and the compounds have all of film-formability, filling property, and so forth with more certainty.

The aryl benzyl ether compound (B) preferably has a weight-average molecular weight of 1,000 to 30,000, more preferably 1,500 to 25,000. When the weight-average molecular weight is 1,000 or more, it is possible to suppress the degradation of a blending effect due to volatilization or the like, and a sufficient blending effect can be achieved. Meanwhile, when the weight-average molecular weight is 30,000 or less, there is no risk of flowability being degraded and so forth, and an excellent filling property can be achieved.

Note that, in the present invention, the weight-average molecular weight (Mw) and the number-average molecular weight (Mn) are values measured in terms of polystyrene by gel permeation chromatography (GPC) using tetrahydrofuran as an eluent (solvent), and the dispersity (Mw/Mn) is calculated from the Mw and Mn.

### [Method for Manufacturing Aryl Benzyl Ether Compound (B)]

Means for obtaining the aryl benzyl ether compound (B) of the present invention are not limited. However, examples include synthesis, as shown below, by a substitution reaction or the like between one or more of phenols and naphthols having a valency of "b" and pentafluorobenzyl halide, 2-(trifluoromethoxy)benzyl halide, 3-(trifluoromethoxy)benzyl halide, or 4-(trifluoromethoxy)benzyl halide performed in the presence of a base catalyst. One kind of the b-valent phenols or naphthols and one kind of the pentafluorobenzyl halide, 2-(trifluoromethoxy)benzyl halide, 3-(trifluoromethoxy)benzyl halide, and 4-(trifluoromethoxy)benzyl halide used in this synthesis may be used, or two or more kinds thereof may be used. These can be selected appropriately and combined depending on the required properties. In the following formula, R₁, R₂, "a", "b", and "c" are as defined above, and X represents a Cl atom, a Br atom, or an I atom.

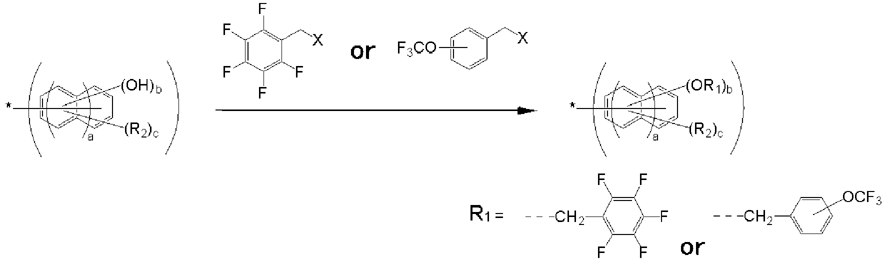

Examples of the base catalyst used in this event include: inorganic basic compounds, such as sodium hydrogen carbonate, sodium carbonate, potassium carbonate, calcium carbonate, cesium carbonate, sodium hydroxide, potassium hydroxide, sodium hydride, and potassium phosphate; and organic amine compounds, such as triethylamine, pyridine, and N-methylmorpholine. One of these base catalysts may be used or a combination of two or more kinds thereof may be used. The catalyst is preferably used in an amount of 0.1 to 20 mol, more preferably 0.2 to 10 mol, relative to 1 mol of the hydroxy groups in the b-valent phenols or naphthols as the raw material.

A solvent used in this event is not particularly limited as long as the solvent is inactive to the reaction. Examples thereof include: ether solvents, such as diethyl ether, tetrahydrofuran, and dioxane; aromatic solvents, such as benzene, toluene, and xylene; acetonitrile; dimethyl sulfoxide; N,N-dimethylformamide; N-methylpyrrolidone; and water. One of these solvents or a mixture of two or more kinds thereof may be used. These solvents can be used, for example, within a range of 0 to 2000 parts by mass relative to 100 parts by mass of the reaction raw material. The reaction temperature is preferably from -50°C to approximately the boiling point of the solvent, further preferably room temperature to 150°C. The reaction time is appropriately selected from 0.1 to 100 hours.

Examples of methods for the reaction include: a method in which one or more of the phenols and naphthols and pentafluorobenzyl halide, 2-(trifluoromethoxy)benzyl halide, 3-(trifluoromethoxy)benzyl halide, or 4-(trifluoromethoxy)benzyl halide are charged in a solvent at once; a method in which each of one or more of the phenols and naphthols and a pentafluorobenzyl halide, 2-(trifluoromethoxy)benzyl halide, 3-(trifluoromethoxy)benzyl halide, or 4-(trifluoromethoxy)benzyl halide is respectively dispersed or dissolved in separate solvents, and these are charged by adding dropwise; a method in which one of one or more of the phenols and naphthols and a pentafluorobenzyl halide, 2-(trifluoromethoxy)benzyl halide, 3-(trifluoromethoxy)benzyl halide, or 4-(trifluoromethoxy)benzyl halide is dispersed or dissolved in a solvent, and then the other, dispersed or dissolved in a solvent, is charged by adding dropwise thereto; etc. In addition, in a case where multiple kinds of one or more of the phenols and naphthols and multiple kinds of pentafluorobenzyl halide, 2-(trifluoromethoxy)benzyl halide, 3-(trifluoromethoxy)benzyl halide, and 4-(trifluoromethoxy)benzyl halide are charged, the materials may be mixed together beforehand and allowed to react, or may be allowed to react individually in succession. In a case where a base catalyst is used, examples of methods include: a method in which the catalyst is charged at once with one or more of the phenols and naphthols and with the pentafluorobenzyl halide, 2-(trifluoromethoxy)benzyl halide, 3-(trifluoromethoxy)benzyl halide, or 4-(trifluoromethoxy)benzyl halide; a method in which the base catalyst is dispersed or dissolved beforehand, and then added dropwise; etc.

To remove unreacted raw materials, the catalyst, etc. present in the system, the reaction solution obtained by a method described above with examples may be diluted in an organic solvent, then liquid-liquid separation washing may be performed, and the aryl benzyl ether compound (B) can be collected.

The organic solvent used in the liquid-liquid separation washing is not particularly limited, as long as it is capable of dissolving the compound and being separated into two layers when mixed with water. Examples of the organic solvent include: hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; and the like. As the water used for washing in this event, generally, what is called deionized water or ultrapure water may be used. The washing may be performed once or more, preferably approximately once to five times, because washing ten times or more does not always produce the full washing effects thereof.

In the liquid-liquid separation washing, the washing may be performed with a basic aqueous solution to remove unreacted raw materials or acidic components in the system. Specific examples of the base include hydroxides of alkaline metals, carbonates of alkaline metals, hydroxides of alkali earth metals, carbonates of alkali earth metals, ammonia, organic ammonium, etc.

Further, in the liquid-liquid separation washing, the washing may be performed with an acidic aqueous solution to remove unreacted raw materials, metal impurities, or basic components in the system. Specific examples of the acid include: inorganic acids, such as hydrochloric acid, hydrobromic acid, sulfuric acid, nitric acid, phosphoric acid, and heteropoly acid; organic acids, such as oxalic acid, fumaric acid, maleic acid, trifluoroacetic acid, methanesulfonic acid, benzenesulfonic acid, p-toluenesulfonic acid, and trifluoromethanesulfonic acid; etc.

The liquid-liquid separation washing may be performed with any one of the basic aqueous solution and the acidic aqueous solution, or can be performed with a combination of the two. The liquid-liquid separation washing is preferably performed with the basic aqueous solution and the acidic aqueous solution in this order from the viewpoint of removing the metal impurities.

After the liquid-liquid separation washing with the basic aqueous solution and/or acidic aqueous solution, washing with neutral water may be successively performed. As the neutral water, deionized water, ultrapure water, or the like mentioned above may be used. The washing may be performed once or more, but if the washing is not performed sufficiently, the basic components and the acidic components may not be removed in some cases. The washing is performed preferably approximately once to five times because washing ten times or more does not always produce the full washing effects.

Further, the reaction product after the liquid-liquid separation operation can also be collected as a powder by concentration and drying of the solvent under reduced pressure or normal pressure or by crystallizing the reaction product. Alternatively, the reaction product can be retained in a solution state with an appropriate concentration to improve the workability in preparing a composition for forming an organic film. The concentration at this point is preferably 0.1 to 50 mass%, more preferably 0.5 to 30 mass%. With such a concentration, the viscosity is hardly increased, so that the degradation of workability can be prevented; in addition, since the amount of the solvent is not excessive, the solution can be prepared economically.

The solvent in this event is not particularly limited, as long as it is capable of dissolving the compound. Specific examples of the solvent include: ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these can be used or a mixture of two or more thereof can be used.

In the above-described reactions, one or more of the phenols and naphthols and a pentafluorobenzyl halide, 2-(trifluoromethoxy)benzyl halide, 3-(trifluoromethoxy)benzyl halide, or 4-(trifluoromethoxy)benzyl halide can be combined in accordance with the required performance. For example, it is possible optionally to use in combination a fluorine-containing substituent or the like for controlling surface tension and so forth to change the surface activating ability. Therefore, when a composition for forming an organic film containing such a compound is used for an organic film, it is possible to achieve high levels of various properties such as film-formability and filling property.

### [Material (A) for Forming Organic Film]

The material (A) (resin or compound) for forming an organic film contained in the inventive composition for forming an organic film is not particularly limited as long as the material is a resin or compound that has sufficient film-formability in spin-coating and curability. From the viewpoints of etching resistance, optical characteristics, heat resistance, etc., a resin or compound including an aromatic skeleton (different from the aryl benzyl ether compound (B)) is preferable.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. Among these, benzene, naphthalene, fluorene, and carbazole are particularly preferable.

In the following, the material (A) for forming an organic film will be described with reference to specific examples, but these are simply examples, and the material is not limited thereto. In addition, the numbers of the formulae shown in the following examples are used only for explaining the following formulae.

Examples of the material (A) (resin or compound) for forming an organic film used in the present invention include resins containing the following structures, disclosed in JP 2012-001687 A and JP 2012-077295 A.

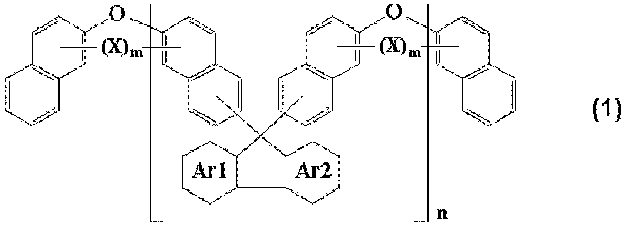

In the formula (1), the cyclic structures Ar1 and Ar2 each independently represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the definitions of the symbols in the formula apply only in this formula.

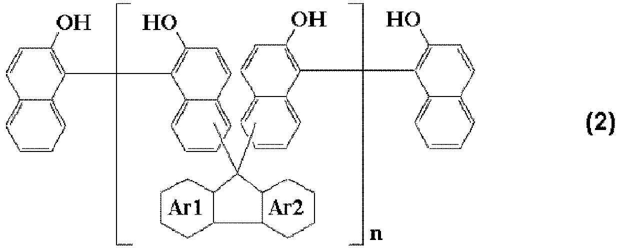

In the formula (2), the cyclic structures Ar1 and Ar2 each independently represent a benzene ring or a naphthalene ring. "n" represents any natural number that provides a weight-average molecular weight of 100,000 or less as measured by gel permeation chromatography in terms of polystyrene. Note that the definitions of the symbols in the formula apply only in this formula.

Further examples of the material (A) for forming an organic film used in the present invention include resins containing the following structures, disclosed in JP 2004-264710 A, JP 2005-043471 A, JP 2005-250434 A, JP 2007-293294 A, and JP 2008-065303 A.

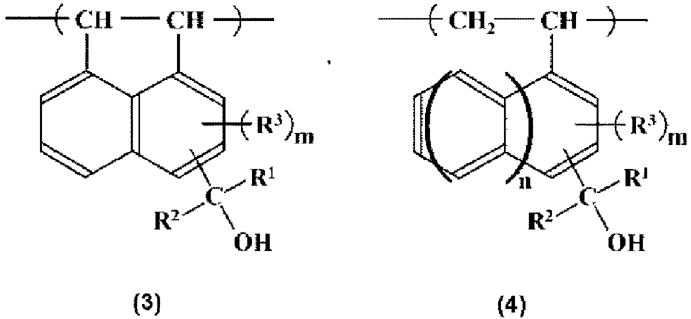

In the formula (3) and the formula (4), R¹ and R² each independently represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1; and "m" represents 0, 1, or 2. Note that the definitions of the symbols in the formulae apply only in these formulae.

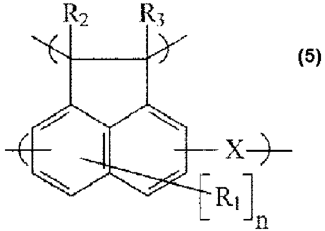

In the formula (5), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the definitions of the symbols in the formula apply only in this formula.

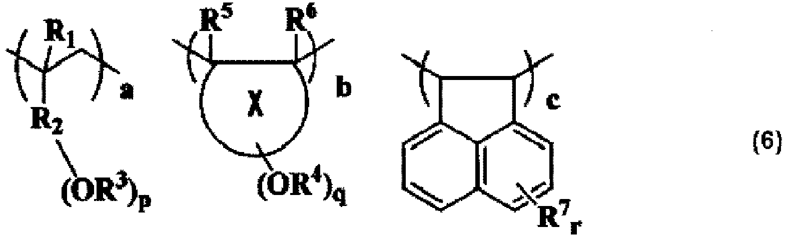

In the formula (6), R₁ represents a hydrogen atom or a methyl group. R₂ represents a single bond, a linear, branched, or cyclic alkylene group having 1 to 20 carbon atoms, or an arylene group having 6 to 10 carbon atoms, and may have any of ether, ester, lactone, and amide. R³ and R⁴ each independently represent a hydrogen atom or a glycidyl group. X represents any polymer of any of a hydrocarbon including an indene skeleton, a cycloolefin having 3 to 10 carbon atoms, and maleimide, and may have any of ether, ester, lactone, and carboxylic anhydride. R⁵ and R⁶ each independently represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the definitions of the symbols in the formula apply only in this formula.

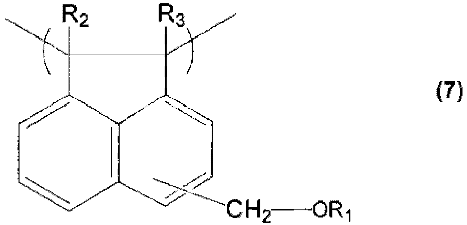

In the formula (7), R₁ represents a hydrogen atom or a monovalent organic group; and R₂ and R₃ each independently represent a monovalent atom or a monovalent organic group. Note that the definitions of the symbols in the formula apply only in this formula.

Further specific examples of the material (A) for forming an organic film used in the present invention include resins containing the following structures, disclosed in JP 2004-205685 A, JP 2007-171895 A, and JP 2009-014816 A.

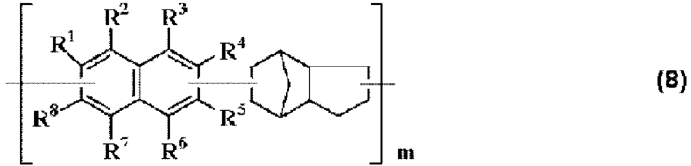

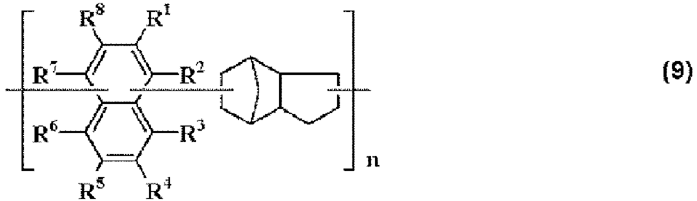

In the formula (8) and the formula (9), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the definitions of the symbols in the formulae apply only in these formulae.

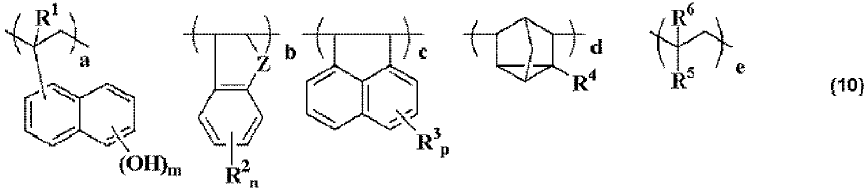

In the formula (10), R¹ and R⁶ each independently represent a hydrogen atom or a methyl group. R², R³, and R⁴ each independently represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the definitions of the symbols in the formula apply only in this formula.

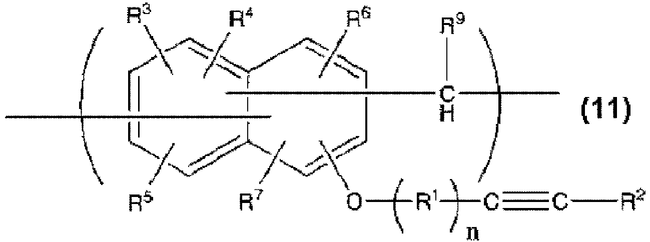

In the formula (11), "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each independently represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the definitions of the symbols in the formula apply only in this formula.

Examples of the resin represented by the formula (11) include the following resins.

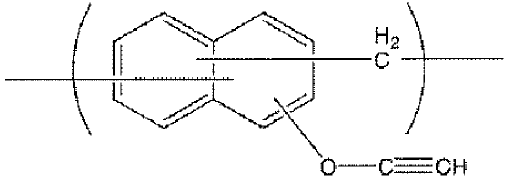

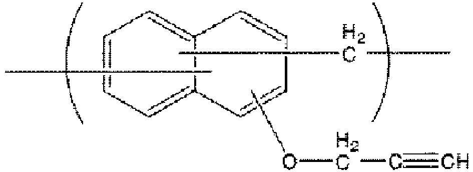

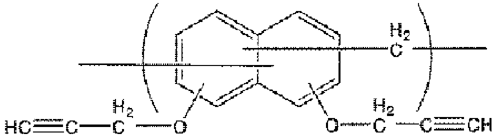

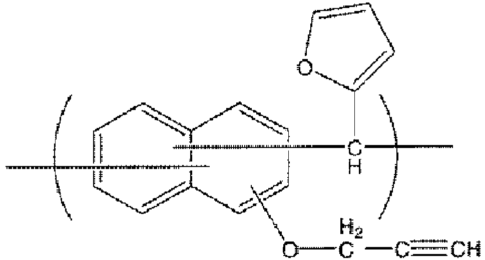

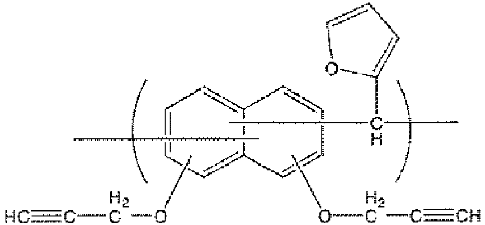

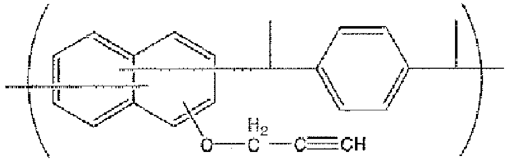

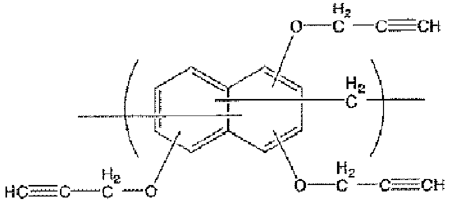

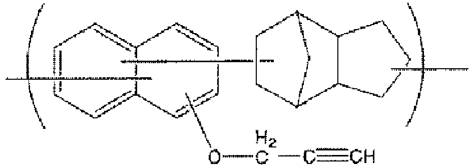

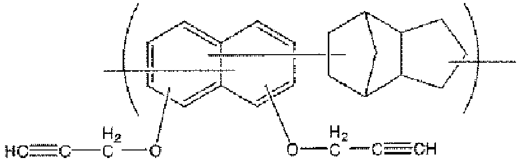

Further examples of the material (A) for forming an organic film used in the present invention include resins containing the following structures, disclosed in JP 2007-199653 A, JP 2008-274250 A, and JP 2010-122656 A.

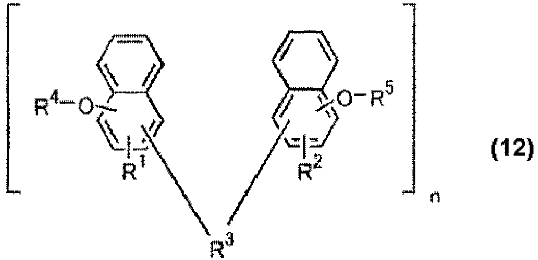

In the formula (12), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the definitions of the symbols in the formula apply only in this formula.

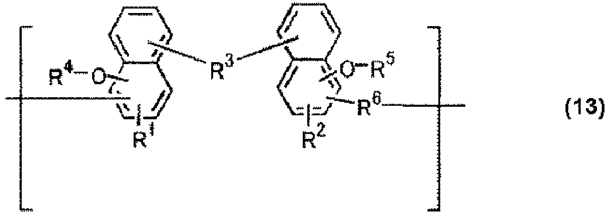

In the formula (13), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the definitions of the symbols in the formula apply only in this formula.

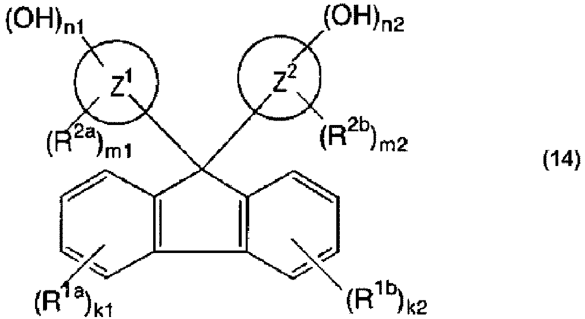

In the formula (14), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" may be identical to or different from each other and each represent 0 or an integer of 1 to 4; "m1" and "m2" each represent 0 or an integer of 1 or more; and "n1" and "n2" each independently represent 0 or an integer of 1 or more. Here, n1+n2 ≥ 1. Note that the definitions of the symbols in the formula apply only in this formula.

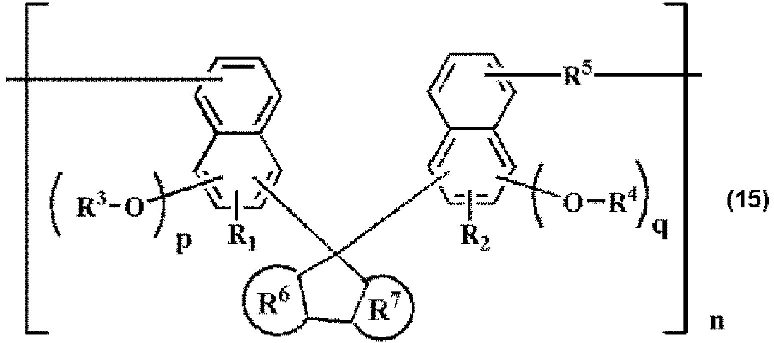

In the formula (15), R₁ and R₂ are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each independently represent a hydrogen atom or a glycidyl group; R⁵ represents a single bond or a linear or branched alkylene group having 1 to 10 carbon atoms; and R⁶ and R⁷ each independently represent a benzene ring or a naphthalene ring. "p" and "q" each represent 1 or 2. "n" satisfies 0 < n ≤ 1. Note that the definitions of the symbols in the formula apply only in this formula.

Examples of the resin represented by the formula (15) include the following resins.

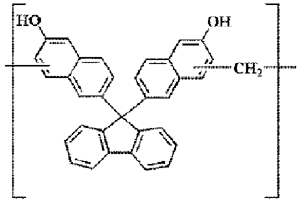

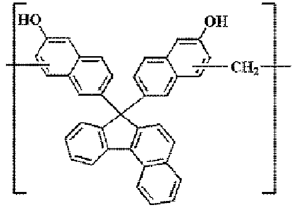

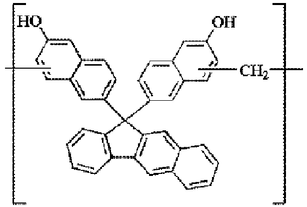

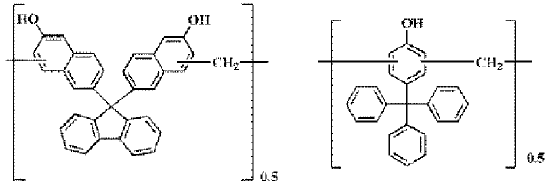

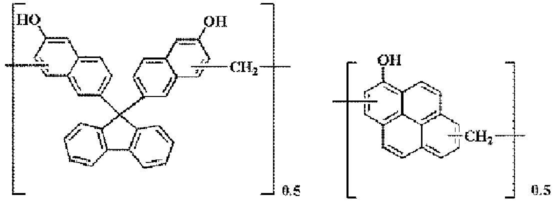

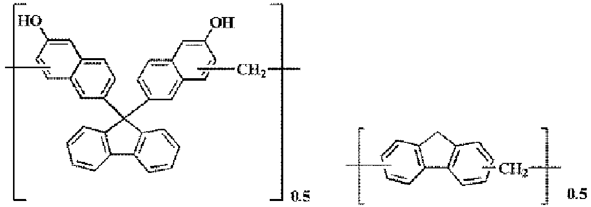

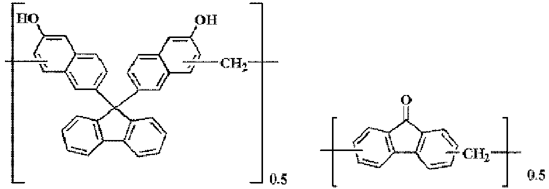

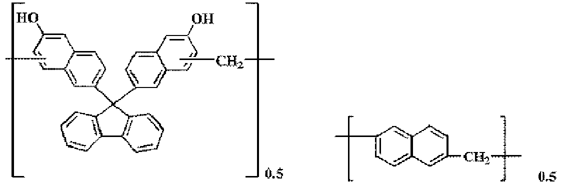

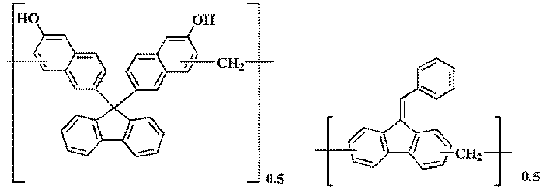

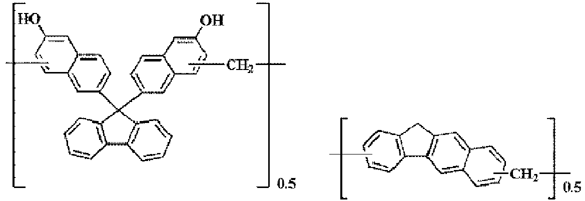

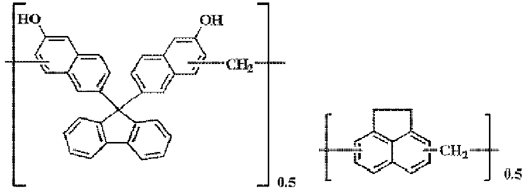

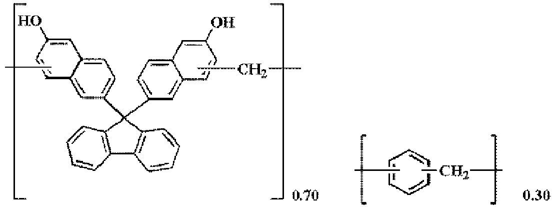

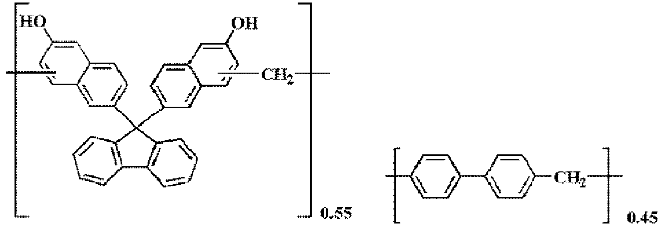

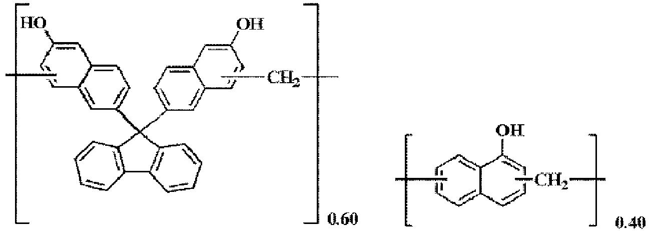

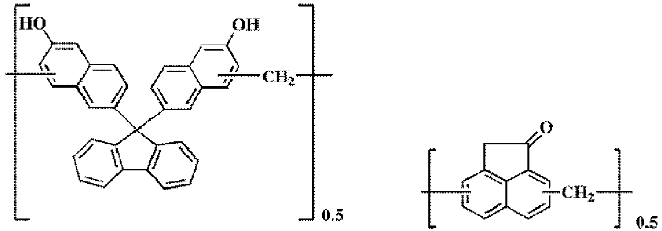

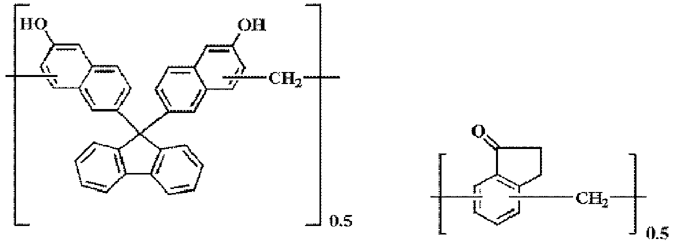

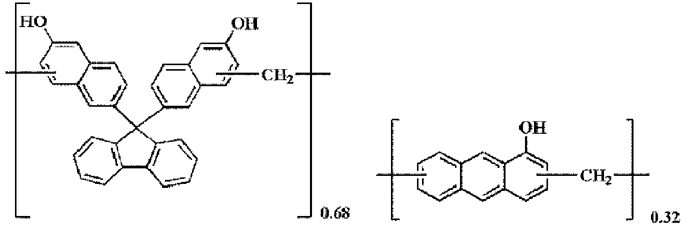

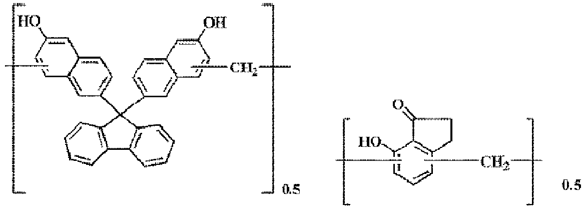

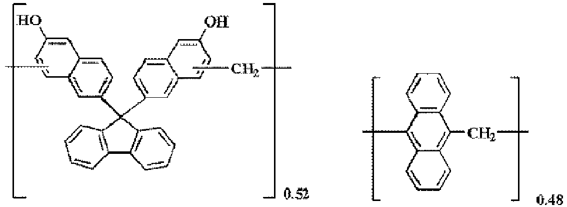

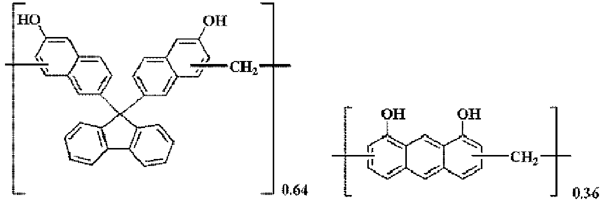

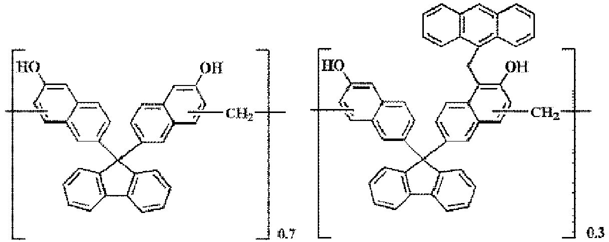

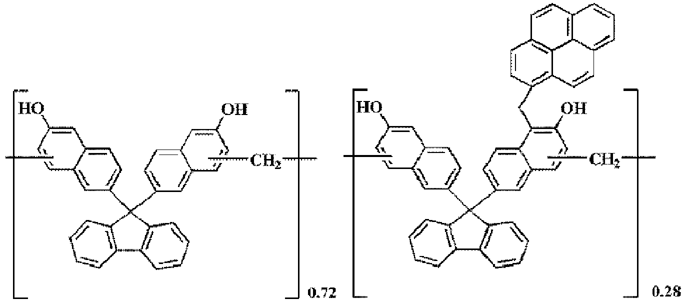

Further examples of the material (A) for forming an organic film used in the present invention include resins containing the following structure, disclosed in JP 2012-214720 A.

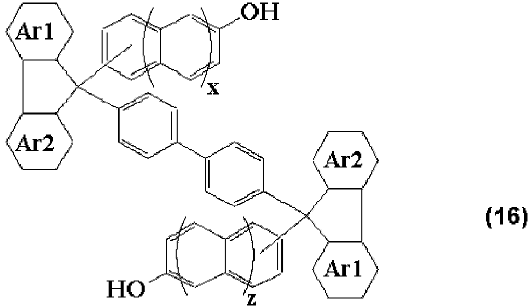

In the formula (16), the cyclic structures Ar1 and Ar2 each independently represent a benzene ring or a naphthalene ring. "x" and "z" each independently represent 0 or 1. Note that the definitions of the symbols in the formula apply only in this formula.

Further examples of the material (A) for forming an organic film used in the present invention include resins disclosed in JP 2014-029435 A.

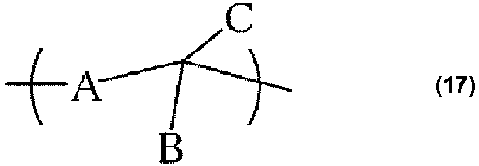

In the formula (17), A represents a structure having carbazole, B represents a structure having an aromatic ring, and C represents a hydrogen atom, an alkyl group, or a structure having an aromatic ring, B and C optionally constituting a ring with each other. One to four carboxyl groups, a salt thereof, or a carboxylic acid ester group is contained in the combined structure of A, B, and C. Note that the definitions of the symbols in the formula apply only in this formula.

Further examples of the material (A) for forming an organic film used in the present invention include polymers disclosed in WO 2012/077640 A1, the polymers containing a unit structure represented by the following formula (18) and a unit structure represented by the following formula (19), where the ratio of the unit structure represented by the formula (18) to the unit structure represented by the formula (19) is 3 to 97 : 97 to 3 by molar ratio.

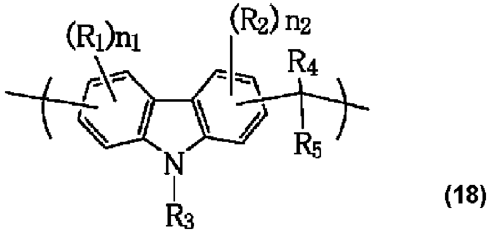

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group or heterocyclic group having 6 to 40 carbon atoms and optionally being substituted with a halogen atom, a nitro group, an amino group, or a hydroxy group; R₅ represents a hydrogen atom, or an alkyl group having 1 to 10 carbon atoms, aryl group having 6 to 40 carbon atoms, or heterocyclic group optionally substituted with a halogen atom, a nitro group, an amino group or a hydroxy group; and R₄ and R₅ may form a ring with each other. "n1" and "n2" each represent an integer of 1 to 3. Note that the definitions of the symbols in the formula apply only in this formula.

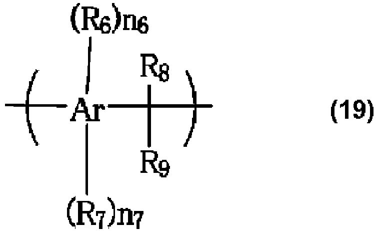

In the formula (19), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group or heterocyclic group having 6 to 40 carbon atoms and optionally substituted with a halogen atom, a nitro group, an amino group, or a hydroxy group; R₉ represents a hydrogen atom, or an alkyl group having 1 to 10 carbon atoms optionally substituted with a halogen atom, a nitro group, an amino group, or a hydroxy group, an aryl group having 6 to 40 carbon atoms optionally substituted with a halogen atom, a nitro group, an amino group, or a hydroxy group, or a heterocyclic group optionally substituted with a halogen atom, a nitro group, an amino group, or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the definitions of the symbols in the formula apply only in this formula.

Further examples of the material (A) for forming an organic film used in the present invention include polymers containing a unit structure represented by the following formula (20), disclosed in WO 2010/147155 A1.

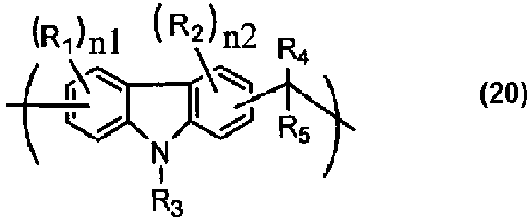

In the formula (20), R₁ and R₂ are each independently selected from the group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from the group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms and optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms and optionally substituted with a halogen group, a nitro group, an amino group, or a hydroxy group; R₄ and R₅ optionally form a ring together with the carbon atom bonded to R₄ and R₅; and "n1" and "n2" each represent an integer of 1 to 3. Note that the definitions of the symbols in the formula apply only in this formula.

Further examples of the material (A) for forming an organic film used in the present invention include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (21), disclosed in WO 2012/176767 A1.

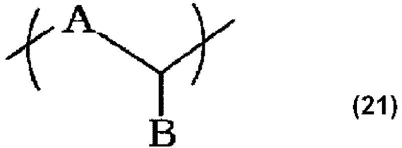

In the formula (21), A represents a hydroxy group-substituted phenylene group derived from polyhydroxybenzene; and B represents a monovalent condensed aromatic hydrocarbon ring group in which two to six benzene rings are condensed. Note that the definitions of the symbols in the formula apply only in this formula.

Further examples of the material (A) for forming an organic film used in the present invention include novolak resins having a fluorene or tetrahydrospirobiindene structure, disclosed in JP 2005-128509 A, JP 2006-259249 A, JP 2006-259482 A, JP 2006-293298 A, and JP 2007-316282 A, the novolak resins containing a repeating unit structure represented by the following formula (22-1) or (22-2).

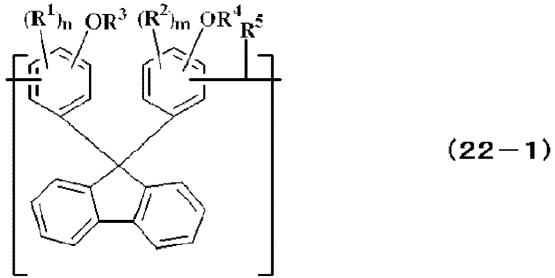

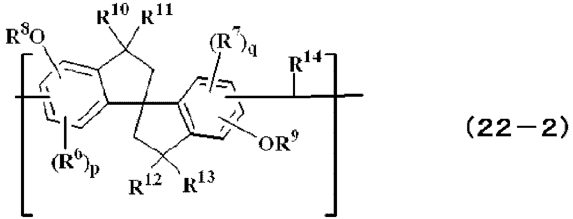

In the formula (22-1) and the formula (22-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the definitions of the symbols in the formulae apply only in these formulae.

Further examples of the material (A) for forming an organic film used in the present invention include reaction products obtained by a method disclosed in JP 2012-145897 A. More specific examples include polymers obtained by condensing one or more compounds represented by the following general formula (23-1) and/or (23-2) and one or more compounds represented by the following general formula (24-1) and/or (24-2) and/or an equivalent thereof.

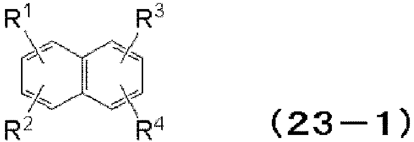

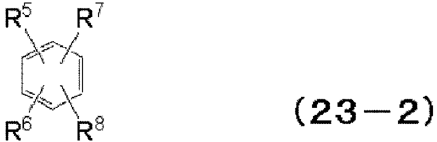

In the general formula (23-1) and the general formula (23-2), R¹ to R⁸ each independently represent a hydrogen atom, a halogen atom, a hydroxy group, an isocyanato group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, or a saturated or unsaturated organic group having 1 to 30 carbon atoms and optionally being substituted. Furthermore, any two substituents selected from each of R¹ to R⁴ or R⁵ to R⁸ may be bonded to each other within a molecule to form a cyclic substituent. Note that the definitions of the symbols in the formulae apply only in these formulae.

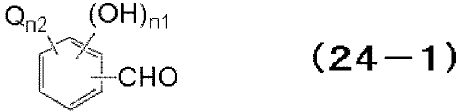

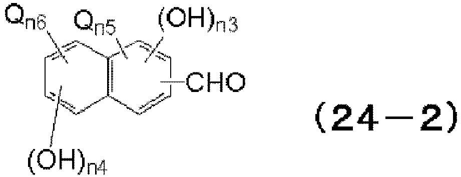

In the general formula (24-1) and the general formula (24-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each independently 0, 1, or 2, and in the formula (24-1), hydroxybenzaldehyde is excluded. Meanwhile, in the formula (24-2), the relationships 0 ≤ n3+n5 ≤ 3, 0 ≤ n4+n6 ≤ 4, and 1 ≤ n3+n4 ≤ 4 are satisfied. Note that the definitions of the symbols in the formulae apply only in these formulae.

Further examples also include polymers obtained by condensing one or more compounds represented by the general formula (23-1) and/or (23-2), one or more compounds represented by the general formula (24-1) and/or (24-2) and/or an equivalent thereof, and one or more compounds represented by the following general formula (25) and/or an equivalent thereof.

Y-CHO (25)

In the formula (25), Y represents a hydrogen atom or a monovalent organic group having 30 or fewer carbon atoms and optionally having a substituent, and the formula (25) is different from the general formula (24-1) and the general formula (24-2). Note that the definition of the symbol in the formula applies only in this formula.

Further examples of the material (A) for forming an organic film used in the present invention include compounds containing the following structure, disclosed in JP 2017-119671 A.

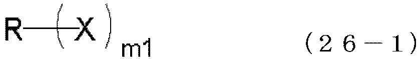

In the formula (26-1), R represents a single bond or an organic group having 1 to 50 carbon atoms; X represents a group represented by any of the following general formulae (26-2); and "m1" represents an integer that satisfies 2 ≤ m1 ≤ 10. Note that the definitions of the symbols in the formula apply only in this formula.

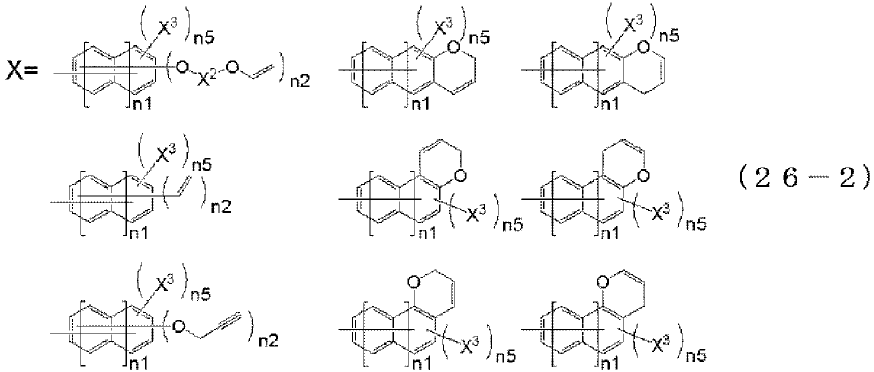

In the formulae, X² represents a divalent organic group having 1 to 10 carbon atoms; "n1" represents 0 or 1; "n2" represents 1 or 2; X³ represents a group represented by the following general formula (26-3); and "n5" represents 0, 1, or 2. Note that the definitions of the symbols in the formulae apply only in these formulae.

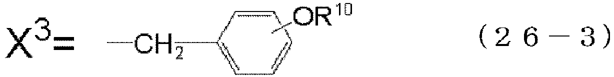

In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the definition of the symbol in the formula applies only in this formula.

Examples of the compounds containing the above-described structures include the following compounds.

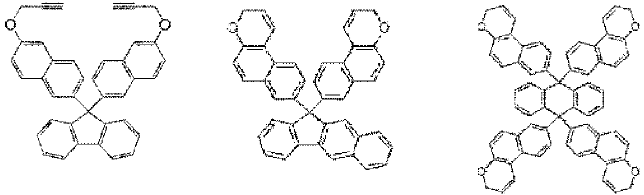

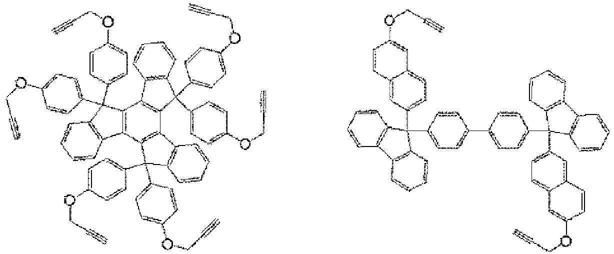

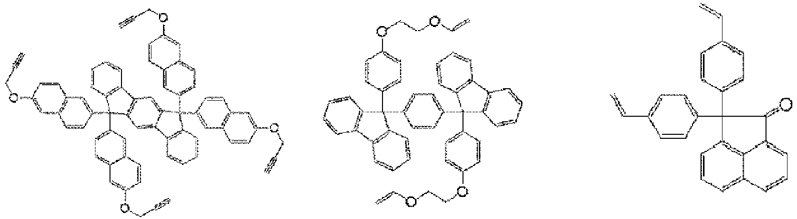

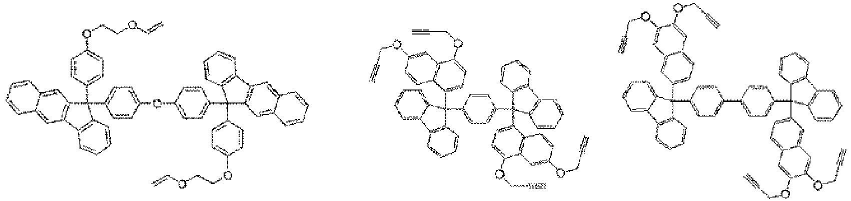

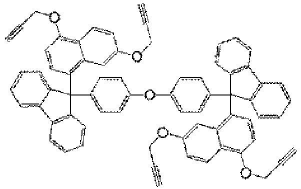

Further examples of the material (A) for forming an organic film used in the present invention include polymers having a repeating unit represented by the following general formula (27-1), disclosed in JP 2019-044022 A.

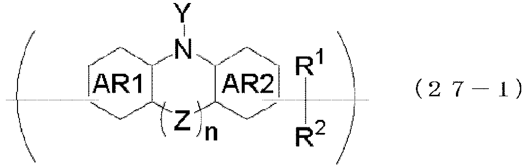

In the formula (27-1), AR1 and AR2 each represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or one of the following formulae (27-2). Y represents a group represented by the following formula (27-3). Note that the definitions of the symbols in the formula apply only in this formula.

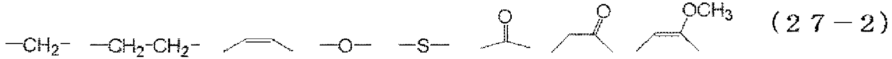

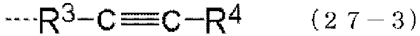

In the formula (27-3), R³ represents a single bond or a divalent organic group having 1 to 20 carbon atoms; R⁴ represents a hydrogen atom or a monovalent organic group having 1 to 20 carbon atoms; and a broken line represents an attachment point. Note that the definitions of the symbols in the formula apply only in this formula.

Examples of the polymers having a repeating unit represented by the general formula (27-1) include the following polymers.

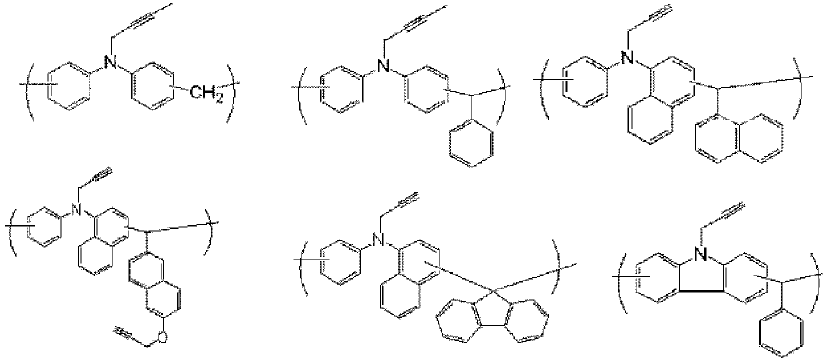

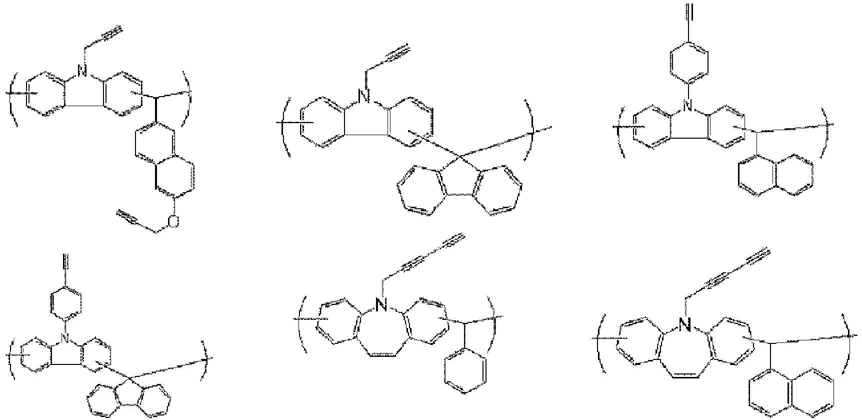

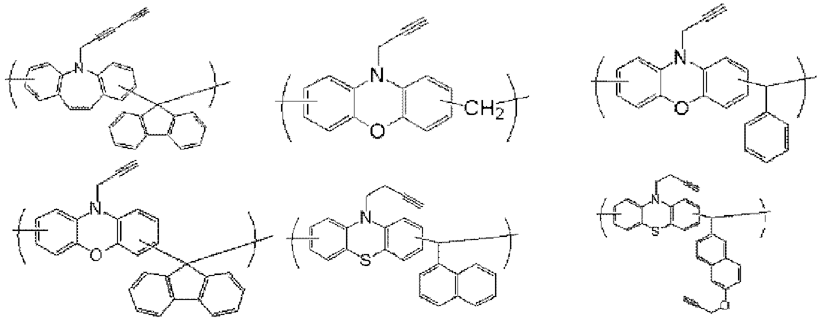

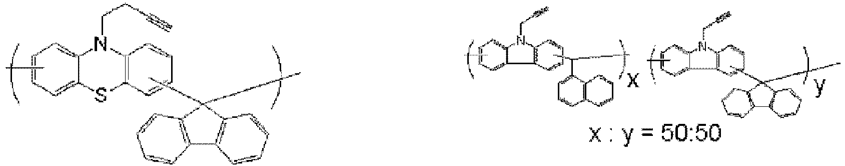

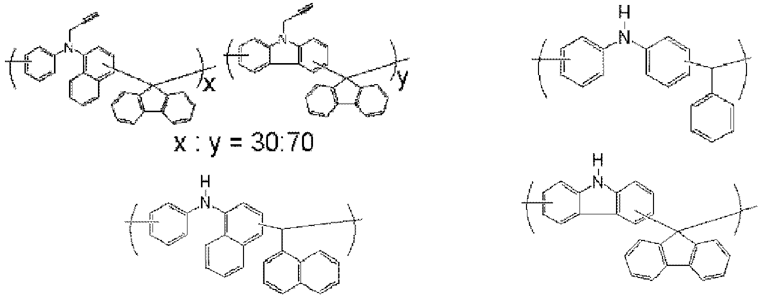

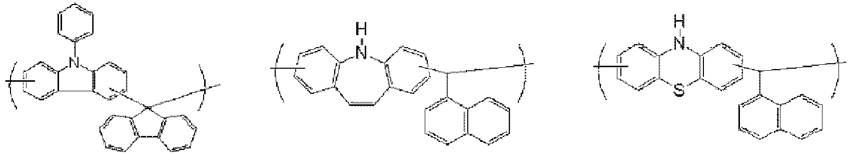

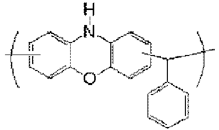

The material (A) for forming an organic film may be synthesized by a known method, and a commercially available product may be used.

The amount of the material (A) for forming an organic film to be contained is not particularly limited as long as sufficient film-formability can be achieved on spin-coating with the composition for forming an organic film, but the material (A) for forming an organic film is preferably contained in an amount of 10 to 40 parts by mass, more preferably 10 to 30 parts by mass, and further preferably 10 to 25 parts by mass, based on 100 parts by mass of the composition for forming an organic film. For example, when a hole or trench, having a very high aspect ratio, of a 3D NAND memory architecture is to be filled with the composition for forming an organic film, the contained amount of the material for forming an organic film needs to be large. However, on the other hand, such a composition for forming an organic film is highly viscous, and in-plane uniformity after spin-coating and filling property are degraded. Even when the material (A) for forming an organic film is contained in such a proportion, the inventive composition for forming an organic film makes it possible to form an organic film having excellent in-plane uniformity and excellent filling property, and can therefore be applied suitably.

Meanwhile, the aryl benzyl ether compound (B) is preferably contained in an amount of 0.01 parts by mass to 5 parts by mass based on 100 parts by mass of the material (A) for forming an organic film. A composition for forming an organic film containing the aryl benzyl ether compound (B) in such an amount makes it possible to form an organic film with better in-plane uniformity.

### [Solvent (C)]

The solvent (C) usable for the inventive composition for forming an organic film is not particularly limited as long as the solvent can dissolve the material (A) for forming an organic film and the aryl benzyl ether compound (B), and the solvent can preferably also dissolve the acid generator, crosslinking agent, a further surfactant, etc. described later. Specifically, it is possible to use a solvent having a boiling point lower than 180°C, such as the solvents disclosed in paragraphs (0091) and (0092) of JP 2007-199653 A. In particular, preferable solvents are propylene glycol monomethyl ether acetate, propylene glycol monomethyl ether, 2-heptanone, cyclopentanone, cyclohexanone, and mixtures of two or more thereof.

The solvent (C) is preferably contained in an amount of 200 to 10,000 parts by mass, more preferably 300 to 5,000 parts based on 100 parts by mass of the material (A) for forming an organic film. When the amount is in such a range, the concentration is adjustable in accordance with the desired film thickness.

Furthermore, the inventive composition for forming an organic film may also contain, as an organic solvent, being the solvent (C), a high-boiling-point solvent, having a boiling point of 180°C or higher, in addition to the above-described solvent having a boiling point of lower than 180°C (a mixture of a solvent having a boiling point of lower than 180°C and a solvent having a boiling point of 180°C or higher). Note that the boiling point herein is a boiling point at standard atmosphere (1013 hPa). The high-boiling-point organic solvent is not particularly limited to hydrocarbons, alcohols, ketones, esters, ethers, or chlorine-based solvents as long as the solvent is capable of dissolving the material (A) for forming an organic film and the aryl benzyl ether compound (B). Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The boiling point of the high-boiling-point solvent can be selected appropriately in accordance with the temperature at which the material (A) for forming an organic film is heated, and the boiling point of the high-boiling-point solvent to be contained is preferably 180°C to 300°C, further preferably 200°C to 300°C. When the boiling point is as described, sufficient thermal flowability can be achieved, since there is no risk of excessive evaporation rate at the baking (heating) due to the boiling point being too low. Moreover, a solvent having such a boiling point does not remain in the film without evaporating even after the baking due to the boiling point being too high. Therefore, there is no risk of the solvent adversely affecting the physical properties, such as etching resistance, of the film.

Furthermore, when the high-boiling-point solvent is used, the amount to be blended is preferably 1 to 30 parts by mass per 100 parts by mass of the solvent having a boiling point of lower than 180°C. When the contained amount is as described, sufficient thermal flowability can be imparted at the time of baking, and there is no risk that the solvent remains in the film and leads to degradation of physical properties, such as etching resistance, of the film.

The above-described composition for forming an organic film is provided with both high filling property and excellent planarizing property by thermal flowability being imparted to the material (A) for forming an organic film by virtue of the high-boiling-point solvent being contained.

### [Other Components]

In addition, the inventive composition for forming an organic film can contain an acid generator or a crosslinking agent for further promoting the crosslinking reaction.

Acid generators include materials that generate an acid by thermal decomposition and materials that generate an acid by light irradiation, and any acid generator can be contained. Specific examples of the acid generator include those disclosed in paragraphs [0061] to [0085] of JP 2007-199653 A. One kind of the acid generator may be used, or two or more kinds thereof may be used in combination. When the acid generator is contained, the contained amount is preferably 0.05 to 50 parts by mass, more preferably 0.1 to 10 parts by mass based on 100 parts by mass of the material (A) for forming an organic film. When the amount is as described, it is possible to promote the crosslinking reaction and form a dense film.

Specific examples of the crosslinking agent include those disclosed in paragraphs [0055] to [0060] of JP 2007-199653 A. One kind of the crosslinking agent may be used, or two or more kinds thereof may be used in combination. The crosslinking agent is preferably contained in an amount of 1 to 100 parts by mass, more preferably 5 to 50 parts by mass based on 100 parts by mass of the material (A) for forming an organic film. When the amount is as described, it is possible to enhance curability and further suppress intermixing with an upper layer film.

The inventive composition for forming an organic film can also contain an additional surfactant other than the aryl benzyl ether compound (B) of the present invention, in order to further improve in-plane uniformity in spin-coating. Specific examples of the additional surfactant include those disclosed in paragraphs [0142] to [0147] of JP 2009-269953 A. One kind of the additional surfactant may be used, or two or more kinds thereof may be used in combination. When the additional surfactant is contained, the contained amount is preferably 0.01 to 10 parts by mass, more preferably 0.05 to 5 parts by mass based on 100 parts by mass of the material for forming an organic film. When the amount is as described, it is possible to form an organic film excellent in in-plane uniformity.

The inventive composition for forming an organic film can further contain a basic compound for enhancing storage stability. The basic compound serves as a quencher to an acid to prevent a very small amount of acid generated by the acid generator from promoting the crosslinking reaction. Specific examples of such a basic compound include those disclosed in paragraphs [0086] to [0090] of JP 2007-199653 A. One kind of the basic compound may be used, or two or more kinds thereof may be used in combination. When the basic compound is contained, the contained amount is preferably 0.05 to 50 parts by mass, more preferably 0.1 to 10 parts by mass based on 100 parts by mass of the material (A) for forming an organic film. When the amount is as described, it is possible to improve the storage stability of the composition for forming an organic film.

As described above, the inventive composition for forming an organic film is excellent in hump suppression at the time of an EBR process. Accordingly, the inventive composition for forming an organic film is extremely useful as a resist underlayer film material (organic film material) for multilayer resist processes such as two-layer resist processes, three-layer resist processes using a silicon-containing resist middle layer film or a silicon-containing inorganic hard mask middle layer film, and four-layer resist processes using a silicon-containing resist middle layer film or silicon-containing inorganic hard mask middle layer film and an organic antireflective film or adhesive film.

### [Method for Forming Organic Film]

The present invention provides a method for forming an organic film to be used in a manufacturing process of a semiconductor device, the method including: spin-coating a substrate to be processed with the inventive composition for forming an organic film to obtain a coating film; and forming an organic film by heating the coating film at a temperature of 100°C or higher and 600°C or lower for 10 to 600 seconds to cure the coating film. For example, an organic film is formed by heating a substrate coated with the composition for forming an organic film in the above-described temperature and time ranges to cure the composition.

In this method for forming an organic film, firstly, the inventive composition for forming an organic film described above is applied onto a substrate to be processed by spin-coating. An excellent filling property can be obtained by using a spin-coating method. After removing a film on an edge portion in an EBR process, baking (heating) is performed in order to promote the crosslinking reaction. Incidentally, the solvent in the composition can be evaporated by this baking, and therefore, mixing can be prevented even when a resist upper layer film or a silicon-containing resist middle layer film is formed on the organic film.

The baking is performed at a temperature of 100°C or higher and 600°C or lower for 10 to 600 seconds, preferably at a temperature of 200°C or higher and 500°C or lower for 10 to 300 seconds, and particularly preferably at a temperature of 300°C or higher and 500°C or lower for 10 to 300 seconds. Considering influence on device damage and wafer deformation, the upper limit of the heating temperature in a wafer process of lithography is preferably 600°C or lower, more preferably 500°C or lower. By performing the heat treatment under such conditions, the crosslinking reaction can be promoted, and it is possible to form an organic film that does not mix with a film formed thereon.

### [Patterning Process]

In the following, patterning processes using the inventive composition for forming an organic film will be described.

### [Three-Layer Resist Process Using Silicon-Containing Resist Middle Layer Film]

The present invention provides a patterning process including:
forming an organic film on a body to be processed by using the inventive composition for forming an organic film;
forming a silicon-containing resist middle layer film on the organic film by using a silicon-containing resist middle layer film material;
forming a resist upper layer film on the silicon-containing resist middle layer film by using a resist upper layer film material including a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The body to be processed is preferably a semiconductor device substrate or the semiconductor device substrate coated with any of a metal film, a metal carbide film, a metal oxide film, a metal nitride film, a metal oxycarbide film, and a metal oxynitride film, for example. The body to be processed is not particularly limited, but more specifically, may be a substrate made of Si, α-Si, p-Si, SiO₂, SiN, SiON, W, TiN, Al, etc.; the substrate coated with the above-mentioned metal film or the like as a layer to be processed; etc.

Examples of the layer to be processed include various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, particularly preferably 100 to 5,000 nm. Note that when the layer to be processed is formed, the substrate and the layer to be processed are formed from different materials.

Incidentally, the metal constituting the body to be processed preferably contains silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When forming an organic film on the body to be processed by using the inventive composition for forming an organic film, the inventive method for forming an organic film described above can be adopted, for example, although the method is not limited thereto.

Subsequently, a resist middle layer film (silicon-containing resist middle layer film) is formed on the organic film by using a resist middle layer film material containing a silicon atom. As the resist middle layer film material containing a silicon atom, a polysiloxane-based middle layer film material is preferable. By imparting an antireflective effect to the silicon-containing resist middle layer film, reflection can be suppressed. Particularly, for 193-nm light exposure, when a material containing many aromatic groups and having high etching selectivity relative to the substrate is used as a composition for forming an organic film, the k-value and thus the substrate reflection are increased; in contrast, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used which has an anthryl group for 248-nm or 157-nm light exposure, or a phenyl group or a light-absorbing group having a silicon-silicon bond for 193-nm light exposure in a pendant structure, and which is to be crosslinked by an acid or heat.

Subsequently, a resist upper layer film is formed on the silicon-containing resist middle layer film by using a resist upper layer film material containing a photoresist composition. The resist upper layer film material may be a positive type or a negative type, and a photoresist composition that is normally used can be used. After the spin-coating with the resist upper layer film material, pre-baking is preferably performed at 60 to 180°C for 10 to 300 seconds. Then, light exposure, post-exposure baking (PEB), and development are performed according to conventional methods to obtain a resist upper layer film pattern. Note that the thickness of the resist upper layer film is not particularly limited, but is preferably 30 to 500 nm, particularly preferably 50 to 400 nm.

Subsequently, a circuit pattern (resist upper layer film pattern) is formed in the resist upper layer film. The circuit pattern is preferably formed by a lithography using light having a wavelength of 10 nm or more and 300 nm or less, a direct writing with electron beam, nanoimprinting, or a combination thereof.

Examples of exposure light include high-energy beams having a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) of 3 to 20 nm, electron beam (EB), ion beam, X-ray, etc.

Furthermore, the circuit pattern is preferably developed with an alkaline development or an organic solvent.

Subsequently, the pattern is transferred to the silicon-containing resist middle layer film by etching while using the resist upper layer film having the formed circuit pattern as a mask. The etching of the silicon-containing resist middle layer film performed while using the resist upper layer film pattern as a mask is preferably performed by using a fluorocarbon-based gas. Thus, the pattern (silicon-containing resist middle layer film pattern) is transferred to the silicon-containing resist middle layer film.

Subsequently, the pattern is transferred to the organic film by etching while using the silicon-containing resist middle layer film having the transferred pattern (silicon-containing resist middle layer film pattern) as a mask. The silicon-containing resist middle layer film exhibits etching resistance to oxygen gas or hydrogen gas, and therefore, the etching of the organic film performed while using the silicon-containing resist middle layer film pattern as a mask is preferably performed by using an etching gas mainly containing oxygen gas or hydrogen gas. Thus, the pattern (organic film pattern) is transferred to the organic film.

Subsequently, the pattern is formed in the body to be processed by etching while using the organic film having the transferred pattern (organic film pattern) as a mask.

This etching of the body to be processed (layer to be processed) can be performed by a conventional method. For example, a body to be processed made of SiO₂, SiN, or silica low-dielectric insulating film is etched mainly with a fluorocarbon-based gas; and a body to be processed made of p-Si, Al, or W is etched mainly with a chlorine- or bromine-based gas. When the substrate is processed by etching with a fluorocarbon-based gas, the silicon-containing resist middle layer film pattern is removed when the body to be processed is processed. Meanwhile, when the body to be processed is processed by etching with a chlorine- or bromine-based gas, the silicon-containing resist middle layer film pattern needs to be removed by additional dry etching with a fluorocarbon-based gas after the processing of the body to be processed.

The organic film obtained by using the inventive composition for forming an organic film can be provided with excellent etching resistance when the body to be processed is etched as described above.

### [Four-Layer Resist Process Using Silicon-Containing Resist Middle Layer Film and Organic Antireflective Film or Adhesive Film]

The present invention also provides a patterning process including:
forming an organic film on a body to be processed by using the inventive composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

This method can be performed in the same manner as the three-layer resist process using the silicon-containing resist middle layer film, except that the organic antireflective film (BARC) or the adhesive film is formed between the silicon-containing resist middle layer film and the resist upper layer film.

The organic antireflective film and the adhesive film can be formed by spin-coating by using a known organic antireflective film material.

### [Three-Layer Resist Process Using Inorganic Hard Mask Middle Layer Film]

The present invention also provides a patterning process including:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming a resist upper layer film on the inorganic hard mask by using a resist upper layer film material containing a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further forming the pattern in the body to be processed by etching while using the organic film having the transferred pattern as a mask.

This method can be performed in the same manner as the three-layer resist process using the silicon-containing resist middle layer film, except that the inorganic hard mask middle layer film is formed instead of the silicon-containing resist middle layer film on the organic film.

The inorganic hard mask middle layer film selected from the group consisting of a silicon oxide film, a silicon nitride film, and a silicon oxynitride film (SiON film) can be formed, for example, by a CVD method, an ALD method, etc. Examples of methods for forming the silicon nitride film are disclosed in JP 2002-334869 A, WO 2004/066377 A1, etc. The inorganic hard mask middle layer film preferably has a thickness of 5 to 200 nm, more preferably 10 to 100 nm. As the inorganic hard mask middle layer film, a SiON film, which has a high function as an antireflective film, is the most preferably used.

### [Four-Layer Resist Process Using Inorganic Hard Mask Middle Layer Film and Organic Antireflective Film or Adhesive Film]

The present invention also provides a patterning process including:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming an organic antireflective film or an adhesive film on the inorganic hard mask;
forming a resist upper layer film on the organic antireflective film or the adhesive film by using a resist upper layer film material containing a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic film by etching while using the inorganic hard mask having the transferred pattern as a mask; and
further forming the pattern in the body to be processed by etching while using the organic film having the transferred pattern as a mask.

This method can be performed in the same manner as the three-layer resist process using the inorganic hard mask middle layer film, except that the organic antireflective film (BARC) or the adhesive film is formed between the inorganic hard mask middle layer film and the resist upper layer film.

Particularly, when a SiON film is used as the inorganic hard mask middle layer film, two antireflective films including the SiON film and the BARC make it possible to suppress the reflection even in liquid immersion exposure at a high NA exceeding 1.0. Another merit of forming the BARC is having an effect of reducing trailing of the resist upper layer film pattern immediately above the SiON film.

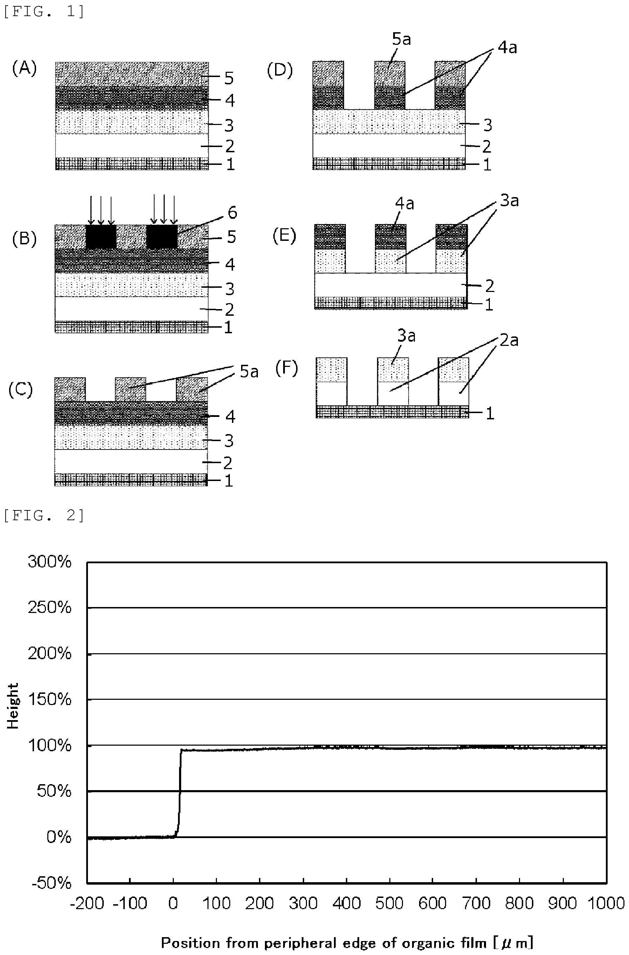

Here, an example of the inventive patterning processes according to a three-layer resist process is shown in FIG. 1 (A) to (F). In the case of a three-layer resist process, as shown in FIG. 1 (A), an organic film 3 is formed by using the inventive composition for forming an organic film on a layer 2 to be processed (body to be processed) formed on a substrate 1; then, a silicon-containing resist middle layer film 4 is formed on the organic film 3; and a resist upper layer film 5 is formed thereon. Next, as shown in FIG. 1 (B), an exposure portion 6 of the resist upper layer film 5 is exposed, and then PEB (post-exposure baking) is performed. Next, as shown in FIG. 1 (C), development is performed to form a resist upper layer film pattern 5a. Next, as shown in FIG. 1 (D), the silicon-containing resist middle layer film 4 is dry-etched by using a fluorocarbon-based gas while using the resist upper layer film pattern 5a as a mask, and thus, a silicon-containing resist middle layer film pattern 4a is formed. Next, the resist upper layer film pattern 5a is removed, then, as shown in FIG. 1 (E), the organic film 3 is etched with oxygen plasma while using the silicon-containing resist middle layer film pattern 4a as a mask, and thus, an organic film pattern 3a is formed. Furthermore, as shown in FIG. 1 (F), the silicon-containing resist middle layer film pattern 4a is removed, then the layer 2 to be processed is etched while using the organic film pattern 3a as a mask, and thus, a pattern 2a is formed.

In the patterning process of this example, by humps being suppressed when the organic film 3 is formed, during the dry etching of FIG. 1 (D), (E), and (F), it is possible to reduce defects that are generated due to humps of the organic film.

In a case where an inorganic hard mask middle layer film is formed, the silicon-containing resist middle layer film 4 can be changed to an inorganic hard mask middle layer film, and in a case where a BARC or an adhesive film is formed, the BARC or the adhesive film can be formed between the silicon-containing resist middle layer film 4 and the resist upper layer film 5. The etching of the BARC or the adhesive film may be performed continuously before the etching of the silicon-containing resist middle layer film 4; alternatively, after the BARC or the adhesive film alone is etched, the etching apparatus may be changed and so forth, and then the etching of the silicon-containing resist middle layer film 4 may be performed.

As described above, the inventive patterning processes make it possible to form a fine pattern in a body to be processed with high precision according to a multilayer resist process, and to suppress hump formation on an organic film, thus reducing defects derived from humps of the organic film.

### EXAMPLES

Hereinafter, the present invention will be further specifically described with reference to Synthesis Examples, Comparative Synthesis Examples, Examples, and Comparative Examples. However, the present invention is not limited thereto. Note that, specifically, the molecular weight was measured in the following manner. Weight-average molecular weight (Mw) and number-average molecular weight (Mn) on polystyrene basis were measured by gel permeation chromatography (GPC) using tetrahydrofuran as an eluent (solvent), and dispersity (Mw/Mn) was calculated therefrom.

### [Synthesis of Aryl Benzyl Ether Compounds (B-1) to (B-14)]

For the synthesis of aryl benzyl ether compounds (B-1) to (B-14), used for the preparation of compositions (UDL-1 to -89) for forming an organic film in the Examples, the following phenol-based compounds (a1) to (a14) and bromo compounds (b1) to (b4) were used.

### Phenol-Based Compounds

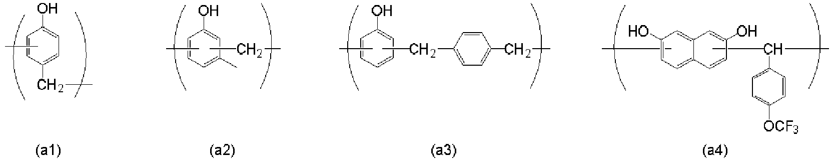

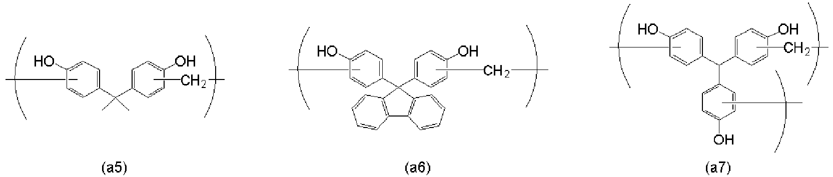

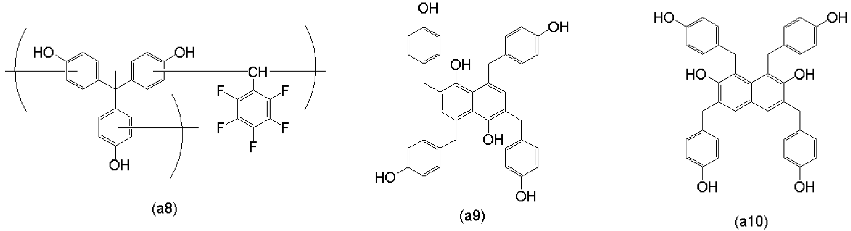

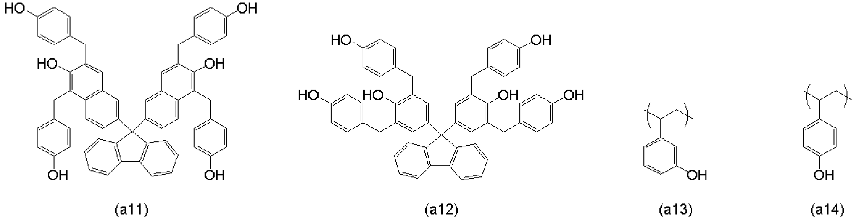

### Bromo Compounds

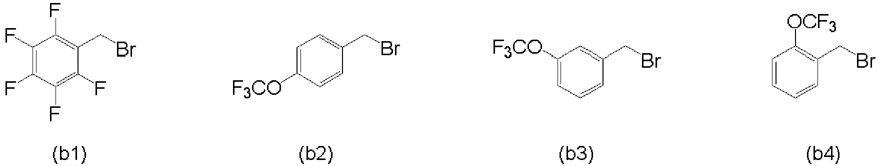

### [Synthesis Example 1] Synthesis of Aryl Benzyl Ether Compound (B-1)

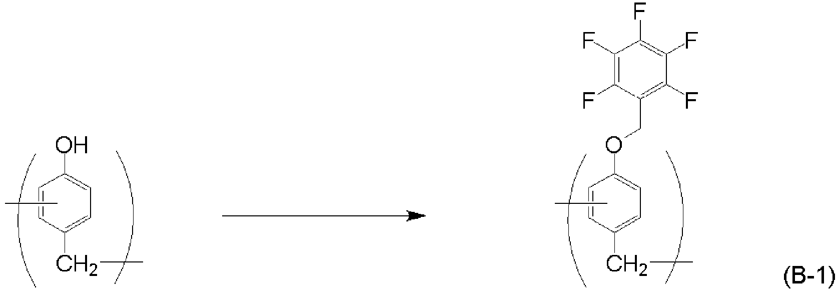

To 2.12 g of the phenol-based compound (a1) and 2.76 g of potassium carbonate, 60.0 g of DMF (N,N-dimethylformamide) was added, and under a nitrogen atmosphere, the mixture was stirred at an internal temperature of 60°C to form a homogeneous solution. After that, 5.22 g of the bromo compound (b1) was added dropwise to the homogeneous solution over 5 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-1) was obtained.

The weight-average molecular weight (Mw) and the dispersity (Mw/Mn) were determined by GPC, and the following results were obtained.
(B-1): Mw=4030, Mw/Mn=2.64

### [Synthesis Example 2] Synthesis of Aryl Benzyl Ether Compound (B-2)

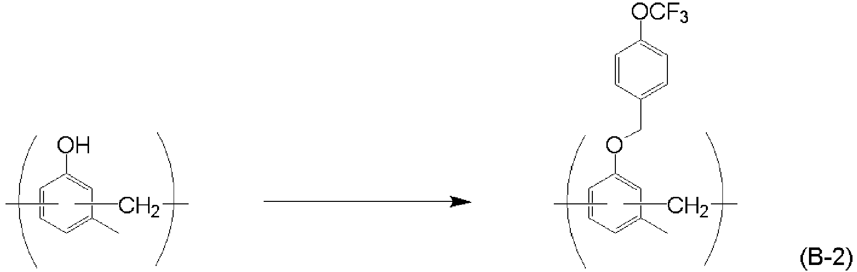

To 2.67 g of the phenol-based compound (a2) and 2.76 g of potassium carbonate, 60.0 g of DMF (N,N-dimethylformamide) was added, and under a nitrogen atmosphere, the mixture was stirred at an internal temperature of 60°C to form a homogeneous solution. After that, 5.10 g of the bromo compound (b2) was added dropwise to the homogeneous solution over 5 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-2) was obtained.

The weight-average molecular weight (Mw) and the dispersity (Mw/Mn) were determined by GPC, and the following results were obtained.
(B-2): Mw=7780, Mw/Mn=5.15

### [Synthesis Example 3] Synthesis of Aryl Benzyl Ether Compound (B-3)

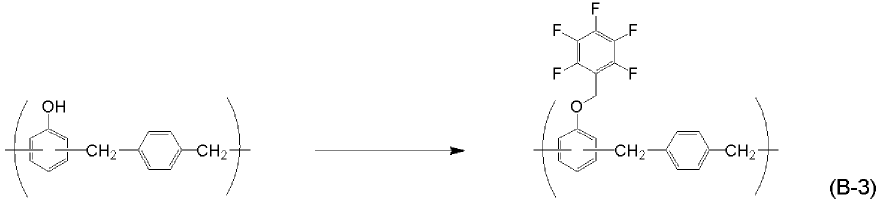

To 2.90 g of the phenol-based compound (a3) and 2.76 g of potassium carbonate, 60.0 g of DMF (N,N-dimethylformamide) was added, and under a nitrogen atmosphere, the mixture was stirred at an internal temperature of 60°C to form a homogeneous solution. After that, 5.22 g of the bromo compound (b1) was added dropwise to the homogeneous solution over 5 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-3) was obtained.

The weight-average molecular weight (Mw) and the dispersity (Mw/Mn) were determined by GPC, and the following results were obtained.
(B-3): Mw=5180, Mw/Mn=2.78

### [Synthesis Example 4] Synthesis of Aryl Benzyl Ether Compound (B-4)

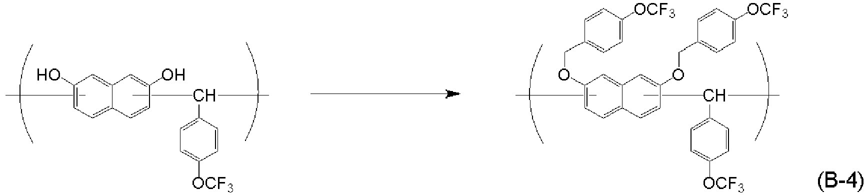

To 6.30 g of the phenol-based compound (a4) and 5.53 g of potassium carbonate, 60.0 g of DMF (N,N-dimethylformamide) was added, and under a nitrogen atmosphere, the mixture was stirred at an internal temperature of 60°C to form a homogeneous solution. After that, 10.20 g of the bromo compound (b2) was added dropwise to the homogeneous solution over 10 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-4) was obtained.

The weight-average molecular weight (Mw) and the dispersity (Mw/Mn) were determined by GPC, and the following results were obtained.
(B-4): Mw=4745, Mw/Mn=2.42

### [Synthesis Example 5] Synthesis of Aryl Benzyl Ether Compound (B-5)

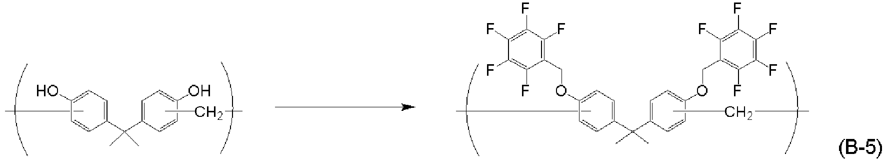

To 5.70 g of the phenol-based compound (a5) and 5.53 g of potassium carbonate, 60.0 g of DMF (N,N-dimethylformamide) was added, and under a nitrogen atmosphere, the mixture was stirred at an internal temperature of 60°C to form a homogeneous solution. After that, 10.44 g of the bromo compound (b1) was added dropwise to the homogeneous solution over 10 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-5) was obtained.

The weight-average molecular weight (Mw) and the dispersity (Mw/Mn) were determined by GPC, and the following results were obtained.
(B-5): Mw=3790, Mw/Mn=2.81

### [Synthesis Example 6] Synthesis of Aryl Benzyl Ether Compound (B-6)

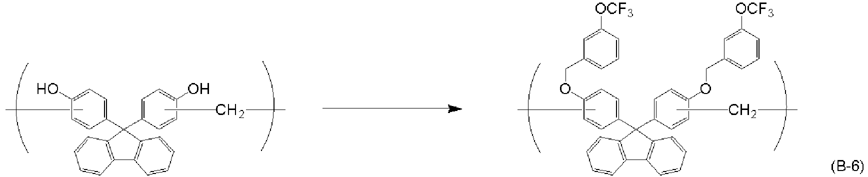

To 7.52 g of the phenol-based compound (a6) and 5.53 g of potassium carbonate, 60.0 g of DMF (N,N-dimethylformamide) was added, and under a nitrogen atmosphere, the mixture was stirred at an internal temperature of 60°C to form a homogeneous solution. After that, 10.20 g of the bromo compound (b3) was added dropwise to the homogeneous solution over 10 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-6) was obtained.

The weight-average molecular weight (Mw) and the dispersity (Mw/Mn) were determined by GPC, and the following results were obtained.
(B-6): Mw=4120, Mw/Mn=3.24

### [Synthesis Example 7] Synthesis of Aryl Benzyl Ether Compound (B-7)

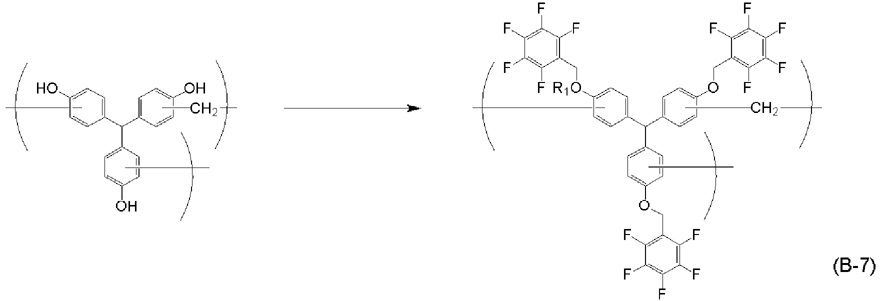

To 6.35 g of the phenol-based compound (a7) and 8.29 g of potassium carbonate, 60.0 g of DMF (N,N-dimethylformamide) was added, and under a nitrogen atmosphere, the mixture was stirred at an internal temperature of 60°C to form a homogeneous solution. After that, 15.66 g of the bromo compound (b1) was added dropwise to the homogeneous solution over 20 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-7) was obtained.

The weight-average molecular weight (Mw) and the dispersity (Mw/Mn) were determined by GPC, and the following results were obtained.
(B-7): Mw=12830, Mw/Mn=6.47

### [Synthesis Example 8] Synthesis of Aryl Benzyl Ether Compound (B-8)

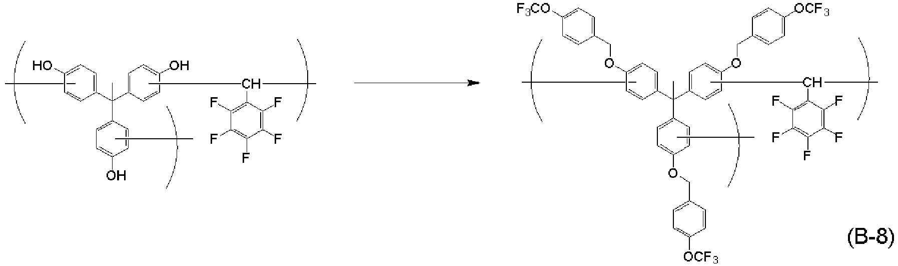

To 9.63 g of the phenol-based compound (a8) and 8.29 g of potassium carbonate, 60.0 g of DMF (N,N-dimethylformamide) was added, and under a nitrogen atmosphere, the mixture was stirred at an internal temperature of 60°C to form a homogeneous solution. After that, 15.30 g of the bromo compound (b2) was added dropwise to the homogeneous solution over 20 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-8) was obtained.

The weight-average molecular weight (Mw) and the dispersity (Mw/Mn) were determined by GPC, and the following results were obtained.
(B-8): Mw=2780, Mw/Mn=1.62

### [Synthesis Example 9] Synthesis of Aryl Benzyl Ether Compound (B-9)

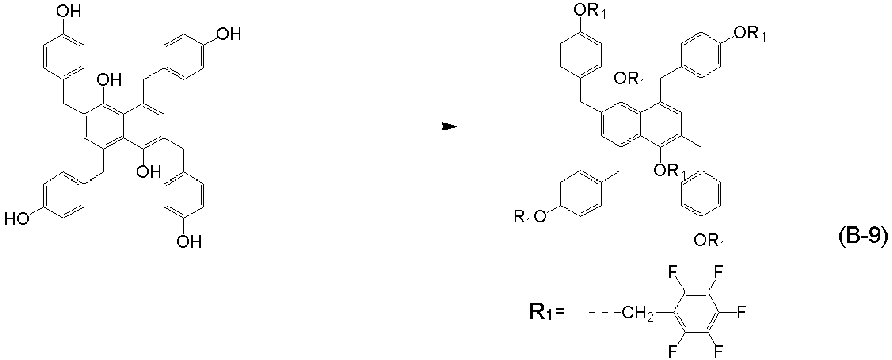

To 11.69 g of the phenol-based compound (a9) and 16.58 g of potassium carbonate, 60.0 g of DMF (N,N-dimethylformamide) was added, and under a nitrogen atmosphere, the mixture was stirred at an internal temperature of 60°C to form a homogeneous solution. After that, 31.32 g of the bromo compound (b1) was added dropwise to the homogeneous solution over 30 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-9) was obtained.

The weight-average molecular weight (Mw) and the dispersity (Mw/Mn) were determined by GPC, and the following results were obtained.
(B-9): Mw=2040, Mw/Mn=1.24

### [Synthesis Example 10] Synthesis of Aryl Benzyl Ether Compound (B-10)

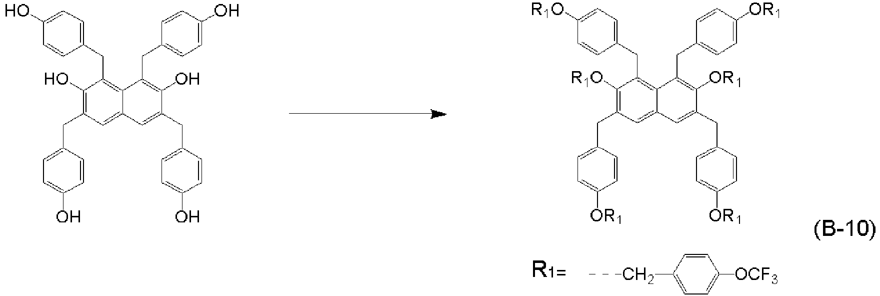

To 11.69 g of the phenol-based compound (a10) and 16.58 g of potassium carbonate, 60.0 g of DMF (N,N-dimethylformamide) was added, and under a nitrogen atmosphere, the mixture was stirred at an internal temperature of 60°C to form a homogeneous solution. After that, 30.60 g of the bromo compound (b2) was added dropwise to the homogeneous solution over 30 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-10) was obtained.

The weight-average molecular weight (Mw) and the dispersity (Mw/Mn) were determined by GPC, and the following results were obtained.
(B-10): Mw=2240, Mw/Mn=1.18

### [Synthesis Example 11] Synthesis of Aryl Benzyl Ether Compound (B-11)

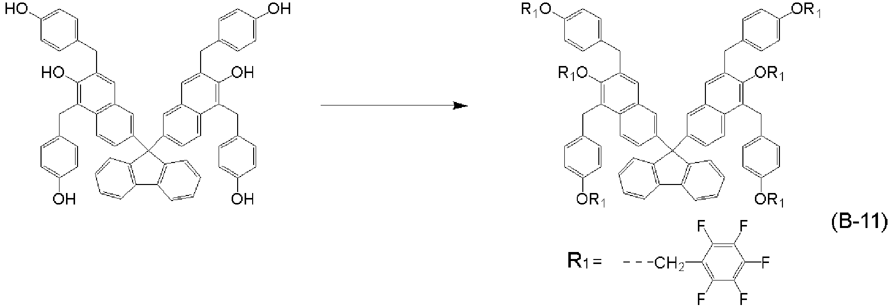

To 17.50 g of the phenol-based compound (a11) and 16.58 g of potassium carbonate, 60.0 g of DMF (N,N-dimethylformamide) was added, and under a nitrogen atmosphere, the mixture was stirred at an internal temperature of 60°C to form a homogeneous solution. After that, 31.32 g of the bromo compound (b1) was added dropwise to the homogeneous solution over 30 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-11) was obtained.

The weight-average molecular weight (Mw) and the dispersity (Mw/Mn) were determined by GPC, and the following results were obtained.
(B-11): Mw=3750, Mw/Mn=1.49

### [Synthesis Example 12] Synthesis of Aryl Benzyl Ether Compound (B-12)

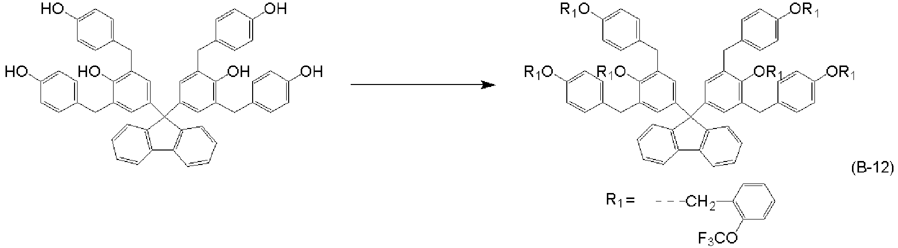

To 15.50 g of the phenol-based compound (a12) and 16.58 g of potassium carbonate, 60.0 g of DMF (N,N-dimethylformamide) was added, and under a nitrogen atmosphere, the mixture was stirred at an internal temperature of 60°C to form a homogeneous solution. After that, 30.60 g of the bromo compound (b4) was added dropwise to the homogeneous solution over 30 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-12) was obtained.

The weight-average molecular weight (Mw) and the dispersity (Mw/Mn) were determined by GPC, and the following results were obtained.
(B-12): Mw=3120, Mw/Mn=2.33

### [Synthesis Example 13] Synthesis of Aryl Benzyl Ether Compound (B-13)

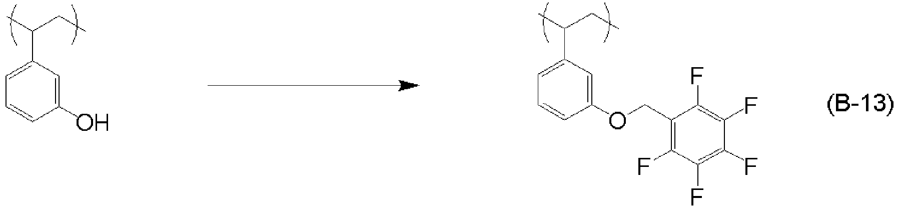

To 2.40 g of the phenol-based compound (a13) and 2.76 g of potassium carbonate, 60.0 g of DMF (N,N-dimethylformamide) was added, and under a nitrogen atmosphere, the mixture was stirred at an internal temperature of 60°C to form a homogeneous solution. After that, 5.22 g of the bromo compound (b1) was added dropwise to the homogeneous solution over 5 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-13) was obtained.

The weight-average molecular weight (Mw) and the dispersity (Mw/Mn) were determined by GPC, and the following results were obtained.
(B-13): Mw=23560, Mw/Mn=1.13

### [Synthesis Example 14] Synthesis of Aryl Benzyl Ether Compound (B-14)

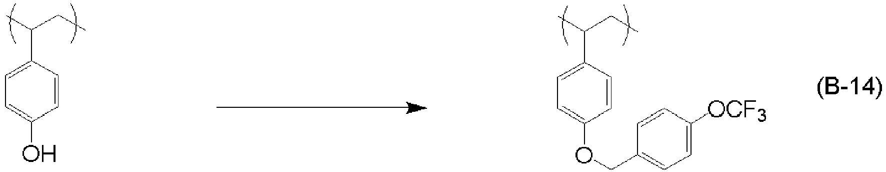

To 2.40 g of the phenol-based compound (a14) and 2.76 g of potassium carbonate, 60.0 g of DMF (N,N-dimethylformamide) was added, and under a nitrogen atmosphere, the mixture was stirred at an internal temperature of 60°C to form a homogeneous solution. After that, 5.10 g of the bromo compound (b2) was added dropwise to the homogeneous solution over 5 minutes, and then a reaction was allowed to take place at an internal temperature of 60°C for 24 hours. The reaction solution was cooled to room temperature, then 100 ml of methyl isobutyl ketone and 100 ml of pure water were added to the reaction solution and the mixture was homogenized, and then the separated aqueous layer was removed. Furthermore, the organic layer was washed twice with 100 ml of a 3% aqueous solution of nitric acid and five times with 100 ml of pure water, and then the organic layer was evaporated under reduced pressure to dryness. Thus, an aryl benzyl ether compound (B-14) was obtained.

The weight-average molecular weight (Mw) and the dispersity (Mw/Mn) were determined by GPC, and the following results were obtained.
(B-14): Mw=20726, Mw/Mn=1.10

### [Synthesis of Comparative Compounds (R1) to (R8)]

For the synthesis of comparative compounds (R1) to (R8), used for the preparation of comparative compositions (comparative UDL-1 to -13) for forming an organic film, the following monomers (r1) to (r12) were used.

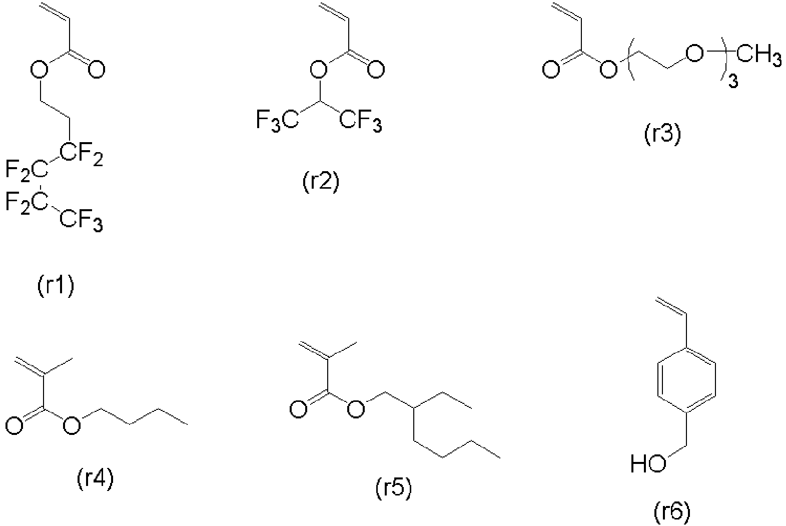

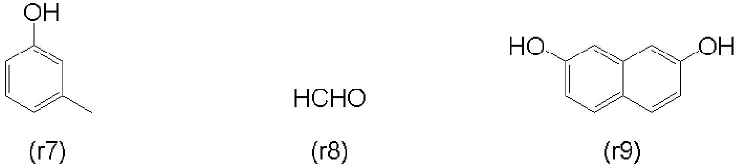

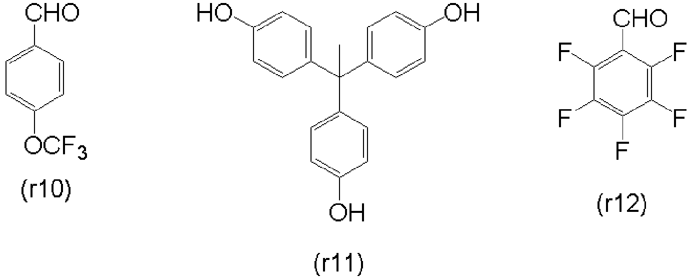

### [Comparative Synthesis Example 1] Synthesis of Comparative Compound (R1)

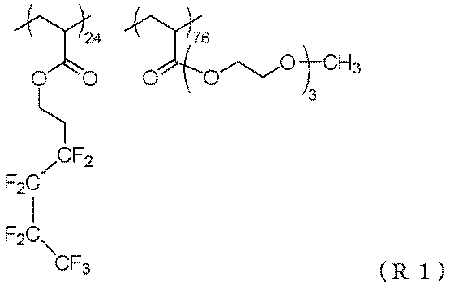

Under a nitrogen atmosphere, 6.0 g of propylene glycol monomethyl ether acetate (PGMEA) was heated and stirred at 80°C. A mixture of 3.44 g (0.011 mol) of the monomer (r1), 7.46 g (0.034 mol) of the monomer (r3), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target compound (R1) in PGMEA was obtained.

The weight-average molecular weight (Mw) and the dispersity (Mw/Mn) were determined by GPC, and the following results were obtained.
(R1): Mw=9500, Mw/Mn=1.20

### [Comparative Synthesis Example 2] Synthesis of Comparative Compound (R2)

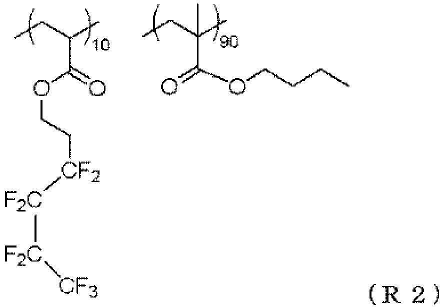

Under a nitrogen atmosphere, 6.0 g of propylene glycol monomethyl ether acetate (PGMEA) was heated and stirred at 80°C. A mixture of 1.43 g (0.005 mol) of the monomer (r1), 5.76 g (0.041 mol) of the monomer (r4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target compound (R2) in PGMEA was obtained.

The weight-average molecular weight (Mw) and the dispersity (Mw/Mn) were determined by GPC, and the following results were obtained.
(R2): Mw=5800, Mw/Mn=1.42

### [Comparative Synthesis Example 3] Synthesis of Comparative Compound (R3)

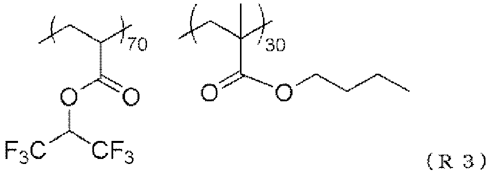

Under a nitrogen atmosphere, 6.0 g of propylene glycol monomethyl ether acetate (PGMEA) was heated and stirred at 80°C. A mixture of 7.00 g (0.032 mol) of the monomer (r2), 1.92 g (0.014 mol) of the monomer (r4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target compound (R3) in PGMEA was obtained.

The weight-average molecular weight (Mw) and the dispersity (Mw/Mn) were determined by GPC, and the following results were obtained.
(R3): Mw=6200, Mw/Mn=1.33

### [Comparative Synthesis Example 4] Synthesis of Comparative Compound (R4)

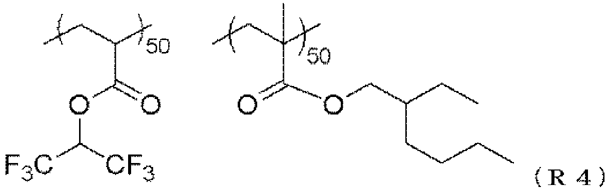

Under a nitrogen atmosphere, 6.0 g of propylene glycol monomethyl ether acetate (PGMEA) was heated and stirred at 80°C. A mixture of 5.00 g (0.023 mol) of the monomer (r2), 3.20 g (0.023 mol) of the monomer (r5), 0.473 g of dimethyl 2,2-azobis(2-methylpropionate), and 34 g of PGMEA was added dropwise thereto over 4 hours. This mixture was further heated and stirred for 16 hours, and then cooled to room temperature. Thus, a solution of the target compound (R4) in PGMEA was obtained.

The weight-average molecular weight (Mw) and the dispersity (Mw/Mn) were determined by GPC, and the following results were obtained.
(R4): Mw=8300, Mw/Mn=1.33

### [Comparative Synthesis Example 5] Synthesis of Comparative Compound (R5)

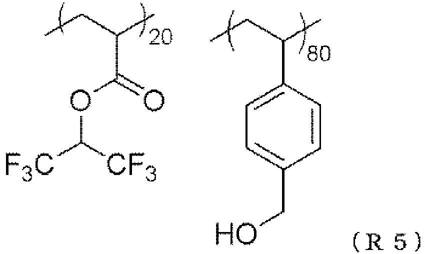

Under a nitrogen atmosphere, 6.0 g of propylene glycol monomethyl ether acetate (PGMEA) was heated and stirred at 80°C. A mixture of 2.00 g (0.009 mol) of the monomer (r2), 5.41 g (0.036 mol) of the monomer (r6), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a solution of the target compound (R5) in PGMEA was obtained.

The weight-average molecular weight (Mw) and the dispersity (Mw/Mn) were determined by GPC, and the following results were obtained.
(R5): Mw=3800, Mw/Mn=1.44

### [Comparative Synthesis Example 6] Synthesis of Comparative Compound (R6)

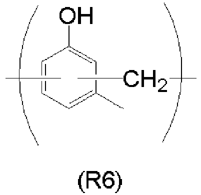

Under a nitrogen atmosphere, to 2.16 g of the monomer (r7) and 0.54 g of the monomer (r8), 40.0 g of PGME (propylene glycol monomethyl ether) was added, and the mixture was stirred at an internal temperature of 110°C to form a homogeneous solution. After that, 0.38 g of p-toluenesulfonic acid was added to the homogeneous solution, and a reaction was allowed to take place at an internal temperature of 110°C for 24 hours. The reaction solution was cooled to room temperature, then 100 ml of methyl isobutyl ketone and 100 ml of pure water were added to the reaction solution and the mixture was homogenized, and then the separated aqueous layer was removed. After further washing five times with 100 ml of pure water, the organic layer was evaporated under reduced pressure to dryness. Thus, the target compound (R6) was obtained.

The weight-average molecular weight (Mw) and the dispersity (Mw/Mn) were determined by GPC, and the following results were obtained.
(R6): Mw=5700, Mw/Mn=3.55

### [Comparative Synthesis Example 7] Synthesis of Comparative Compound (R7)

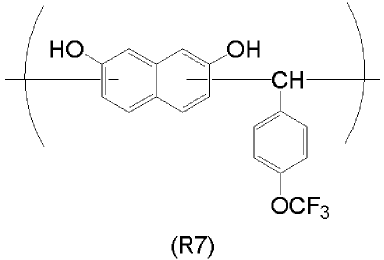

Under a nitrogen atmosphere, to 3.20 g of the monomer (r9) and 3.42 g of the monomer (r10), 40.0 g of 1,2-dichloroethane was added, and the mixture was stirred at an internal temperature of 50°C to form a homogeneous solution. After that, 1.92 g of methanesulfonic acid was added to the homogeneous solution, and a reaction was allowed to take place at an internal temperature of 70°C for 24 hours. The reaction solution was cooled to room temperature, then 100 ml of methyl isobutyl ketone and 100 ml of pure water were added to the reaction solution and the mixture was homogenized, and then the separated aqueous layer was removed. After further washing five times with 100 ml of pure water, the organic layer was evaporated under reduced pressure to dryness. Thus, the target compound (R7) was obtained.

The weight-average molecular weight (Mw) and the dispersity (Mw/Mn) were determined by GPC, and the following results were obtained.
(R7): Mw=3250, Mw/Mn=2.12

### [Comparative Synthesis Example 8] Synthesis of Comparative Compound (R8)

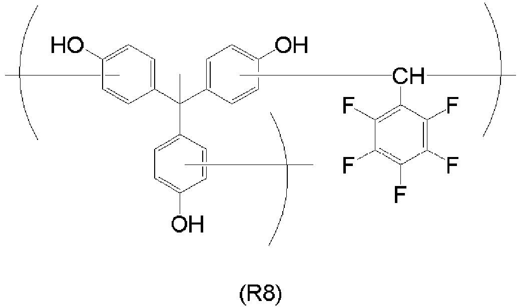

Under a nitrogen atmosphere, to 6.13 g of the monomer (r11) and 3.53 g of the monomer (r12), 40.0 g of 1,2-dichloroethane was added, and the mixture was stirred at an internal temperature of 50°C to form a homogeneous solution. After that, 1.92 g of methanesulfonic acid was added thereto, and a reaction was allowed to take place at an internal temperature of 70°C for 24 hours. The reaction solution was cooled to room temperature, then 100 ml of methyl isobutyl ketone and 100 ml of pure water were added to the reaction solution and the mixture was homogenized, and then the separated aqueous layer was removed. After further washing five times with 100 ml of pure water, the organic layer was evaporated under reduced pressure to dryness. Thus, the target compound (R8) was obtained.

The weight-average molecular weight (Mw) and the dispersity (Mw/Mn) were determined by GPC, and the following results were obtained.
(R8): Mw=1660, Mw/Mn=1.92

### [Material (A) for Forming Organic Film (Resin or Compound)]

In the preparation of the compositions (UDL-1 to -89 and comparative UDL-1 to -19) for forming an organic film in the Examples and Comparative Examples, the following resins and compounds were used as materials (A) for forming an organic film.
M1: a resin represented by the following formula (M1)
M2: a resin represented by the following formula (M2)
M3: a compound represented by the following formula (M3)
M4: a compound represented by the following formula (M4)
M5: a resin represented by the following formula (M5)
M6: a resin represented by the following formula (M6)

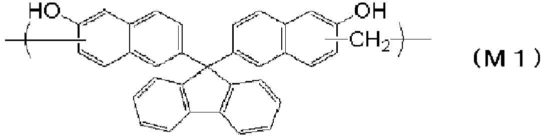

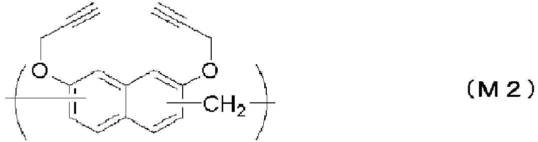

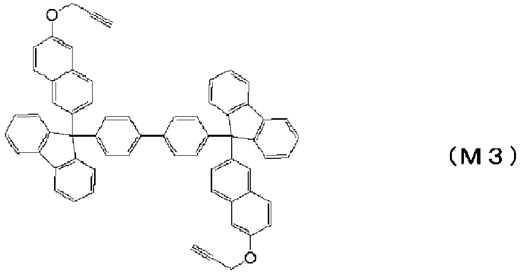

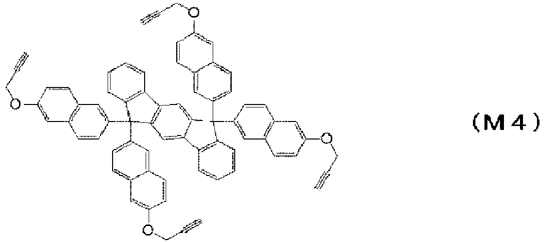

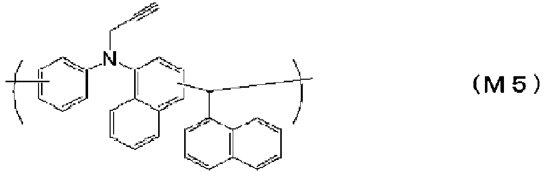

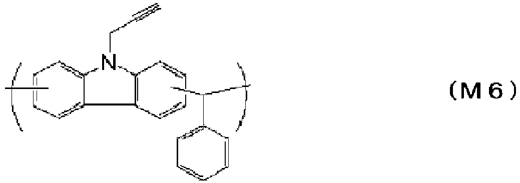

### [Solvent (C)]

In the preparation of the compositions (UDL-1 to -89 and comparative UDL-1 to -19) for forming an organic film in the Examples and Comparative Examples, the following solvents were used as a solvent (C).
(S1): propylene glycol monomethyl ether acetate
(S2): propylene glycol monoethyl ether

### [Preparation of Compositions (UDL-1 to -89 and Comparative UDL-1 to -19) for Forming Organic Film]

One of the compounds (B-1) to (B-14) and (R1) to (R8), one of the materials (M1) to (M6) for forming an organic film, and one or both of the solvents given above were dissolved in the proportions shown in Tables 1 to 3. The mixture thus obtained was filtered through a 0.1-pm filter made of a fluorinated resin to prepare each of compositions (resist underlayer film materials: UDL-1 to -89 and comparative UDL-1 to -13) for forming an organic film. Meanwhile, one of the materials (M1) to (M6) for forming an organic film and the solvent (S1) were dissolved in the proportions shown in Table 3. The mixture thus obtained was filtered through a 0.1-pm filter made of a fluorinated resin to prepare each of compositions (resist underlayer film materials: comparative UDL-14 to -19) for forming an organic film.

**[Table 1]**

| Composition for forming organic film | (A) Material for forming organic film | | (B) Aryl benzyl ether compound | | (C) Solvent 1 | | (C) Solvent 2 | |
|---|---|---|---|---|---|---|---|---|
| | Type | Parts by mass | Type | Parts by mass | Type | Parts by mass | Type | Parts by mass |
| UDL-1 | (M1) | 10.00 | (B-1) | 0.10 | (S1) | 89.90 | | |
| UDL-2 | (M1) | 10.00 | (B-2) | 0.10 | (S1) | 89.90 | | |
| UDL-3 | (M1) | 10.00 | (B-3) | 0.10 | (S1) | 89.90 | | |
| UDL-4 | (M1) | 10.00 | (B-4) | 0.10 | (S1) | 89.90 | | |
| UDL-5 | (M1) | 10.00 | (B-5) | 0.10 | (S1) | 89.90 | | |
| UDL-6 | (M1) | 10.00 | (B-6) | 0.10 | (S1) | 89.90 | | |
| UDL-7 | (M1) | 10.00 | (B-7) | 0.10 | (S1) | 89.90 | | |
| UDL-8 | (M1) | 10.00 | (B-8) | 0.10 | (S1) | 89.90 | | |
| UDL-9 | (M1) | 10.00 | (B-9) | 0.10 | (S1) | 89.90 | | |
| UDL-10 | (M1) | 10.00 | (B-10) | 0.10 | (S1) | 89.90 | | |
| UDL-11 | (M1) | 10.00 | (B-11) | 0.10 | (S1) | 89.90 | | |
| UDL-12 | (M1) | 10.00 | (B-12) | 0.10 | (S1) | 89.90 | | |
| UDL-13 | (M1) | 10.00 | (B-13) | 0.10 | (S1) | 89.90 | | |
| UDL-14 | (M1) | 10.00 | (B-14) | 0.10 | (S1) | 89.90 | | |
| UDL-15 | (M1) | 10.00 | (B-1) | 0.10 | (S1) | 62.93 | (S2) | 26. 97 |
| UDL-16 | (M1) | 10.00 | (B-2) | 0.10 | (S1) | 62.93 | (S2) | 26. 97 |
| UDL-17 | (M1) | 10.00 | (B-4) | 0.10 | (S1) | 62.93 | (S2) | 26. 97 |
| UDL-18 | (M1) | 10.00 | (B-8) | 0.10 | (S1) | 62.93 | (S2) | 26. 97 |
| UDL-19 | (M1) | 10.00 | (B-2) | 0.001 | (S1) | 90.00 | | |
| UDL-20 | (M2) | 10.00 | (B-1) | 0.10 | (S1) | 89.90 | | |
| UDL-21 | (M2) | 10.00 | (B-2) | 0.10 | (S1) | 89.90 | | |
| UDL-22 | (M2) | 10.00 | (B-3) | 0.10 | (S1) | 89.90 | | |
| UDL-23 | (M2) | 10.00 | (B-4) | 0.10 | (S1) | 89.90 | | |
| UDL-24 | (M2) | 10.00 | (B-5) | 0.10 | (S1) | 89.90 | | |
| UDL-25 | (M2) | 10.00 | (B-6) | 0.10 | (S1) | 89.90 | | |
| UDL-26 | (M2) | 10.00 | (B-7) | 0.10 | (S1) | 89.90 | | |
| UDL-27 | (M2) | 10.00 | (B-8) | 0.10 | (S1) | 89.90 | | |
| UDL-28 | (M2) | 10.00 | (B-9) | 0.10 | (S1) | 89.90 | | |
| UDL-29 | (M2) | 10.00 | (B-10) | 0.10 | (S1) | 89.90 | | |
| UDL-30 | (M2) | 10.00 | (B-11) | 0.10 | (S1) | 89.90 | | |
| UDL-31 | (M2) | 10.00 | (B-12) | 0.10 | (S1) | 89.90 | | |
| UDL-32 | (M2) | 10.00 | (B-13) | 0.10 | (S1) | 89.90 | | |
| UDL-33 | (M2) | 10.00 | (B-14) | 0.10 | (S1) | 89.90 | | |
| UDL-34 | (M3) | 10.00 | (B-1) | 0.10 | (S1) | 89.90 | | |
| UDL-35 | (M3) | 10.00 | (B-2) | 0.10 | (S1) | 89.90 | | |
| UDL-36 | (M3) | 10.00 | (B-3) | 0.10 | (S1) | 89.90 | | |

**[Table 2]**

| Composition for forming organic film | (A) Material for forming organic film | | (B) Aryl benzyl ether compound | | (C) Solvent 1 | | (C) Solvent 2 | |
|---|---|---|---|---|---|---|---|---|
| | Type | Parts by mass | Type | Parts by mass | Type | Parts by mass | Type | Parts by mass |
| UDL-37 | (M3) | 10.00 | (B-4) | 0.10 | (S1) | 89.90 | | |
| UDL-38 | (M3) | 10.00 | (B-5) | 0.10 | (S1) | 89.90 | | |
| UDL-39 | (M3) | 10.00 | (B-6) | 0.10 | (S1) | 89.90 | | |
| UDL-40 | (M3) | 10.00 | (B-7) | 0.10 | (S1) | 89.90 | | |
| UDL-41 | (M3) | 10.00 | (B-8) | 0.10 | (S1) | 89.90 | | |
| UDL-42 | (M3) | 10.00 | (B-9) | 0.10 | (S1) | 89.90 | | |
| UDL-43 | (M3) | 10.00 | (B-10) | 0.10 | (S1) | 89.90 | | |
| UDL-44 | (M3) | 10.00 | (B-11) | 0.10 | (S1) | 89.90 | | |
| UDL-45 | (M3) | 10.00 | (B-12) | 0.10 | (S1) | 89.90 | | |
| UDL-46 | (M3) | 10.00 | (B-13) | 0.10 | (S1) | 89.90 | | |
| UDL-47 | (M3) | 10.00 | (B-14) | 0.10 | (S1) | 89.90 | | |
| UDL-48 | (M4) | 10.00 | (B-1) | 0.10 | (S1) | 89.90 | | |
| UDL-49 | (M4) | 10.00 | (B-2) | 0.10 | (S1) | 89.90 | | |
| UDL-50 | (M4) | 10.00 | (B-3) | 0.10 | (S1) | 89.90 | | |
| UDL-51 | (M4) | 10.00 | (B-4) | 0.10 | (S1) | 89.90 | | |
| UDL-52 | (M4) | 10.00 | (B-5) | 0.10 | (S1) | 89.90 | | |
| UDL-53 | (M4) | 10.00 | (B-6) | 0.10 | (S1) | 89.90 | | |
| UDL-54 | (M4) | 10.00 | (B-7) | 0.10 | (S1) | 89.90 | | |
| UDL-55 | (M4) | 10.00 | (B-8) | 0.10 | (S1) | 89.90 | | |
| UDL-56 | (M4) | 10.00 | (B-9) | 0.10 | (S1) | 89.90 | | |
| UDL-57 | (M4) | 10.00 | (B-10) | 0.10 | (S1) | 89.90 | | |
| UDL-58 | (M4) | 10.00 | (B-11) | 0.10 | (S1) | 89.90 | | |
| UDL-59 | (M4) | 10.00 | (B-12) | 0.10 | (S1) | 89.90 | | |
| UDL-60 | (M4) | 10.00 | (B-13) | 0.10 | (S1) | 89.90 | | |
| UDL-61 | (M4) | 10.00 | (B-14) | 0.10 | (S1) | 89.90 | | |
| UDL-62 | (M5) | 10.00 | (B-1) | 0.10 | (S1) | 89.90 | | |
| UDL-63 | (M5) | 10.00 | (B-2) | 0.10 | (S1) | 89.90 | | |
| UDL-64 | (M5) | 10.00 | (B-3) | 0.10 | (S1) | 89.90 | | |
| UDL-65 | (M5) | 10.00 | (B-4) | 0.10 | (S1) | 89.90 | | |
| UDL-66 | (M5) | 10.00 | (B-5) | 0.10 | (S1) | 89.90 | | |
| UDL-67 | (M5) | 10.00 | (B-6) | 0.10 | (S1) | 89.90 | | |
| UDL-68 | (M5) | 10.00 | (B-7) | 0.10 | (S1) | 89.90 | | |
| UDL-69 | (M5) | 10.00 | (B-8) | 0.10 | (S1) | 89.90 | | |
| UDL-70 | (M5) | 10.00 | (B-9) | 0.10 | (S1) | 89.90 | | |
| UDL-71 | (M5) | 10.00 | (B-10) | 0.10 | (S1) | 89.90 | | |
| UDL-72 | (M5) | 10.00 | (B-11) | 0.10 | (S1) | 89.90 | | |

**[Table 3]**

| Composition for forming organic film | (A) Material for forming organic film | | (B) Aryl benzyl ether compound or comparative compound | | (C) Solvent 1 | | (C) Solvent 2 | |
|---|---|---|---|---|---|---|---|---|
| | Type | Parts by mass | Type | Parts by mass | Type | Parts by mass | Type | Parts by mass |
| UDL-73 | (M5) | 10.00 | (B-12) | 0.10 | (S1) | 89.90 | | |
| UDL-74 | (M5) | 10.00 | (B-13) | 0.10 | (S1) | 89.90 | | |
| UDL-75 | (M5) | 10.00 | (B-14) | 0.10 | (S1) | 89.90 | | |
| UDL-76 | (M6) | 10.00 | (B-1) | 0.10 | (S1) | 89.90 | | |
| UDL-77 | (M6) | 10.00 | (B-2) | 0.10 | (S1) | 89.90 | | |
| UDL-78 | (M6) | 10.00 | (B-3) | 0.10 | (S1) | 89.90 | | |
| UDL-79 | (M6) | 10.00 | (B-4) | 0.10 | (S1) | 89.90 | | |
| UDL-80 | (M6) | 10.00 | (B-5) | 0.10 | (S1) | 89.90 | | |
| UDL-81 | (M6) | 10.00 | (B-6) | 0.10 | (S1) | 89.90 | | |
| UDL-82 | (M6) | 10.00 | (B-7) | 0.10 | (S1) | 89.90 | | |
| UDL-83 | (M6) | 10.00 | (B-8) | 0.10 | (S1) | 89.90 | | |
| UDL-84 | (M6) | 10.00 | (B-9) | 0.10 | (S1) | 89.90 | | |
| UDL-85 | (M6) | 10.00 | (B-10) | 0.10 | (S1) | 89.90 | | |
| UDL-86 | (M6) | 10.00 | (B-11) | 0.10 | (S1) | 89.90 | | |
| UDL-87 | (M6) | 10.00 | (B-12) | 0.10 | (S1) | 89.90 | | |
| UDL-88 | (M6) | 10.00 | (B-13) | 0.10 | (S1) | 89.90 | | |
| UDL-89 | (M6) | 10.00 | (B-14) | 0.10 | (S1) | 89.90 | | |
| Comparative UDL-1 | (M1) | 10.00 | (R1) | 0.10 | (S1) | 89.90 | | |
| Comparative UDL-2 | (M2) | 10.00 | (R1) | 0.10 | (S1) | 89.90 | | |
| Comparative UDL-3 | (M3) | 10.00 | (R1) | 0.10 | (S1) | 89.90 | | |
| Comparative UDL-4 | (M4) | 10.00 | (R1) | 0.10 | (S1) | 89.90 | | |
| Comparative UDL-5 | (M5) | 10.00 | (R1) | 0.10 | (S1) | 89.90 | | |
| Comparative UDL-6 | (M6) | 10.00 | (R1) | 0.10 | (S1) | 89.90 | | |
| Comparative UDL-7 | (M1) | 10.00 | (R2) | 0.10 | (S1) | 89.90 | | |
| Comparative UDL-8 | (M1) | 10.00 | (R3) | 0.10 | (S1) | 89.90 | | |
| Comparative UDL-9 | (M1) | 10.00 | (R4) | 0.10 | (S1) | 89.90 | | |
| Comparative UDL-10 | (M1) | 10.00 | (R5) | 0.10 | (S1) | 89.90 | | |
| Comparative UDL-11 | (M1) | 10.00 | (R6) | 0.10 | (S1) | 89.90 | | |
| Comparative UDL-12 | (M1) | 10.00 | (R7) | 0.10 | (S1) | 89.90 | | |
| Comparative UDL-13 | (M1) | 10.00 | (R8) | 0.10 | (S1) | 89.90 | | |
| Comparative UDL-14 | (M1) | 10.00 | | | (S1) | 90.00 | | |
| Comparative UDL-15 | (M2) | 10.00 | | | (S1) | 90.00 | | |
| Comparative UDL-16 | (M3) | 10.00 | | | (S1) | 90.00 | | |
| Comparative UDL-17 | (M4) | 10.00 | | | (S1) | 90.00 | | |
| Comparative UDL-18 | (M5) | 10.00 | | | (S1) | 90.00 | | |
| Comparative UDL-19 | (M6) | 10.00 | | | (S1) | 90.00 | | |

[Preparation of Silicon Wafers Having Organic Film Formed Thereon By Using Compositions (UDL-1 to -89 and Comparative UDL-1 to -19) for Forming Organic Film]

Using a coater/developer "CLEAN TRACK LITHIUS Pro AP" of Tokyo Electron Ltd., each of the compositions (UDL-1 to -89 and comparative UDL-1 to -19) for forming an organic film prepared above was respectively discharged in an amount of 2 ml onto a silicon wafer at the center. Then, the wafer was rotated at a rotational rate to achieve the average film thickness shown in Tables 4 to 6 to spread the composition, and then baking was performed at 350°C. Thus, a coating film of the composition for forming an organic film was formed. While rotating the silicon wafer at a rate of 1000 rpm, the remover-discharging nozzle was moved at a speed of 5 mm/s from the periphery of the silicon wafer to a position 3 mm from the center while discharging a remover (mixed solution of propylene glycol monomethyl ether acetate and propylene glycol monomethyl ether (30:70, mass ratio)) at a discharge rate of 2 ml/s, and the remover was further discharged at that position for 5 seconds at a discharge rate of 2 ml/s. After that, the discharging of the discharged liquid was terminated, and the silicon wafer was further rotated at a rate of 1000 rpm for 30 seconds. Next, the silicon wafer was heated at 350°C for 60 seconds. Thus, silicon wafers having an organic film (organic cured film) of each example formed were obtained.

### [Solvent Resistance Evaluation: Examples 1-1 to 1-89 and Comparative Examples 1-1 to 1-19]

An organic film was formed on a silicon wafer by the above-described method by using each of the compositions (UDL-1 to -89 and comparative UDL-1 to -19) for forming an organic film, and the film thickness of the organic film was measured. Subsequently, a PGMEA solvent was dispensed on each organic film, left to stand for 30 seconds, spin-dried, and baked at 100°C for 60 seconds to evaporate the PGMEA, and then the film thickness of the organic film was measured. The absolute value of the value determined by (X₁-X)/X × 100 was obtained as a film thickness change rate (%), where X is the film thickness before dispensing the PGMEA solvent, and X₁ is the film thickness after the PGMEA solvent was dispensed. When the film thickness change rate was lower than 0.5%, the composition was evaluated as "Good", and when 0.5% or higher, "Poor". Tables 4 to 6 below show the results.

### [In-Plane Uniformity Evaluation: Examples 1-1 to 1-89 and Comparative Examples 1-1 to 1-19]

An organic film was formed on a silicon wafer by the above-described method by using each of the compositions (UDL-1 to -89 and comparative UDL-1 to -19) for forming an organic film, and the film thickness within a radius of 145 mm from the center of the organic film was measured. The value determined by (Xₘₐₓ-Xₘᵢₙ)/X_{average} was obtained as in-plane uniformity (%), where Xₘₐₓ is the maximum value of the film thickness, Xₘᵢₙ is the minimum value of the film thickness, and X_{average} is the average film thickness. When the in-plane uniformity was less than 2%, the composition was evaluated as A (good), when 2% or more to less than 3%, B, and when 3% or more, C (poor). Tables 4 to 6 show the results.

**[Table 4]**

| | Composition for forming organic film | Average film thickness | Solvent resistance | In-plane uniformity |
|---|---|---|---|---|
| Example 1-1 | UDL-1 | 500 nm | Good | A |
| Example 1-2 | UDL-2 | 500 nm | Good | A |
| Example 1-3 | UDL-3 | 500 nm | Good | B |
| Example 1-4 | UDL-4 | 500 nm | Good | A |
| Example 1-5 | UDL-5 | 500 nm | Good | A |
| Example 1-6 | UDL-6 | 500 nm | Good | B |
| Example 1-7 | UDL-7 | 500 nm | Good | A |
| Example 1-8 | UDL-8 | 500 nm | Good | A |
| Example 1-9 | UDL-9 | 500 nm | Good | A |
| Example 1-10 | UDL-10 | 500 nm | Good | A |
| Example 1-11 | UDL-11 | 500 nm | Good | A |
| Example 1-12 | UDL-12 | 500 nm | Good | A |
| Example 1-13 | UDL-13 | 500 nm | Good | A |
| Example 1-14 | UDL-14 | 500 nm | Good | A |
| Example 1-15 | UDL-15 | 500 nm | Good | A |
| Example 1-16 | UDL-16 | 500 nm | Good | A |
| Example 1-17 | UDL-17 | 500 nm | Good | A |
| Example 1-18 | UDL-18 | 500 nm | Good | A |
| Example 1-19 | UDL-19 | 500 nm | Good | A |
| Example 1-20 | UDL-20 | 500 nm | Good | A |
| Example 1-21 | UDL-21 | 500 nm | Good | A |
| Example 1-22 | UDL-22 | 500 nm | Good | B |
| Example 1-23 | UDL-23 | 500 nm | Good | A |
| Example 1-24 | UDL-24 | 500 nm | Good | A |
| Example 1-25 | UDL-25 | 500 nm | Good | B |
| Example 1-26 | UDL-26 | 500 nm | Good | A |
| Example 1-27 | UDL-27 | 500 nm | Good | A |
| Example 1-28 | UDL-28 | 500 nm | Good | A |
| Example 1-29 | UDL-29 | 500 nm | Good | A |
| Example 1-30 | UDL-30 | 500 nm | Good | A |
| Example 1-31 | UDL-31 | 500 nm | Good | A |
| Example 1-32 | UDL-32 | 500 nm | Good | A |
| Example 1-33 | UDL-33 | 500 nm | Good | A |
| Example 1-34 | UDL-34 | 500 nm | Good | A |
| Example 1-35 | UDL-35 | 500 nm | Good | A |
| Example 1-36 | UDL-36 | 500 nm | Good | B |

**[Table 5]**

| | Composition for forming organic film | Average film thickness | Solvent resistance | In-plane uniformity |
|---|---|---|---|---|
| Example 1-37 | UDL-37 | 500 nm | Good | A |
| Example 1-38 | UDL-38 | 500 nm | Good | A |
| Example 1-39 | UDL-39 | 500 nm | Good | B |
| Example 1-40 | UDL-40 | 500 nm | Good | A |
| Example 1-41 | UDL-41 | 500 nm | Good | A |
| Example 1-42 | UDL-42 | 500 nm | Good | A |
| Example 1-43 | UDL-43 | 500 nm | Good | A |
| Example 1-44 | UDL-44 | 500 nm | Good | A |
| Example 1-45 | UDL-45 | 500 nm | Good | A |
| Example 1-46 | UDL-46 | 500 nm | Good | A |
| Example 1-47 | UDL-47 | 500 nm | Good | A |
| Example 1-48 | UDL-48 | 500 nm | Good | A |
| Example 1-49 | UDL-49 | 500 nm | Good | A |
| Example 1-50 | UDL-50 | 500 nm | Good | B |
| Example 1-51 | UDL-51 | 500 nm | Good | A |
| Example 1-52 | UDL-52 | 500 nm | Good | A |
| Example 1-53 | UDL-53 | 500 nm | Good | B |
| Example 1-54 | UDL-54 | 500 nm | Good | A |
| Example 1-55 | UDL-55 | 500 nm | Good | A |
| Example 1-56 | UDL-56 | 500 nm | Good | A |
| Example 1-57 | UDL-57 | 500 nm | Good | A |
| Example 1-58 | UDL-58 | 500 nm | Good | A |
| Example 1-59 | UDL-59 | 500 nm | Good | A |
| Example 1-60 | UDL-60 | 500 nm | Good | A |
| Example 1-61 | UDL-61 | 500 nm | Good | A |
| Example 1-62 | UDL-62 | 500 nm | Good | A |
| Example 1-63 | UDL-63 | 500 nm | Good | A |
| Example 1-64 | UDL-64 | 500 nm | Good | B |
| Example 1-65 | UDL-65 | 500 nm | Good | A |
| Example 1-66 | UDL-66 | 500 nm | Good | A |
| Example 1-67 | UDL-67 | 500 nm | Good | B |
| Example 1-68 | UDL-68 | 500 nm | Good | A |
| Example 1-69 | UDL-69 | 500 nm | Good | A |
| Example 1-70 | UDL-70 | 500 nm | Good | A |
| Example 1-71 | UDL-71 | 500 nm | Good | A |
| Example 1-72 | UDL-72 | 500 nm | Good | A |

**[Table 6]**

| | Composition for forming organic film | Average film thickness | Solvent resistance | In-plane uniformity |
|---|---|---|---|---|
| Example 1-73 | UDL-73 | 500 nm | Good | A |
| Example 1-74 | UDL-74 | 500 nm | Good | A |
| Example 1-75 | UDL-75 | 500 nm | Good | A |
| Example 1-76 | UDL-76 | 500 nm | Good | A |
| Example 1-77 | UDL-77 | 500 nm | Good | A |
| Example 1-78 | UDL-78 | 500 nm | Good | B |
| Example 1-79 | UDL-79 | 500 nm | Good | A |
| Example 1-80 | UDL-80 | 500 nm | Good | A |
| Example 1-81 | UDL-81 | 500 nm | Good | B |
| Example 1-82 | UDL-82 | 500 nm | Good | A |
| Example 1-83 | UDL-83 | 500 nm | Good | A |
| Example 1-84 | UDL-84 | 500 nm | Good | A |
| Example 1-85 | UDL-85 | 500 nm | Good | A |
| Example 1-86 | UDL-86 | 500 nm | Good | A |
| Example 1-87 | UDL-87 | 500 nm | Good | A |
| Example 1-88 | UDL-88 | 500 nm | Good | A |
| Example 1-89 | UDL-89 | 500 nm | Good | A |
| Comparative Example 1-1 | Comparative UDL-1 | 500 nm | Good | A |
| Comparative Example 1-2 | Comparative UDL-2 | 500 nm | Good | A |
| Comparative Example 1-3 | Comparative UDL-3 | 500 nm | Good | A |
| Comparative Example 1-4 | Comparative UDL-4 | 500 nm | Good | A |
| Comparative Example 1-5 | Comparative UDL-5 | 500 nm | Good | A |
| Comparative Example 1-6 | Comparative UDL-6 | 500 nm | Good | A |
| Comparative Example 1-7 | Comparative UDL-7 | 500 nm | Good | A |
| Comparative Example 1-8 | Comparative UDL-8 | 500 nm | Good | A |
| Comparative Example 1-9 | Comparative UDL-9 | 500 nm | Good | A |
| Comparative Example 1-10 | Comparative UDL-10 | 500 nm | Good | A |
| Comparative Example 1-11 | Comparative UDL-11 | 500 nm | Good | C |
| Comparative Example 1-12 | Comparative UDL-12 | 500 nm | Good | C |
| Comparative Example 1-13 | Comparative UDL-13 | 500 nm | Good | C |
| Comparative Example 1-14 | Comparative UDL-14 | 500 nm | Good | C |
| Comparative Example 1-15 | Comparative UDL-15 | 500 nm | Good | C |
| Comparative Example 1-16 | Comparative UDL-16 | 500 nm | Good | C |
| Comparative Example 1-17 | Comparative UDL-17 | 500 nm | Good | C |
| Comparative Example 1-18 | Comparative UDL-18 | 500 nm | Good | C |
| Comparative Example 1-19 | Comparative UDL-19 | 500 nm | Good | C |

As shown in Tables 4 to 6, in Examples 1-1 to 1-89, where the inventive compositions for forming an organic film were used, organic films excellent in both solvent resistance and in-plane uniformity were obtained, but in Comparative Examples 1-11 to 1-19 out of Comparative Examples 1-1 to 1-19, where compositions not containing an aryl benzyl ether compound, contained in the inventive compositions for forming an organic film, were used, in-plane uniformity was poor. Therefore, in the following evaluations, UDL-1 to -89 and comparative UDL-1 to -10, which were excellent in both solvent resistance and in-plane uniformity, were considered.

### [Hump Suppression Property Evaluation: Examples 2-1 to 2-89 and Comparative Examples 2-1 to 2-10]

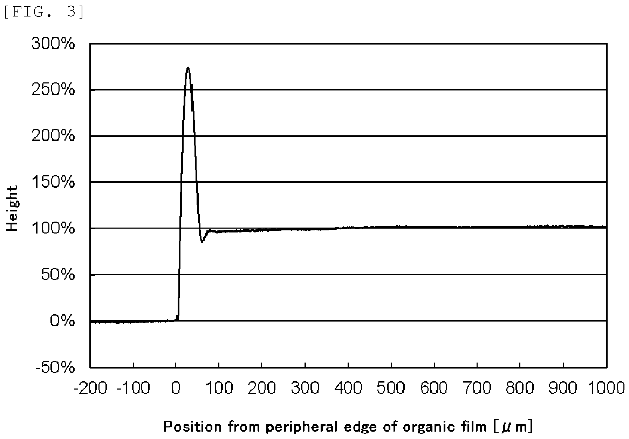

An organic film was formed on a silicon wafer by the above-described method by using each of the compositions (UDL-1 to -89 and comparative UDL-1 to -10) for forming an organic film, and the variation in height from the peripheral edge of the organic film towards the center of the silicon wafer to a position of 1000 um was measured by using Alpha-Step D-600 (a stylus profiler) manufactured by KLA corporation. The height of the silicon wafer was regarded as 0, and when the maximum height was less than 110% of the film thickness as shown in FIG. 2, the composition was evaluated as A (good), when the maximum height was 110% or more to less than 150%, B, and when a region where the height was 150% or more occurred as shown in FIG. 3, C (poor). Tables 7 to 9 show the results.

### [Filling Property Evaluation: Examples 2-1 to 2-89 and Comparative Examples 2-1 to 2-10]

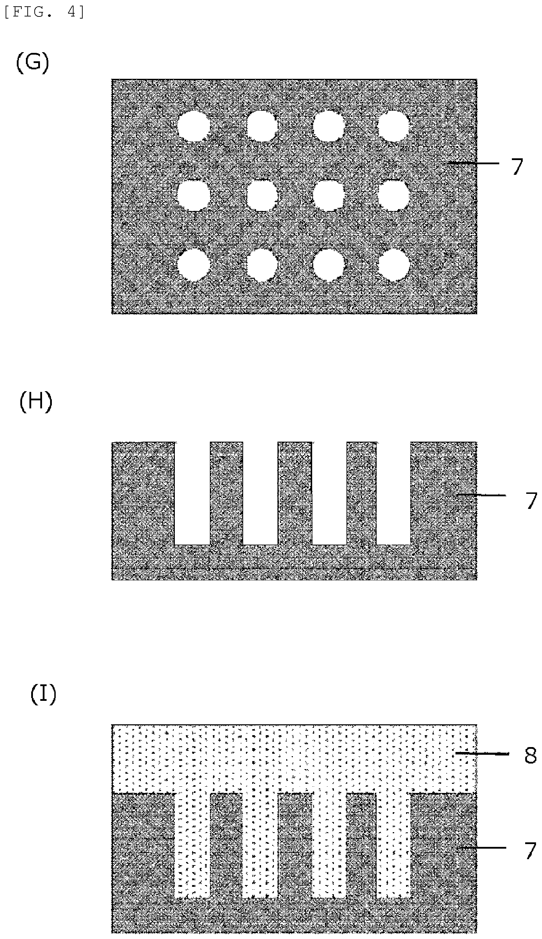

As shown in FIG. 4, a film was formed on an SiO₂ wafer substrate having a dense hole pattern (hole diameter 0.2 um, hole depth 1.0 um, distance between the centers of two adjacent holes 0.4 µm) by using each of the compositions (UDL-1 to -89 and comparative UDL-1 to -10) for forming an organic film respectively according to the above-described method to form an organic film 8. The substrate used was a base substrate (SiO₂ wafer substrate) 7 having the dense hole pattern shown in FIG. 4 (G) (downward view) and (H) (cross-sectional view). The cross-sectional shape of each of the obtained wafer substrates was observed using a scanning electron microscope (SEM), and it was observed whether or not the inside of the holes was filled with the organic film without gaps. When a composition for forming an organic film having poor filling property is used, gaps are generated inside the holes. When a composition for forming an organic film having a desirable filling property is used in the present evaluation, the inside of the holes is filled with the organic film without gaps, as shown in FIG. 4 (I). The composition was evaluated as "Good" when no gaps were generated, and when gaps were generated, as "Poor". Tables 7 to 9 show the results.

### [Silicon-Containing Resist Middle Layer Film Coating Property Evaluation: Examples 2-1 to 2-89 and Comparative Examples 2-1 to 2-10]

An organic film was formed respectively on a silicon wafer substrate by using each of the compositions (UDL-1 to -89 and comparative UDL-1 to -10) for forming an organic film by the above-described method, the silicon-containing resist middle layer film material (SOG1) described below was applied thereto, and baking was performed at 200°C for 60 seconds to form a silicon-containing resist middle layer film. Then, the condition of the coating film of the silicon-containing resist middle layer film was visually observed and evaluated.

When the condition of the coating film of the silicon-containing resist middle layer film was good, the composition was evaluated as "Good", and when dewetting had occurred, as "Poor".

Note that, in this evaluation, to evaluate whether the coatability of the silicon-containing resist middle layer film is excellent or not, the thickness of the silicon-containing resist middle layer film was set to 10 nm, and this is a severe evaluation condition. Tables 7 to 9 show the results.

As the silicon-containing resist middle layer film material (SOG1), a solution of the following polymer in propylene glycol ethyl ether was prepared. The polymer solution used in the silicon-containing resist middle layer film coating property evaluation was 0.5 mass%.

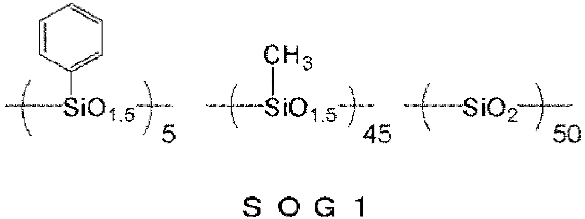

### [Contact Angle Evaluation: Examples 2-1 to 2-89 and Comparative Examples 2-1 to 2-10]

An organic film was formed respectively on a silicon wafer substrate by using each of the compositions (UDL-1 to -89 and comparative UDL-1 to -10) for forming an organic film according to the above-described method, and the contact angle with pure water was measured. Tables 7 to 9 show the results.

**[Table 7]**

| | Composition for forming organic film | Hump suppression property evaluation | Filling property evaluation | Silicon-containing resist middle layer film coating property evaluation | Contact angle evaluation |
|---|---|---|---|---|---|
| Example 2-1 | UDL-1 | A | Good | Good | 57° |
| Example 2-2 | UDL-2 | A | Good | Good | 55° |
| Example 2-3 | UDL-3 | A | Good | Good | 65° |
| Example 2-4 | UDL-4 | A | Good | Good | 66° |
| Example 2-5 | UDL-5 | A | Good | Good | 61° |
| Example 2-6 | UDL-6 | A | Good | Good | 61° |
| Example 2-7 | UDL-7 | A | Good | Good | 63° |
| Example 2-8 | UDL-8 | A | Good | Good | 66° |
| Example 2-9 | UDL-9 | A | Good | Good | 64° |
| Example 2-10 | UDL-10 | A | Good | Good | 63° |
| Example 2-11 | UDL-11 | A | Good | Good | 61° |
| Example 2-12 | UDL-12 | A | Good | Good | 59° |
| Example 2-13 | UDL-13 | A | Good | Good | 58° |
| Example 2-14 | UDL-14 | A | Good | Good | 56° |
| Example 2-15 | UDL-15 | A | Good | Good | 57° |
| Example 2-16 | UDL-16 | A | Good | Good | 55° |
| Example 2-17 | UDL-17 | A | Good | Good | 66° |
| Example 2-18 | UDL-18 | A | Good | Good | 66° |
| Example 2-19 | UDL-19 | A | Good | Good | 60° |
| Example 2-20 | UDL-20 | A | Good | Good | 57° |
| Example 2-21 | UDL-21 | A | Good | Good | 55° |
| Example 2-22 | UDL-22 | A | Good | Good | 65° |
| Example 2-23 | UDL-23 | A | Good | Good | 66° |
| Example 2-24 | UDL-24 | A | Good | Good | 61° |
| Example 2-25 | UDL-25 | A | Good | Good | 61° |
| Example 2-26 | UDL-26 | A | Good | Good | 63° |
| Example 2-27 | UDL-27 | A | Good | Good | 66° |
| Example 2-28 | UDL-28 | A | Good | Good | 64° |
| Example 2-29 | UDL-29 | A | Good | Good | 63° |
| Example 2-30 | UDL-30 | A | Good | Good | 61° |
| Example 2-31 | UDL-31 | A | Good | Good | 59° |
| Example 2-32 | UDL-32 | A | Good | Good | 58° |
| Example 2-33 | UDL-33 | A | Good | Good | 56° |
| Example 2-34 | UDL-34 | A | Good | Good | 57° |
| Example 2-35 | UDL-35 | A | Good | Good | 55° |
| Example 2-36 | UDL-36 | A | Good | Good | 65° |

**[Table 8]**

| | Composition for forming organic film | Hump suppression property evaluation | Filling property evaluation | Silicon-containing resist middle layer film coating property evaluation | Contact angle evaluation |
|---|---|---|---|---|---|
| Example 2-37 | UDL-37 | A | Good | Good | 66° |
| Example 2-38 | UDL-38 | A | Good | Good | 61° |
| Example 2-39 | UDL-39 | A | Good | Good | 61° |
| Example 2-40 | UDL-40 | A | Good | Good | 63° |
| Example 2-41 | UDL-41 | A | Good | Good | 66° |
| Example 2-42 | UDL-42 | A | Good | Good | 64° |
| Example 2-43 | UDL-43 | A | Good | Good | 63° |
| Example 2-44 | UDL-44 | A | Good | Good | 61° |
| Example 2-45 | UDL-45 | A | Good | Good | 59° |
| Example 2-46 | UDL-46 | A | Good | Good | 58° |
| Example 2-47 | UDL-47 | A | Good | Good | 56° |
| Example 2-48 | UDL-48 | A | Good | Good | 57° |
| Example 2-49 | UDL-49 | A | Good | Good | 55° |
| Example 2-50 | UDL-50 | A | Good | Good | 65° |
| Example 2-51 | UDL-51 | A | Good | Good | 66° |
| Example 2-52 | UDL-52 | A | Good | Good | 61° |
| Example 2-53 | UDL-53 | A | Good | Good | 61° |
| Example 2-54 | UDL-54 | A | Good | Good | 63° |
| Example 2-55 | UDL-55 | A | Good | Good | 66° |
| Example 2-56 | UDL-56 | A | Good | Good | 64° |
| Example 2-57 | UDL-57 | A | Good | Good | 63° |
| Example 2-58 | UDL-58 | A | Good | Good | 61° |
| Example 2-59 | UDL-59 | A | Good | Good | 59° |
| Example 2-60 | UDL-60 | A | Good | Good | 58° |
| Example 2-61 | UDL-61 | A | Good | Good | 56° |
| Example 2-62 | UDL-62 | A | Good | Good | 57° |
| Example 2-63 | UDL-63 | A | Good | Good | 55° |
| Example 2-64 | UDL-64 | A | Good | Good | 65° |
| Example 2-65 | UDL-65 | A | Good | Good | 66° |
| Example 2-66 | UDL-66 | A | Good | Good | 61° |
| Example 2-67 | UDL-67 | A | Good | Good | 61° |
| Example 2-68 | UDL-68 | A | Good | Good | 63° |
| Example 2-69 | UDL-69 | A | Good | Good | 66° |
| Example 2-70 | UDL-70 | A | Good | Good | 64° |
| Example 2-71 | UDL-71 | A | Good | Good | 63° |
| Example 2-72 | UDL-72 | A | Good | Good | 61° |

**[Table 9]**

| | Composition for forming organic film | Hump suppression property evaluation | Filling property evaluation | Silicon-containing resist middle layer film coating property evaluation | Contact angle evaluation |
|---|---|---|---|---|---|
| Example 2-73 | UDL-73 | A | Good | Good | 59° |
| Example 2-74 | UDL-72 | A | Good | Good | 58° |
| Example 2-75 | UDL-72 | A | Good | Good | 56° |
| Example 2-76 | UDL-72 | A | Good | Good | 57° |
| Example 2-77 | UDL-72 | A | Good | Good | 55° |
| Example 2-78 | UDL-72 | A | Good | Good | 65° |
| Example 2-79 | UDL-72 | A | Good | Good | 66° |
| Example 2-80 | UDL-72 | A | Good | Good | 61° |
| Example 2-81 | UDL-72 | A | Good | Good | 61° |
| Example 2-82 | UDL-72 | A | Good | Good | 63° |
| Example 2-83 | UDL-72 | A | Good | Good | 66° |
| Example 2-84 | UDL-72 | A | Good | Good | 64° |
| Example 2-85 | UDL-72 | A | Good | Good | 63° |
| Example 2-86 | UDL-72 | A | Good | Good | 61° |
| Example 2-87 | UDL-72 | A | Good | Good | 59° |
| Example 2-88 | UDL-72 | A | Good | Good | 58° |
| Example 2-89 | UDL-72 | A | Good | Good | 56° |
| Comparative Example 2-1 | Comparative UDL-1 | C | Poor | Good | 75° |
| Comparative Example 2-2 | Comparative UDL-2 | C | Poor | Good | 75° |
| Comparative Example 2-3 | Comparative UDL-3 | C | Poor | Good | 75° |
| Comparative Example 2-4 | Comparative UDL-4 | C | Poor | Good | 75° |
| Comparative Example 2-5 | Comparative UDL-5 | C | Poor | Good | 75° |
| Comparative Example 2-6 | Comparative UDL-6 | C | Poor | Good | 75° |
| Comparative Example 2-7 | Comparative UDL-7 | C | Poor | Poor | 90° |
| Comparative Example 2-8 | Comparative UDL-8 | C | Poor | Poor | 93° |
| Comparative Example 2-9 | Comparative UDL-9 | C | Poor | Poor | 95° |
| Comparative Example 2-10 | Comparative UDL-10 | A | Poor | Good | 74° |

As shown in Tables 7 to 9, it was confirmed that the compositions (UDL-1 to -89) for forming an organic film, which are Examples of the present invention, were excellent in solvent resistance, in-plane uniformity, hump suppression property, filling property, and the coating property of the silicon-containing resist middle layer film. In addition, the contact angle was between 55 and 66 degrees.

### [Patterning Test: Examples 3-1 to 3-89]

An organic film was formed respectively on an SiO₂ wafer substrate by using each of the compositions (UDL-1 to -89) for forming an organic film according to the above-described method (baking at 350°C), the silicon-containing resist middle layer film material (SOG1) described below was applied thereto, and baking was performed at 200°C for 60 seconds to form a 35-nm thick silicon-containing resist middle layer film. The monolayer resist for ArF described below was applied thereto as a resist upper layer film material and baked at 105°C for 60 seconds to form a 100-nm thick photoresist film. The liquid immersion top coat composition (TC-1) described below was applied to the photoresist film and baked at 90°C for 60 seconds to form a 50-nm thick top coat.

As the silicon-containing resist middle layer film material (SOG1), a 2% solution of the following polymer in propylene glycol ethyl ether was prepared.

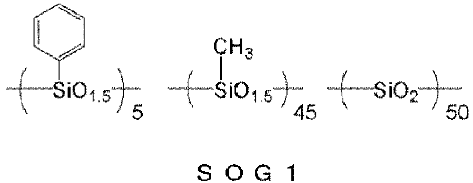

The resist upper layer film material (monolayer resist for ArF) was prepared by dissolving a polymer (RP1), an acid generator (PAG1), and a basic compound (Amine1), each in the proportion shown in Table 10, in a solvent (PGMEA) containing 0.1% by mass of FC-430 (manufactured by Sumitomo 3M Limited), and filtering the solution through a 0.1-pm filter made of a fluororesin.

**[Table 10]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine1) are shown below.

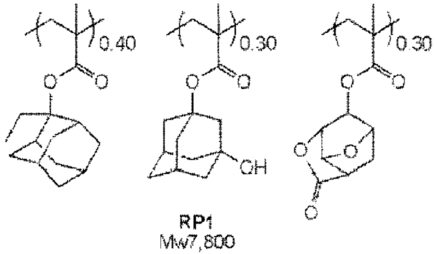

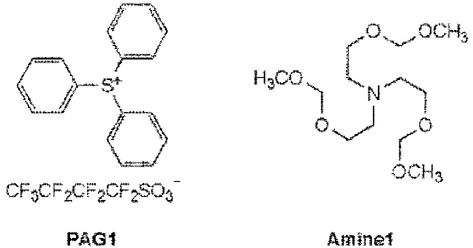

The liquid immersion top coat composition (TC-1) was prepared by dissolving a polymer (PP1) in an organic solvent at the proportion shown in Table 11, and filtering the solution through a 0.1-pm filter made of a fluororesin.

**[Table 11]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) is shown below.

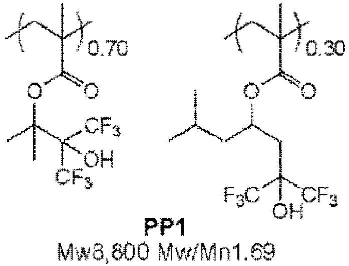

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, using an etching apparatus Telius manufactured by Tokyo Electron Ltd., the silicon-containing resist middle layer film was dry-etched (the pattern was transferred) while using the resist upper layer film pattern as a mask to obtain a silicon-containing resist middle layer film pattern; the organic film was dry-etched (the pattern was transferred) while using the obtained silicon-containing resist middle layer film pattern as a mask to obtain an organic film pattern; and the SiO₂ wafer substrate (SiO₂ film) was dry-etched (the pattern was transferred) while using the obtained organic film pattern as a mask. The etching conditions were as follows.

### Conditions in transferring resist upper layer film pattern to silicon-containing resist middle layer film

Chamber pressure: 10.0 Pa
RF-power: 1,500 W
CF₄ gas flow rate: 75 mL/min
O₂ gas flow rate: 15 mL/min
Time: 15 sec

### Conditions in transferring silicon-containing resist middle layer film pattern to organic film

Chamber pressure: 2.0 Pa
RF-power: 500 W
Ar gas flow rate: 75 mL/min
O₂ gas flow rate: 45 mL/min
Time: 120 sec

### Conditions in transferring organic film pattern to SiO₂ wafer substrate

Chamber pressure: 2.0 Pa
RF-power: 2,200 W
C₅F₁₂ gas flow rate: 20 mL/min
C₂F₆ gas flow rate: 10 mL/min
Ar gas flow rate: 300 mL/min
O₂ gas flow rate: 60 mL/min
Time: 90 sec

The cross section of the obtained pattern was observed with an electron microscope (S-4700) manufactured by Hitachi, Ltd. Tables 12 to 14 show the results.

**[Table 12]**

| | Composition for forming organic film | Profile after etching for transferring to substrate |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |
| Example 3-31 | UDL-31 | Good |
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |

**[Table 13]**

| | Composition for forming organic film | Profile after etching for transferring to substrate |
|---|---|---|
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |
| Example 3-43 | UDL-43 | Good |
| Example 3-44 | UDL-44 | Good |
| Example 3-45 | UDL-45 | Good |
| Example 3-46 | UDL-46 | Good |
| Example 3-47 | UDL-47 | Good |
| Example 3-48 | UDL-48 | Good |
| Example 3-49 | UDL-49 | Good |
| Example 3-50 | UDL-50 | Good |
| Example 3-51 | UDL-51 | Good |
| Example 3-52 | UDL-52 | Good |
| Example 3-53 | UDL-53 | Good |
| Example 3-54 | UDL-54 | Good |
| Example 3-55 | UDL-55 | Good |
| Example 3-56 | UDL-56 | Good |
| Example 3-57 | UDL-57 | Good |
| Example 3-58 | UDL-58 | Good |
| Example 3-59 | UDL-59 | Good |
| Example 3-60 | UDL-60 | Good |
| Example 3-61 | UDL-61 | Good |
| Example 3-62 | UDL-62 | Good |
| Example 3-63 | UDL-63 | Good |
| Example 3-64 | UDL-64 | Good |
| Example 3-65 | UDL-65 | Good |
| Example 3-66 | UDL-66 | Good |
| Example 3-67 | UDL-67 | Good |
| Example 3-68 | UDL-68 | Good |
| Example 3-69 | UDL-69 | Good |
| Example 3-70 | UDL-70 | Good |
| Example 3-71 | UDL-71 | Good |
| Example 3-72 | UDL-72 | Good |

**[Table 14]**

| | Composition for forming organic film | Profile after etching for transferring to substrate |
|---|---|---|
| Example 3-73 | UDL-73 | Good |
| Example 3-74 | UDL-74 | Good |
| Example 3-75 | UDL-75 | Good |
| Example 3-76 | UDL-76 | Good |
| Example 3-77 | UDL-77 | Good |
| Example 3-78 | UDL-78 | Good |
| Example 3-79 | UDL-79 | Good |
| Example 3-80 | UDL-80 | Good |
| Example 3-81 | UDL-81 | Good |
| Example 3-82 | UDL-82 | Good |
| Example 3-83 | UDL-83 | Good |
| Example 3-84 | UDL-84 | Good |
| Example 3-85 | UDL-85 | Good |
| Example 3-86 | UDL-86 | Good |
| Example 3-87 | UDL-87 | Good |
| Example 3-88 | UDL-88 | Good |
| Example 3-89 | UDL-89 | Good |

As shown in Tables 12 to 14, in Examples 3-1 to 3-89, where the compositions (UDL-1 to -89) for forming an organic film, being examples of the present invention, were used, the resist upper layer film pattern was successfully transferred to the SiO₂ wafer substrate in the end in every case. Thus, it was confirmed that the compositions for forming an organic film of the Examples of the present invention can be used suitably for fine processing using a multilayer resist method.

From the above, it can be observed that the inventive composition for forming an organic film has excellent film-formability, high filling property, excellent hump suppression property, and excellent coating property of middle layer films, such as silicon-containing resist middle layer films, and therefore, is extremely useful as an organic film material used in a multilayer resist process. Furthermore, from the above, it can be observed that the inventive patterning processes, using the inventive composition for forming an organic film, make it possible to fill holes and trenches having very high aspect ratios without gaps, form a fine pattern with high precision, and form a hump-suppressed organic film, and therefore, make it possible to manufacture semiconductor devices and the like efficiently.

The present description includes the following embodiments.
[1] A composition for forming an organic film, comprising:
   (A) a material for forming an organic film;
   (B) an aryl benzyl ether compound containing a partial structure represented by the following general formula (B1) and not containing a partial structure represented by the following general formula (B0); and
   (C) a solvent, 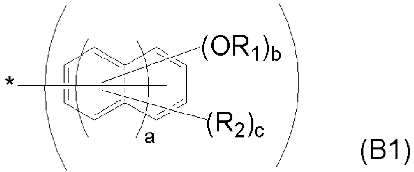 wherein R₁ represents either of groups containing fluorine represented by the following formulae (B2), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 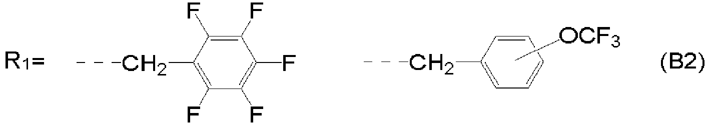 wherein a broken line represents an attachment point to the oxygen atom in the formula (B1), and one of the structures represented by the formulae (B2) is contained or two of the structures is contained, 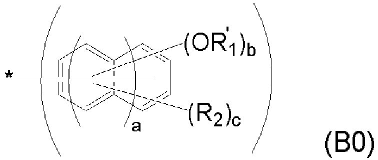 wherein R'₁ represents a hydrogen atom or a group represented by the following formula (B0-1), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 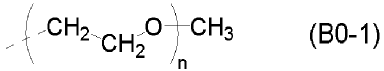 wherein a broken line represents an attachment point to the oxygen atom in the formula (B0), and "n" represents 1 to 6.
[2] The composition for forming an organic film of [1], wherein the aryl benzyl ether compound (B) is a compound represented by the following general formula (B3), (B4), (B6), (B8), (B10), or (B11), 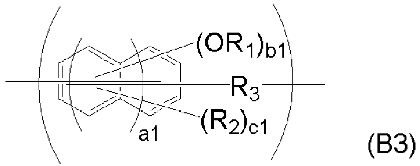 wherein R₁ represents one or two of the groups containing fluorine represented by the formulae (B2); R₂ represents a saturated or unsaturated monovalent organic group having 1 to 30 carbon atoms; R₂ represents a saturated or unsaturated divalent organic group having 1 to 30 carbon atoms; "a1" represents 0 or 1, provided that when "a1" is 0, "b1" represents 1 to 5 and "c1" represents 0 to 4, and when "a1" is 1, "b1" represents 1 to 7 and "c1" represents 0 to 6, 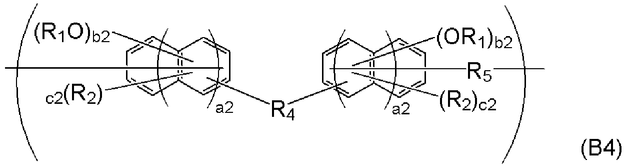 wherein R₁ represents one or two of the groups containing fluorine represented by the formulae (B2); R₂ represents a saturated or unsaturated monovalent organic group having 1 to 30 carbon atoms; R₄ represents a single bond or any of groups represented by the following formulae (B5); R₅ represents a saturated or unsaturated divalent organic group having 1 to 30 carbon atoms; and "a2" represents 0 or 1, provided that when "a2" is 0, "b2" represents 1 to 5 and "c2" represents 0 to 4, and when "a2" is 1, "b2" represents 1 to 7 and "c2" represents 0 to 6, 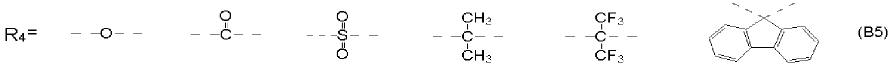 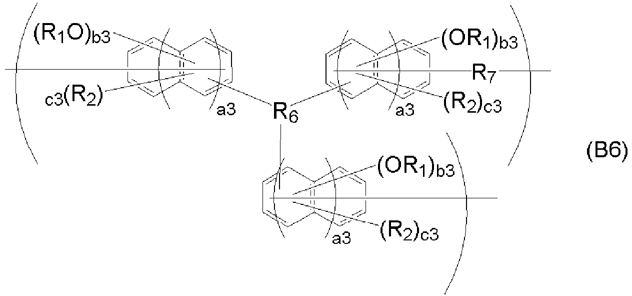 wherein R₁ represents one or two of the groups containing fluorine represented by the formulae (B2); R₂ represents a saturated or unsaturated monovalent organic group having 1 to 30 carbon atoms; R₆ represents a group represented by any of the following formulae (B7); R₇ represents a saturated or unsaturated divalent organic group having 1 to 30 carbon atoms; and "a3" represents 0 or 1, provided that when "a3" is 0, "b3" represents 1 to 5 and "c3" represents 0 to 4, and when "a3" is 1, "b3" represents 1 to 7 and "c3" represents 0 to 6, 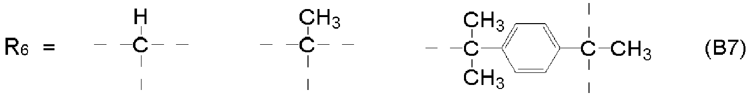 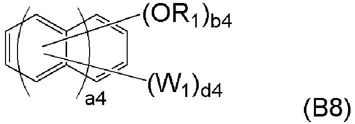 wherein R₁ represents one or two of the groups containing fluorine represented by the formulae (B2); W₁ represents a group represented by the following formula (B9); "a4" represents 0 or 1; "b4" represents 1 or 2; and "d4" represents 1 to 4, 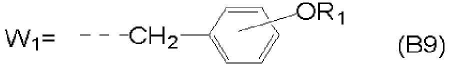 wherein R₁ represents either of the groups containing fluorine represented by the formulae (B2), 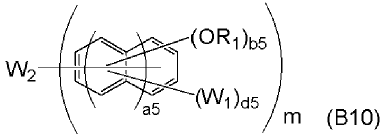 wherein R₁ represents one or two of the groups containing fluorine represented by the formulae (B2); W₁ represents a group represented by the formula (B9); W₂ represents a single bond or an organic group having 1 to 50 carbon atoms; "m" represents an integer satisfying 1 ≤ m ≤ 5; "a5" represents 0 or 1; "b5" represents 1 or 2; and "d5" represents 1 to 4, 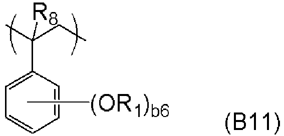 wherein R₁ represents one or two of the groups containing fluorine represented by the formulae (B2); R₈ represents a hydrogen atom or a methyl group; and "b6" represents 1 to 5.
[3] The composition for forming an organic film of [1] or [2], wherein the aryl benzyl ether compound (B) has a weight-average molecular weight of 1000 to 30000.
[4] The composition for forming an organic film of any one of [1] to [3], wherein the aryl benzyl ether compound (B) is contained in an amount of 0.01 parts by mass to 5 parts by mass based on 100 parts by mass of the material (A) for forming an organic film.
[5] A method for forming an organic film to be used in a manufacturing process of a semiconductor device, the method comprising:
   spin-coating a substrate to be processed with the composition for forming an organic film of any one of [1] to [4] to obtain a coating film; and
   forming an organic film by heating the coating film at a temperature of 100°C or higher and 600°C or lower for 10 to 600 seconds to cure the coating film.
[6] A patterning process comprising:
   forming an organic film on a body to be processed by using the composition for forming an organic film of any one of [1] to [4];
   forming a silicon-containing resist middle layer film on the organic film by using a silicon-containing resist middle layer film material;
   forming a resist upper layer film on the silicon-containing resist middle layer film by using a resist upper layer film material comprising a photoresist composition;
   forming a circuit pattern in the resist upper layer film;
   transferring the pattern to the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further forming the pattern in the body to be processed by etching while using the organic film having the transferred pattern as a mask.
[7] A patterning process comprising:
   forming an organic film on a body to be processed by using the composition for forming an organic film of any one of [1] to [4];
   forming a silicon-containing resist middle layer film on the organic film by using a silicon-containing resist middle layer film material;
   forming an organic antireflective film or an adhesive film on the silicon-containing resist middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further forming the pattern in the body to be processed by etching while using the organic film having the transferred pattern as a mask.
[8] A patterning process comprising:
   forming an organic film on a body to be processed by using the composition for forming an organic film of any one of [1] to [4];
   forming an inorganic hard mask selected from the group consisting of a silicon oxide film, a silicon nitride film, and a silicon oxynitride film on the organic film;
   forming a resist upper layer film on the inorganic hard mask by using a resist upper layer film material comprising a photoresist composition;
   forming a circuit pattern in the resist upper layer film;
   transferring the pattern to the inorganic hard mask by etching while using the resist upper layer film having the formed circuit pattern as a mask;
   transferring the pattern to the organic film by etching while using the inorganic hard mask having the transferred pattern as a mask; and
   further forming the pattern in the body to be processed by etching while using the organic film having the transferred pattern as a mask.
[9] A patterning process comprising:
   forming an organic film on a body to be processed by using the composition for forming an organic film of any one of [1] to [4] ;
   forming an inorganic hard mask selected from the group consisting of a silicon oxide film, a silicon nitride film, and a silicon oxynitride film on the organic film;
   forming an organic antireflective film or an adhesive film on the inorganic hard mask;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and to the inorganic hard mask by etching while using the resist upper layer film having the formed circuit pattern as a mask;
   transferring the pattern to the organic film by etching while using the inorganic hard mask having the transferred pattern as a mask; and
   further forming the pattern in the body to be processed by etching while using the organic film having the transferred pattern as a mask.
[10] The patterning process of [8] or [9], wherein the inorganic hard mask is formed by a CVD method or an ALD method.
[11] The patterning process of any one of [6] to [10], wherein the circuit pattern is formed by a lithography using light having a wavelength of 10 nm or more and 300 nm or less, a direct writing with electron beam, nanoimprinting, or a combination thereof.
[12] The patterning process of any one of [6] to [11], wherein the circuit pattern is developed with an alkaline development or an organic solvent.
[13] The patterning process of any one of [6] to [12], wherein the body to be processed is a semiconductor device substrate or the semiconductor device substrate coated with any of a metal film, a metal carbide film, a metal oxide film, a metal nitride film, a metal oxycarbide film, and a metal oxynitride film.
[14] The patterning process of [13], wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming an organic film, comprising:
(A) a material for forming an organic film;
(B) an aryl benzyl ether compound containing a partial structure represented by the following general formula (B1) and not containing a partial structure represented by the following general formula (B0); and
(C) a solvent, 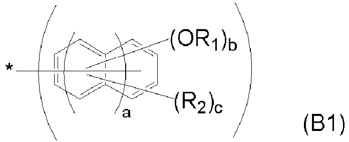 wherein R₁ represents either of groups containing fluorine represented by the following formulae (B2), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 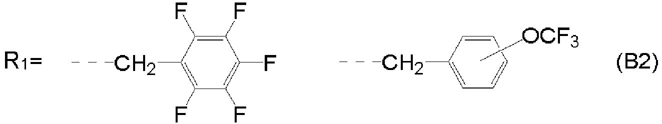 wherein a broken line represents an attachment point to the oxygen atom in the formula (B1), and one of the structures represented by the formulae (B2) is contained or two of the structures is contained, 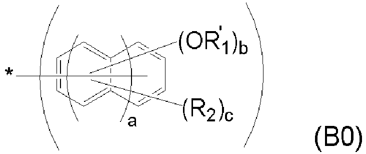 wherein R'₁ represents a hydrogen atom or a group represented by the following formula (B0-1), R₂ represents a saturated or unsaturated monovalent organic group having 1 to 30 carbon atoms, "a" represents 0 or 1, provided that when "a" is 0, "b" represents 1 to 5 and "c" represents 0 to 4, and when "a" is 1, "b" represents 1 to 7 and "c" represents 0 to 6, and "*" represents an attachment point to another atom, 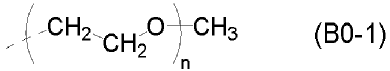 wherein a broken line represents an attachment point to the oxygen atom in the formula (B0), and "n" represents 1 to 6.

2. The composition for forming an organic film according to claim 1, wherein the aryl benzyl ether compound (B) is a compound represented by the following general formula (B3), (B4), (B6), (B8), (B10), or (B11), 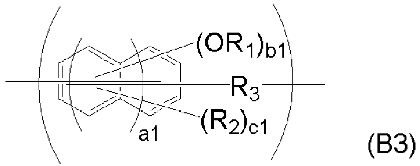 wherein R₁ represents one or two of the groups containing fluorine represented by the formulae (B2); R₂ represents a saturated or unsaturated monovalent organic group having 1 to 30 carbon atoms; R₃ represents a saturated or unsaturated divalent organic group having 1 to 30 carbon atoms; "a1" represents 0 or 1, provided that when "a1" is 0, "b1" represents 1 to 5 and "c1" represents 0 to 4, and when "a1" is 1, "b1" represents 1 to 7 and "c1" represents 0 to 6, 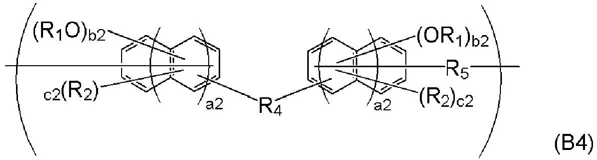 wherein R₁ represents one or two of the groups containing fluorine represented by the formulae (B2); R₂ represents a saturated or unsaturated monovalent organic group having 1 to 30 carbon atoms; R₄ represents a single bond or any of groups represented by the following formulae (B5); R₅ represents a saturated or unsaturated divalent organic group having 1 to 30 carbon atoms; and "a2" represents 0 or 1, provided that when "a2" is 0, "b2" represents 1 to 5 and "c2" represents 0 to 4, and when "a2" is 1, "b2" represents 1 to 7 and "c2" represents 0 to 6, 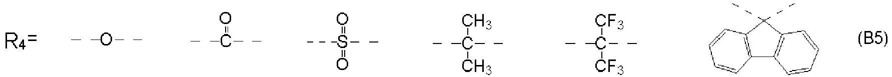 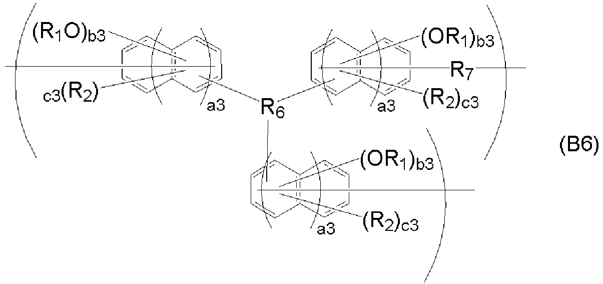 wherein R₁ represents one or two of the groups containing fluorine represented by the formulae (B2); R₂ represents a saturated or unsaturated monovalent organic group having 1 to 30 carbon atoms; R₆ represents a group represented by any of the following formulae (B7); R₇ represents a saturated or unsaturated divalent organic group having 1 to 30 carbon atoms; and "a3" represents 0 or 1, provided that when "a3" is 0, "b3" represents 1 to 5 and "c3" represents 0 to 4, and when "a3" is 1, "b3" represents 1 to 7 and "c3" represents 0 to 6, 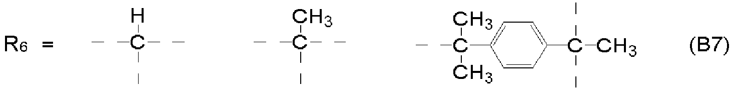 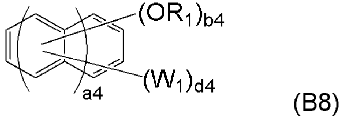 wherein R₁ represents one or two of the groups containing fluorine represented by the formulae (B2); W₁ represents a group represented by the following formula (B9); "a4" represents 0 or 1; "b4" represents 1 or 2; and "d4" represents 1 to 4, 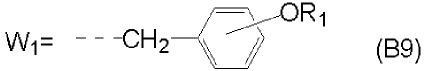 wherein R₁ represents either of the groups containing fluorine represented by the formulae (B2), 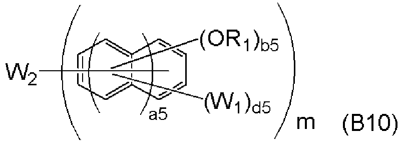 wherein R₁ represents one or two of the groups containing fluorine represented by the formulae (B2); W₁ represents a group represented by the formula (B9); W₂ represents a single bond or an organic group having 1 to 50 carbon atoms; "m" represents an integer satisfying 1 ≤ m ≤ 5; "a5" represents 0 or 1; "b5" represents 1 or 2; and "d5" represents 1 to 4, 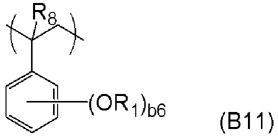 wherein R₁ represents one or two of the groups containing fluorine represented by the formulae (B2); R₈ represents a hydrogen atom or a methyl group; and "b6" represents 1 to 5.

3. The composition for forming an organic film according to claim 1 or 2, wherein the aryl benzyl ether compound (B) has a weight-average molecular weight of 1000 to 30000.

4. The composition for forming an organic film according to any one of claims 1 to 3, wherein the aryl benzyl ether compound (B) is contained in an amount of 0.01 parts by mass to 5 parts by mass based on 100 parts by mass of the material (A) for forming an organic film.

5. A method for forming an organic film to be used in a manufacturing process of a semiconductor device, the method comprising:
spin-coating a substrate to be processed with the composition for forming an organic film according to any one of claims 1 to 4 to obtain a coating film; and
forming an organic film by heating the coating film at a temperature of 100°C or higher and 600°C or lower for 10 to 600 seconds to cure the coating film.

6. A patterning process comprising:
forming an organic film on a body to be processed by using the composition for forming an organic film according to any one of claims 1 to 4;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

7. A patterning process comprising:
forming an organic film on a body to be processed by using the composition for forming an organic film according to any one of claims 1 to 4;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

8. A patterning process comprising:
forming an organic film on a body to be processed by using the composition for forming an organic film according to any one of claims 1 to 4;
forming an inorganic hard mask selected from the group consisting of a silicon oxide film, a silicon nitride film, and a silicon oxynitride film on the organic film;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further forming the pattern in the body to be processed by etching while using the organic film having the transferred pattern as a mask.

9. A patterning process comprising:
forming an organic film on a body to be processed by using the composition for forming an organic film according to any one of claims 1 to 4;
forming an inorganic hard mask selected from the group consisting of a silicon oxide film, a silicon nitride film, and a silicon oxynitride film on the organic film;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and to the inorganic hard mask by etching while using the resist upper layer film having the formed circuit pattern as a mask;
transferring the pattern to the organic film by etching while using the inorganic hard mask having the transferred pattern as a mask; and
further forming the pattern in the body to be processed by etching while using the organic film having the transferred pattern as a mask.

10. The patterning process according to claim 8 or 9, wherein the inorganic hard mask is formed by a CVD method or an ALD method.

11. The patterning process according to any one of claims 6 to 10, wherein the circuit pattern is formed by a lithography using light having a wavelength of 10 nm or more and 300 nm or less, a direct writing with electron beam, nanoimprinting, or a combination thereof.

12. The patterning process according to any one of claims 6 to 11, wherein the circuit pattern is developed with an alkaline development or an organic solvent.

13. The patterning process according to any one of claims 6 to 12, wherein the body to be processed is a semiconductor device substrate or the semiconductor device substrate coated with any of a metal film, a metal carbide film, a metal oxide film, a metal nitride film, a metal oxycarbide film, and a metal oxynitride film.

14. The patterning process according to claim 13, wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
